(19) Europäisches Patentamt
European Patent Office
Office européen des brevets

(11) EP 4 421 080 A1

(12) **EUROPEAN PATENT APPLICATION**
published in accordance with Art. 153(4) EPC

(43) Date of publication:
**28.08.2024 Bulletin 2024/35**

(21) Application number: **22882239.1**

(22) Date of filing: **15.04.2022**

(51) International Patent Classification (IPC):
***C07F 15/00*** *(2006.01)* ***C09K 11/06*** *(2006.01)*
***H10K 50/00*** *(2023.01)* ***H10K 85/00*** *(2023.01)*

(52) Cooperative Patent Classification (CPC):
**C07F 15/0033; C09K 11/06; H10K 85/342;**
C09K 2211/185; H10K 50/11; H10K 2101/10;
H10K 2101/90; Y02E 10/549

(86) International application number:
**PCT/CN2022/087005**

(87) International publication number:
**WO 2023/065614 (27.04.2023 Gazette 2023/17)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **18.10.2021 CN 202111210513**

(71) Applicant: **Guangzhou Chinaray Optoelectronic Materials Ltd.**
**Guangzhou, Guangdong 510663 (CN)**

(72) Inventors:
- **LEUNG, Chi Ming**
**Guangzhou, Guangdong 510663 (CN)**
- **ZHANG, Jing**
**Guangzhou, Guangdong 510663 (CN)**

(74) Representative: **Nederlandsch Octrooibureau**
**P.O. Box 29720**
**2502 LS The Hague (NL)**

# (54) METAL COMPLEX, MIXTURE, COMPOSITION, AND ORGANIC ELECTRONIC COMPONENT

(57) The present disclosure relates to an organometallic complex, a mixture, a composition, an organic electronic device, an electronic device and a use. The structure of the metal complex provided by the present disclosure includes at least one electron-pulling group such as -CN, -F, or $-CF_3$, and the electron-pulling groups can help the electron transmission in the device, so that the electrons can be effectively used, thereby improving the luminous efficiency of the device, reducing the starting voltage and improving the service life of the device.

EP 4 421 080 A1

## Description

### TECHNICAL FIELD

The present disclosure relates to the field of organic electroluminescence, in particular to metal complexs, mixtures, compositions and organic electronic devices.

### BACKGROUND

Organic light-emitting diodes (OLEDs) become the most promising display technology, owing to the advantages of low cost, light weight, low operating voltage, high brightness, color adjustability, wide viewing angle, easy assembly and low energy consumption in flat panel display and lighting applications.

In order to improve the luminescence efficiency of organic light emitting diodes, various luminescent materials based on fluorescence and phosphorescence have been developed. Organic light emitting diodes using fluorescent materials have high reliability, but their internal electroluminescence quantum efficiency is limited to 25% under electric field excitation. In contrast, organic light emitting diodes using phosphorescent materials can achieve almost 100% internal luminescence quantum efficiency because the branching ratio of singlet excited state and triple excited state of excitons is 1: 3. For small molecular organic compounds, metal complexes are formed by doping heavy metal centers, which can improve spin-orbit coupling. It is easy to occur inter-system jumping under the excitation of electric field, thereby effectively obtaining triplet excitation.

Iridium (III)-based complexes are widely used in high-efficiency OLEDs, which have high efficiency and stability. Baldo et al. reported the use of fac-tris (2-phenylpyridine) iridium (III) [Ir $(ppy)_3$ as phosphorescent luminescent materials, and 4, 4'-N, N'-diarbazole-biphenyl (CBP) is a high quantum efficiency OLED (Appl. Phys. Lett. 1999, 75, 4). Another example of a phosphorescent luminescent material is the sky-blue complex iridium (III) bis [2-(4', 6'-difluorophenyl) pyridine-N, C2]-pyrazoate (FIrpic), which, when doped into a high triplet energy matrix, exhibits extremely high photoluminescence quantum efficiency of about 60% in solution and almost 100% in solid films (Appl. Phys. Lett. 2001, 79, 2082). Although iridium (III) system based on 2-phenylpyridine and its derivatives have been widely used to prepare OLEDs, the device performance, especially the lifetime, still needs to be improved.

Therefore, it is hoped to develop these new high-performance metal complexes in order to further improve the service life of devices.

### TECHNICAL PROBLEMS

Therefore, it is necessary to improve the stability of metal-organic complexes and the efficiency and lifetime of organic light-emitting devices. The object of the present disclosure includes providing a metal complex and a mixture, a composition, an organic electronic device, an electronic device and a use thereof. This is a type of metal-organic complex luminescent materials with simple synthesis, novel structure and good properties.

### TECHNICAL SOLUTIONS

In a first aspect of the present disclosure, a metal complex having a structure as represented by formula (I) or formula (II) is provided.

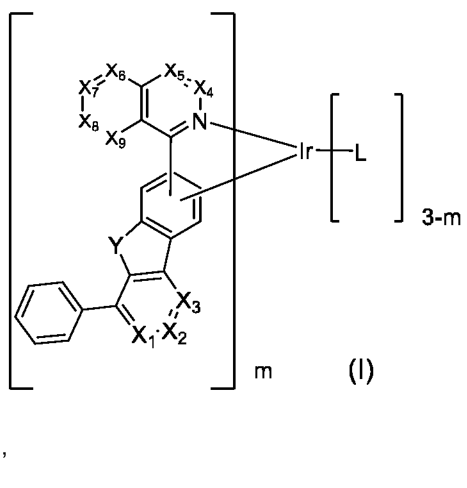
(I)

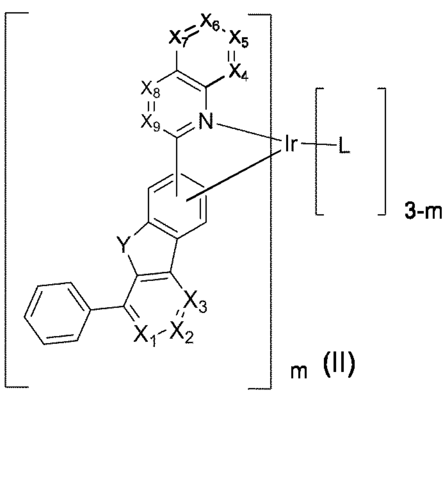
(II)

in which,

L is selected from a monovalent anionic organic ligand;
m is selected from 1 or 2 or 3;
$X_1$, $X_2$, and $X_3$ are selected independently at each occurrence from CRi or N;
$X_4$, $X_5$, $X_6$, $X_7$, $X_8$, and $X_9$ are selected independently at each occurrence from $CR_2$ or N;
Y is selected independently at each occurrence from $CR_3R_4$, $NR_3$, O, S or SOz;
$R_1$, $R_2$, $R_3$, and $R_4$ are selected independently at each occurrence from the group consisting of -H, -D, a linear alkyl group having 1 to 20 carbon atoms, a linear alkoxy group having 1 to 20 carbon atoms, a linear thioalkoxy group having 1 to 20 carbon atoms, a branched alkyl group having 3 to 20 carbon atoms, a cyclic alkyl group having 3 to 20 carbon atoms, a branched alkoxy group having 3 to 20 carbon atoms, a cyclic alkoxy group having 3 to 20 carbon atoms, a branched thioalkoxy group having 3 to 20 carbon atoms, a cyclic thioalkoxy group having 3 to 20 carbon atoms, silicyl, a ketone group having 1 to 20 carbon atoms, an alkoxycarbonyl group having 2 to 20 carbon atoms, an aryloxycarbonyl group having 7 to 20 carbon atoms, -CN, carbamoyl, haloformyl, formyl, an isocyano group, an isocyanate group, an thiocyanate group, an isothiocyanate group, hydroxyl, nitro, $-CF_3$, -Cl, -Br, -F, a substituted or unsubstituted aromatic group having 6 to 60 ring atoms, a substituted or unsubstituted heteroaromatic group having 5 to 60 ring atoms, a substituted or unsubstituted aryloxy group having 6 to 60 ring atoms, a substituted or unsubstituted heteroaryloxy group having 5 to 60 ring atoms, and any combination of the groups; and adjacent two $R_1$ form or do not form a ring, or adjacent two $R_2$ form or do not form a ring; and
at least one $R_2$ is selected from -CN, -F, or $-CF_3$.

In a second aspect of the present disclosure, a mixture is provided, including the metal complex of the first aspect of the present disclosure. The mixture further includes an organic functional material. In some embodiments, the organic functional material is selected from at least one of a hole injection material, a hole transport material, an electron transport material, an electron injection material, an electron blocking material, a hole blocking material, a luminescent material, a host material, and an organic dye.

In a third aspect of the present disclosure, a composition is provided, including the metal complex of the first aspect of the present disclosure, or the mixture of the second aspect of the present disclosure. The composition further includes at least one organic solvent.

In a fourth aspect of the present disclosure, an organic electronic device is provided, including the metal complex of the first aspect of the present disclosure, or the mixture of the second aspect of the present disclosure, or the organic electronic device is prepared by the composition of the third aspect of the present disclosure.

The technical solutions of the present disclosure have at least the following beneficial effects.

The structure of the metal complex provided by the present disclosure includes at least one electron-pulling group such as -CN, -F or $-CF_3$, and the electron-pulling group can help the electron transmission in the device, so that the electrons gather in the light emitting layer, thereby improving the luminous efficiency of the device, reducing the starting voltage and improving the service life of the device.

When the metal complex provided by the present disclosure is used in OLED, especially as the doping material of the light emitting layer, it can provide higher luminous efficiency and device life.

BENEFICIAL EFFECTS

The lowest unoccupied molecular orbital (LUMO) energy level of the metal complex can be greatly stabilized by substitution of electron-pulling groups such as CN, -F or $-CF_3$, so that the luminescence is red-shifted and the color energy of red light emitted is more saturated. The conjugated system of the metal complex can be increased by phenyl group defined in the heteroatom-containing system, which makes the luminescence red-shifted. The electron-pulling group and the phenyl group defined in the heteroatom-containing system are used in coordination, so that the luminescence of the metal complex can be greatly red-shifted, thereby realizing high-efficiency crimson light color.

DETAILED DESCRIPTION OF THE EMBODIMENTS

The present disclosure is described in further detail below with reference to specific embodiments. It should be understood that these implementations and embodiments are intended to be illustrative only and not to limit the scope of the present disclosure and are provided for a more thorough and comprehensive understanding of the present disclosure. It should also be understood that the present disclosure may be embodied in many different forms and is not limited to the implementations and embodiments described herein. Various changes and modifications may be made by those skilled in the art without departing from the connotation of the present disclosure, resulting in equivalent forms that also fall within the scope of protection of the present disclosure. Further in the following description, numerous specific details are described in order to provide a fuller understanding of the present disclosure. It should be understood that the present disclosure may be practiced without one or more of these details.

Unless otherwise defined, all technical and scientific terms used herein have the same meaning as would normally be understood by those skilled in the art of the present disclosure. Terms used herein in the specification of the present disclosure are for the purpose of describing specific implementations and embodiments only and are not intended to limit the present disclosure.

The scope of the terms "and/or", "or/and", and "and/or" as used herein include any one of two or more related listed items, as well as any and all combinations of the related listed items. Any and all combinations of the related listed items include any two related listed items, any more related listed items, or a combination of all related listed items. It should be noted that when connecting at least three items by at least two combinations of conjunctions selected from the group consisting of "and/or", "or/and", and "and/or", it should be understood that, in the present application, the technical solution unquestionably includes technical solutions all connected by "logical conjunction" and also unquestionably includes technical solutions all connected by "logical disjunction". For example, "A and/or B" includes three parallel solutions: solution A, solution B, and solution A and B. For another example, the technical solution of "A, and/or, B, and/or, C, and/or, D" includes any one of A, B, C and D (that is, the technical solution connected by "logical disjunction"), and further includes any and all combinations of A, B, C and D, that is, including any two or three combinations of A, B, C and D, and further includes four combinations of A, B, C and D (that is, technical scheme connected by "logical conjunction").

In the present disclosure, the composition and the printing ink, or ink, have the same meaning and may be interchangeable.

In the present disclosure, the terms "aryl group", "aryl", "aromatic group", "aromatic series", and "aromatic ring system" have the same meaning and may be interchangeable.

In the present disclosure, the terms "heteroaryl group", "heteroaromatic group", "heteroaromatic series" and "heteroaromatic ring system" have the same meaning and mae be interchangeable.

In the present disclosure, the term "heteroatom" refers to non-carbon atom and may be N atom, O atom, S atom, or the like.

In the present disclosure, "substituted" means that the hydrogen atom in a group is substituted by a substituted group.

In the present disclosure, "substituted or unsubstituted" means that the defined group may or may not be substituted. When the defined group is substituted, it should be understood that the defined group may be substituted by one or more substituents R. R is selected from, but not limited to: deuterium atom, cyano, isocyano, nitro or halogen, an alkyl group containing 1 to 20 carbon atoms, a heterocyclic group containing 3 to 20 ring atoms, an aromatic group containing 6 to 20 ring atoms, a heteroaromatic group containing 5 to 20 ring atoms, -NR'R", a silyl group, a carbonyl group, an alkoxycarbonyl group, an aryloxycarbonyl group, carbamoyl, haloformyl, formyl, an isocyanate group, an thiocyanate group, an isothiocyanate group, hydroxyl, trifluoromethyl, and the above groups may be further substituted by acceptable substituents in the art. R' and R" in -NR'R" are independently selected from, but not limited to: H, deuterium atom, cyano, isocyano, nitro, halogen, an alkyl group containing 1 to 10 carbon atoms, a heterocyclic group containing 3 to 20 ring atoms, an aromatic group containing 6 to 20 ring atoms, a heteroaromatic group containing 5-20 ring atoms. Preferably, R is selected from, but not limited to, deuterium, cyano, isocyano, nitro, halogen, an alkyl group containing 1 to 10 carbon atoms, a heterocyclic group containing 3 to 10 ring atoms, an aromatic group containing 6 to 20 ring atoms, a heteroaromatic group containing 5 to 20 ring atoms, a silyl group, a carbonyl group, an alkoxycarbonyl group, an aryloxycarbonyl group, carbamoyl, haloformyl, formyl, an isocyanate group, a thiocyanate group, an isothiocyanate group, hydroxyl, trifluoromethyl, and the above groups may be further substituted by acceptable substituents in the art.

In the present disclosure, unless specifically defined, hydroxyl refers to -OH, carboxyl refers to -COOH, the carbonyl group refers to -C(=O)-, and the amino group refers to $-NH_2$, formyl refers to -C(=O)H, haloformyl refers to -C(=O)Z (where Z represents halogen), carbamoyl refers to $-C(=O)NH_2$, the isocyanate group refers to - NCO, the isothiocyanate group refers to -NCS.

In the present disclosure, the number of atoms described by a numerical range includes two integer endpoints of the numerical range and each integer in the two endpoints. For example, "$C_{1-10}$ alkyl "means an alkyl group having 1, 2, 3, 4, 5, 6, 7, 8, 9 or 10 carbon atoms. "Containing 3 to 10 ring atoms" means containing 3, 4, 5, 6, 7, 8, 9 or 10 ring atoms.

In the present disclosure, "number of ring atoms" means the number of atoms in the atoms constituting the ring itself of a structural compound (for example, a monocyclic compound, a fused ring compound, a crosslinked compound, a carbocyclic compound, or a heterocyclic compound) obtained by synthesizing a ring shape by atomic bonds. When the ring is substituted by one or more substituents, the atoms contained in the substituents are not included in the ring-forming atoms. The same is true with regard to the "number of ring atoms" described below without special explanation. For example, the number of ring atoms of benzene ring is 6, the number of ring atoms of naphthalene ring is 10, and the number of ring atoms of thienyl group is 5. For antoher example, the number of ring atoms of methylbenzene is 6.

"Aryl group or aromatic group" means an aromatic hydrocarbon group derived from the removal of one hydrogen atom on the basis of an aromatic cyclic compound, which may be a monocyclic aryl group, or a fused aryl group, or a polycyclic aryl group. For polycyclic ring species, at least one is an aromatic ring system. For example, "a substituted

or unsubstituted aryl aroup having 6 to 40 ring atoms" means an aryl group containing 6 to 40 ring atoms, preferably a substituted or unsubstituted aryl group having 6 to 30 ring atoms, more preferably a substituted or unsubstituted aryl group hacing 6 to 18 ring atoms, particularly preferably a substituted or unsubstituted aryl group having 6 to 14 ring atoms, and the hydrogen on aryl group is optionally further substituted. Suitable examples include, but not limited to, phenyl, biphenyl, triphenyl, naphthyl, anthryl, phenanthenyl, fluoranthenyl, triphenyl, pyrenyl, perylene, tetraphenyl, fluorenyl, dinaphthenyl, acenaphthenyl and their derivatives. It is understood that one or more aromatic groups may also be disrupted by short non-aromatic units (e.g. less than 10% non-H atoms such as C, N, or O atoms), in particular acenaphthene, fluorene, 9, 9-diarylfluorene, triarylamine, and diaryl ether systems should also be included in the definition of the aryl group.

"Heteroaryl group or heteroaromatic group" means that at least one carbon atom is replaced by a non-carbon atom on the basis of an aryl group, and the non-carbon atom may be an N atom, an O atom, an S atom, or the like. For example, "a substituted or unsubstituted heteroaryl group having 5 to 40 ring atoms" means a heteroaryl group having 5 to 40 ring atoms, preferably substituted or unsubstituted heteroaryl having 6 to 30 ring atoms, more preferably substituted or unsubstituted heteroaryl having 6 to 18 ring atoms, particularly preferably a substituted or unsubstituted heteroaryl group having 6 to 14 ring atoms, and the hydrogen on aryl group is optionally further substituted. Suitable examples, include but not limited to, thienyl, furyl, pyrrolyl, imidazolyl, diazolyl, triazolyl, imidazolyl, pyridyl, bipyridyl, pyrimidyl, triazinyl, acridyl, pyridazinyl, pyrazinyl, quinolinyl, isoquinolinyl, quinazolinyl, quinoxalinyl, phthalazinyl, pyridinopyridinyl, pyridinopyrazinyl, benzothiophenyl, benzofuranyl, indyl, pyrroloimidazolyl, pyrrolopyrrolyl, thiophenopyrrolyl, thiophenothienyl, furopyrrolyl, furofuranyl, thienofuranyl, benzoisoxazolyl, benzoisothiazolyl, benzimidazolyl, o-diazanaphthyl, phenanthridinyl, primidinyl, quinazolinone, dibenzothienyl, dibenzofuranyl, carbazolyl and their derivatives.

In the present disclosure, "alkyl group" may mean straight chain, branched chain and/or cyclic alkyl group. The alkyl group may have a carbon number of 1 to 50, 1 to 30, 1 to 20, 1 to 10, or 1 to 6. Non-limiting examples of the alkyl group include methyl, ethyl, n-propyl, isopropyl, n-butyl, sec-butyl, tert-butyl, isobutyl, 2-ethylbutyl, 3, 3-dimethylbutyl, n-amyl, isoamyl, neopentyl, tert-amyl, cyclopentyl, 1-methylpentyl, 3-methylpentyl, 2-ethylpentyl, 4-methyl-2-pentyl, n-hexyl, 1-methylhexyl, 2-ethylhexyl, 2-butylhexyl, cyclohexyl, adamantyl, or the like.

In the present disclosure, the abbreviations of substituents correspond to: n-normal, sec-second, i-iso, t-tertiary, o-ortho, m-meta, p-para, Me-methyl, Et-ethyl, Pr-propyl, Bu-butyl, Am-amyl, Hx-hexyl, Cy-cyclohexyl.

The term "Halogen" or "halide based" means F, Cl, Br or I.

The term "alkoxy group" refers to a group having the structure of"-O-alkyl", it means an alkyl group as defined above bonded to other groups by an oxygen atom. Suitable examples of phrases containing the term include, but not limited to, methoxy ($-O-CH_3$ or -OMe), ethoxy ($-O-CH)_2CH_3$ or -OEt) and tert-butoxy ($-O-C$ $(CH)_3)_3$ or - OtBu).

In the present disclosure, "*" represents a connecting site.

In the present disclosure, when the same group contains a plurality of substituents of the same symbol, each substituent may be the same or different from each other, for example, in the following formula:

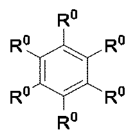,

six $R^0$ groups on the benzene ring can be the same or different from each other.

In the present disclosure, a single bond to which the substituent is connected penetrates the corresponding ring, indicating that the substituent can be connected to any optional position of the ring. For example, R of

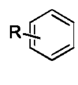

is connected to any substitutable site of benzene ring, such as

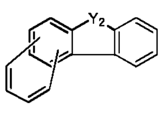 and 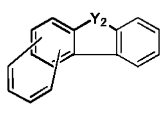

denote

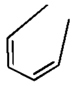

form a merging ring at an optional position on the benzene ring of

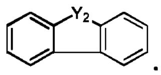

The term "cyclic alkyl group or cycloalkyl group" according to the present disclosure has the same meaning and may be interchangeable.

In the present disclosure, "adjacent group" means that there is no substitutable site between two substituents.

"Combination thereof", "any combination thereof", "any way of combination thereof" and the like used in the present disclosure include all suitable combinations of any two or more of the listed items.

In the present disclosure, "further", "more further", "particular" and the like are used for descriptive purposes to indicate differences in content, but should not be construed as limiting the scope of protection of the present disclosure.

In the present disclosure, "optionally", "optional" and "option" refer to not essential, that is, it refers to any one selected from two parallel solutions of "having" or "not having". If "option" occurs in a technical solution many times, if there is no special explanation, and there is no contradiction or mutual restriction, each "option" is independent.

In the disclosure, the technical features described in an open manner include a closed technical solution composed of the enumerated features and an open technical solution containing the enumerated features.

The present disclosure relates to a metal complex, which has a structure as represented by formula (I) or formula (II):

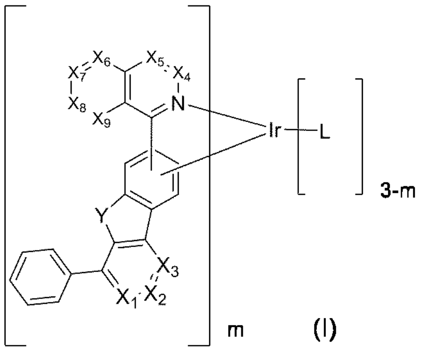

(I)

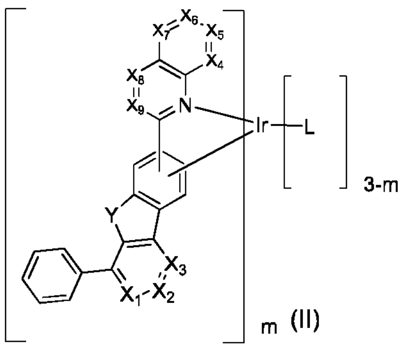

(II)

In which L is selected from a monovalent anionic organic ligand, and m is selected from 1 or 2 or 3.

$X_1$, $X_2$, and $X_3$ are selected independently at each occurrence from CRi or N.

$X_4$, $X_5$, $X_6$, $X_7$, $X_8$, and $X_9$ are selected independently at each occurrence from $CR_2$ or N.

Y is selected independently at each occurrence from $CR_3R_4$, $NR_3$, O, S or $SO_2$.

$R_1$, $R_2$, $R_3$, and $R_4$ are selected independently at each occurrence from the group consisting of -H, -D, a linear alkyl group having 1 to 20 carbon atoms, a linear alkoxy group having 1 to 20 carbon atoms, a linear thioalkoxy group having 1 to 20 carbon atoms, a branched alkyl group having 3 to 20 carbon atoms, a cyclic alkyl group having 3 to 20 carbon atoms, a branched alkoxy group having 3 to 20 carbon atoms, a cyclic alkoxy group having 3 to 20 carbon atoms, a branched thioalkoxy group having 3 to 20 carbon atoms, a cyclic thioalkoxy group having 3 to 20 carbon atoms, silicyl, a ketone group having 1 to 20 carbon atoms, an alkoxycarbonyl group having 2 to 20 carbon atoms, an aryloxycarbonyl group having 7 to 20 carbon atoms, -CN, carbamoyl, haloformyl, formyl, an isocyano group, an isocyanate group, an thiocyanate group, an isothiocyanate group, hydroxyl, nitro, $-CF_3$, -Cl, -Br, -F, a substituted or unsubstituted aromatic group having 6 to 60 ring atoms, a substituted or unsubstituted heteroaromatic group having 5 to 60 ring atoms, a substituted or unsubstituted aryloxy group having 6 to 60 ring atoms, a substituted or unsubstituted heteroaryloxy group having 5 to 60 ring atoms, and any combination of the groups; and adjacent two $R_1$ form or do not form a ring, or adjacent two $R_2$ form or do not form a ring.

At least one $R_2$ is selected from -CN, -F, or $-CF_3$.

In some embodiments, the metal complex is selected from the group consisting of the compounds represented by any of formulae (1-1) to (1-6):

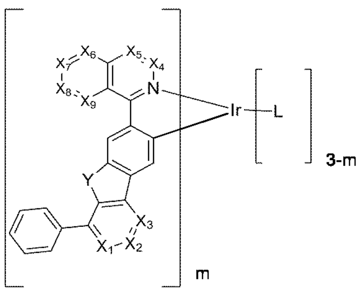
(1-1)

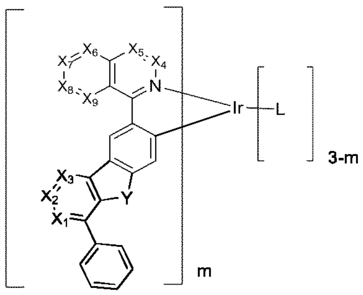
(1-2)

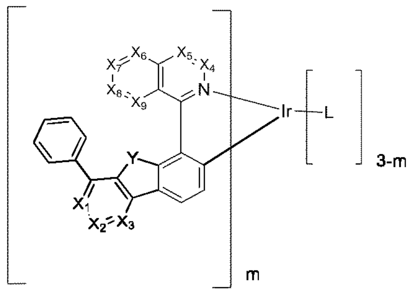
(1-3)

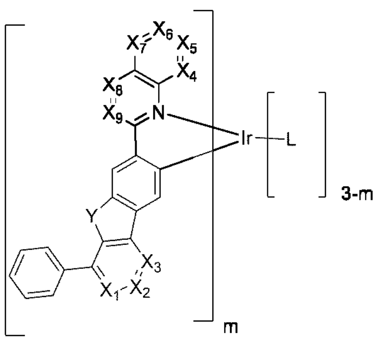
(1-4)

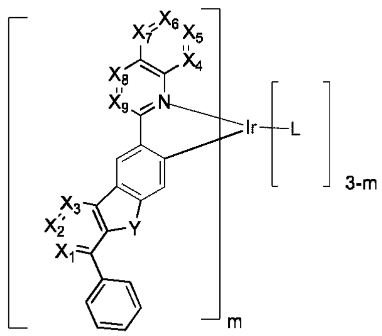
(1-5)

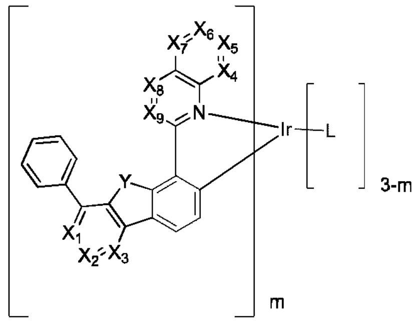
(1-6)

In some embodiments, $R_1$ is selected from the group consisting of -H, -D, -CN, nitro, $-CF_3$, -Cl, -Br, -F, -I, a linear alkyl group having 1 to 10 carbon atoms, a branched or cyclic alkyl group having 3 to 10 carbon atoms, a R*-substituted or unsubstituted aromatic group having 6 to 10 ring atoms, and a R*-substituted or unsubstituted heteroaromatic group having 5 to 13 ring atoms, in which R* is selected from -D, -CN, nitro, and $-CF_3$.

In an embodiment, adjacent two $R_1$ groups form a 6-membered ring together, examples as shown in structures (A-37) below.

In some preferred embodiments, $R_1$ is selected from any one of the following groups: -H, $-CH_3$, tert-butyl, phenyl, pyridyl, and pyrazine.

In some embodiments, $R_2$ is selected from the group consisting of -H, -D, -CN, nitro, $-CF_3$, -Cl, -Br, -F, -I, a linear alkyl group having 1 to 10 carbon atoms, a branched or cyclic alkyl group having 3 to 10 carbon atoms, a R*-substituted or unsubstituted aromatic group having 6 to 10 ring atoms, and a R*-substituted or unsubstituted heteroaromatic group having 5 to 13 ring atoms, in which R* is selected from -D, -CN, nitro, and $-CF_3$.

In some preferred embodiments, $R_2$ is selected from any one of the following groups: -H, -D, $-CH_3$, isopropyl, -F, $-CF_3$, and -CN.

In some embodiments, $X_7$ is selected from $CR_2$, and $R_2$ is selected from-CN, -F, or $-CF_3$.

In some embodiments, $R_3$ and $R_4$ are selected from the group consisting of -H, -D, a linear alkyl group having 1 to 10 carbon atoms, a branched or cyclic alkyl group having 3 to 10 carbon atoms, a R*-substituted or unsubstituted aromatic group having 6 to 10 ring atoms, and a R*-substituted or unsubstituted heteroaromatic group having 5 to 13 ring atoms, in which R* is selected from -D, -CN, nitro, $-CF_3$, -Cl, -Br, -F, -I, a linear alkyl group having 1 to 10 carbon atoms, a branched or cyclic alkyl group having 3 to 10 carbon atoms, phenyl, biphenyl, or naphthyl.

In some preferred embodiments, $R_3$ and $R_4$ are independently of each other selected from any one of the following groups: -H, $-CH_3$, isopropyl, tert-butyl and phenyl.

In some embodiments, the

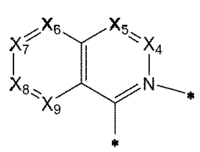

in formula (I) is selected from any one of the following groups:

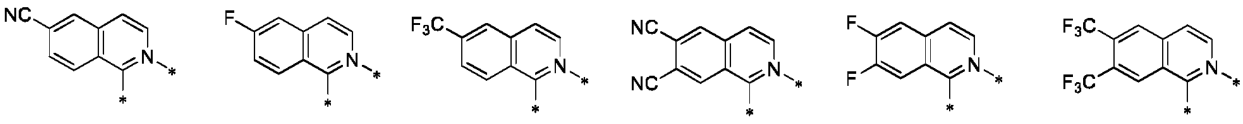

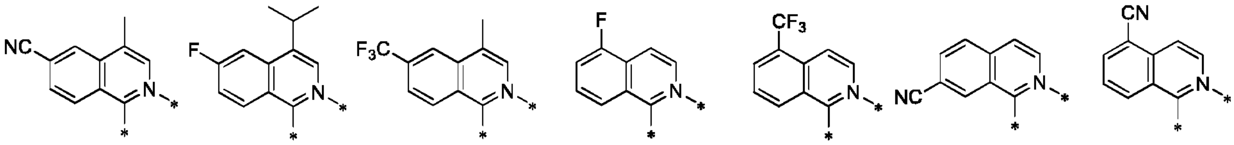

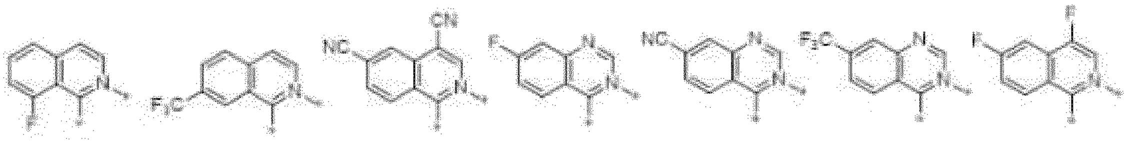

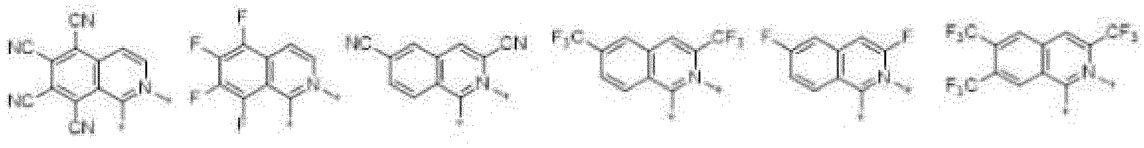

.

In which "*" represents a connecting site.

In some embodiments, the

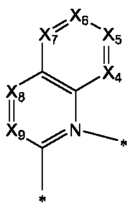

is selected from any one of the following groups:

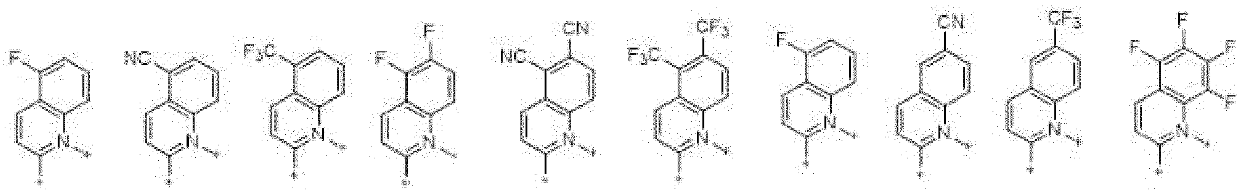

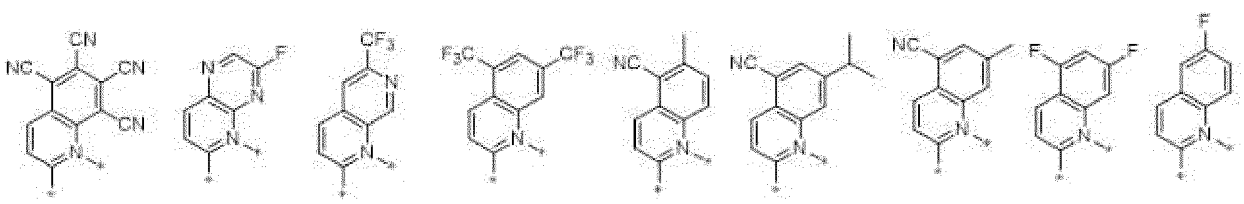

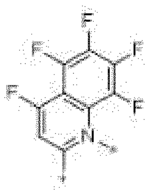 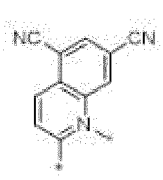 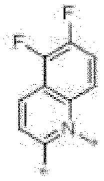 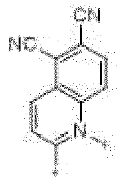 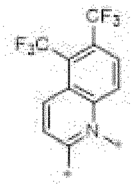 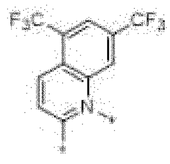

.

In some embodiments, the

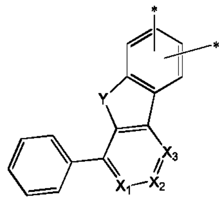

in formulae (I) and (II) is independently of each other selected from any one of the following groups:

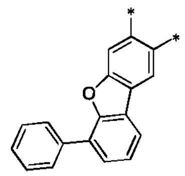 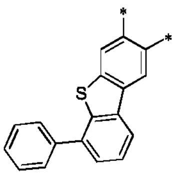 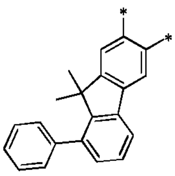 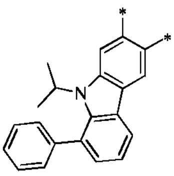 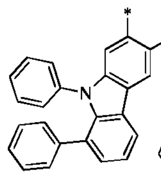 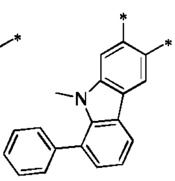 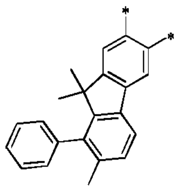

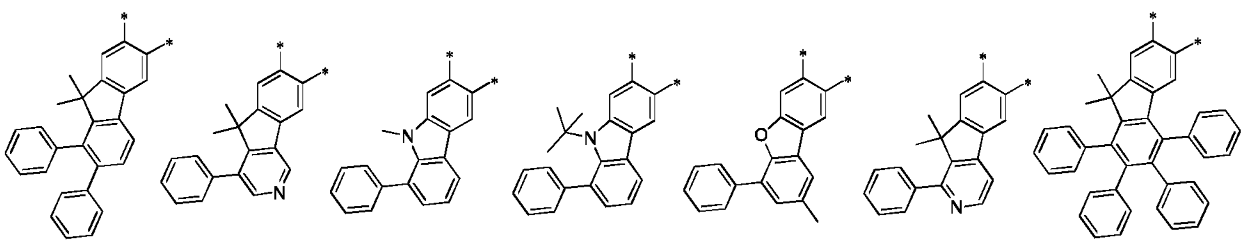

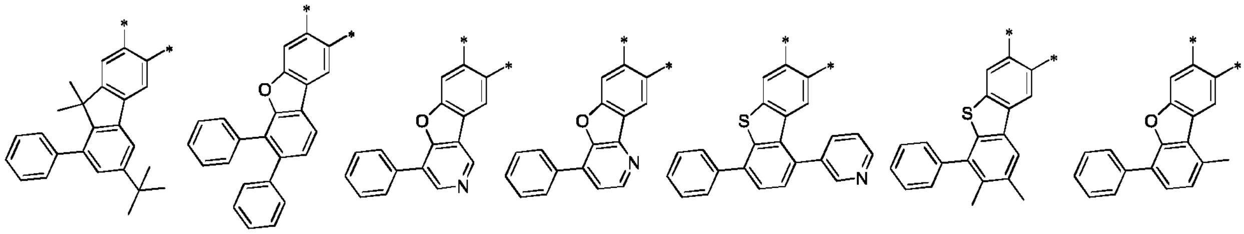

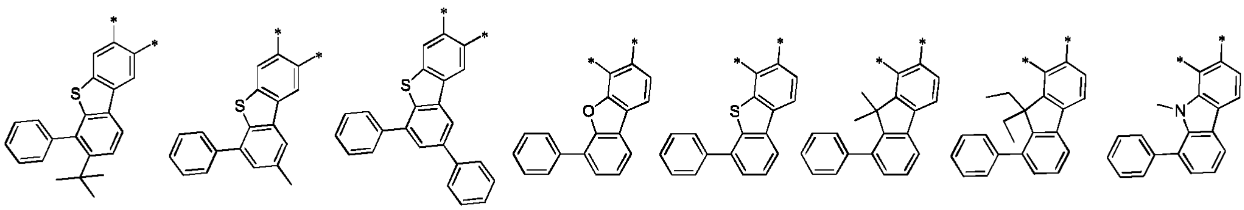

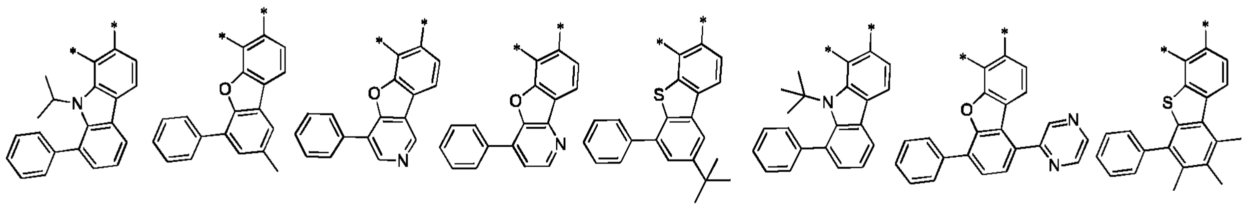

.

In some embodiments, the

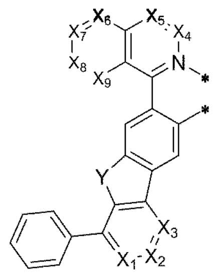

in formula (I) is selected from the group consisting of formulae (A-1) to (A-48):

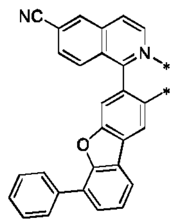
(A-1)

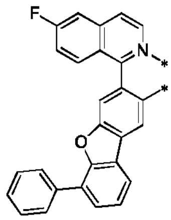
(A-2)

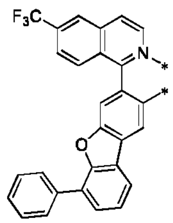
(A-3)

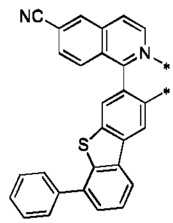
(A-4)

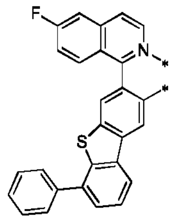
(A-5)

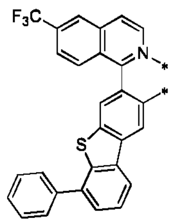
(A-6)

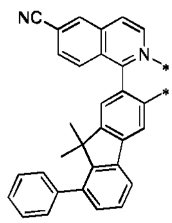
(A-7)

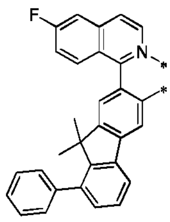
(A-8)

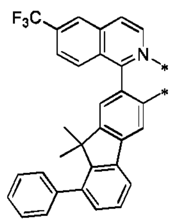
(A-9)

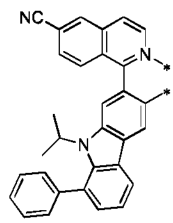
(A-10)

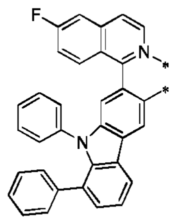
(A-11)

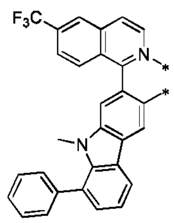
(A-12)

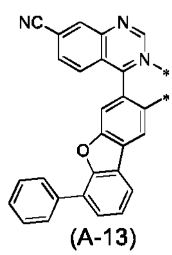
(A-13)

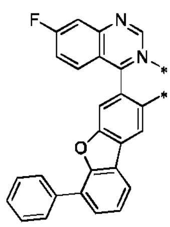
(A-14)

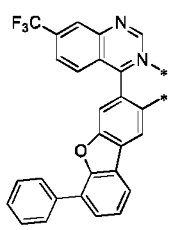
(A-15)

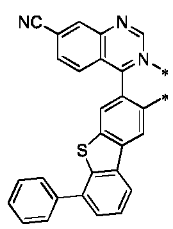
(A-16)

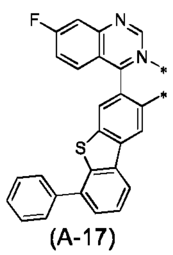
(A-17)

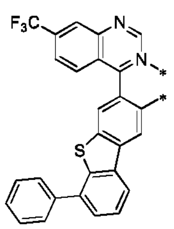
(A-18)

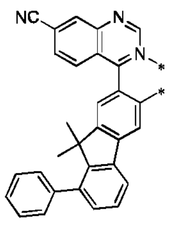
(A-19)
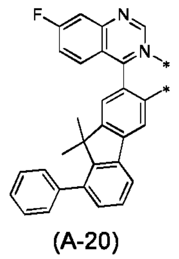
(A-20)
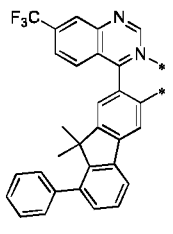
(A-21)
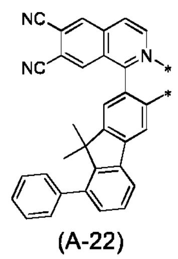
(A-22)
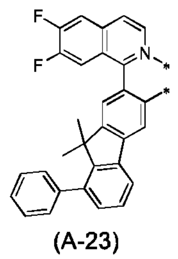
(A-23)
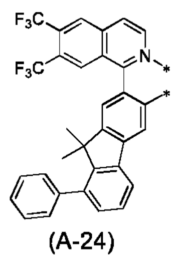
(A-24)
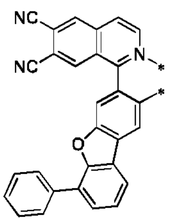
(A-25)
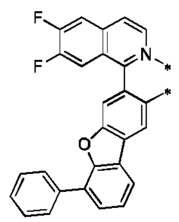
(A-26)
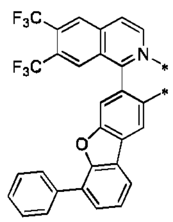
(A-27)
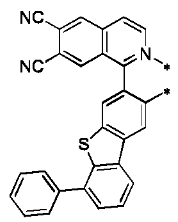
(A-28)
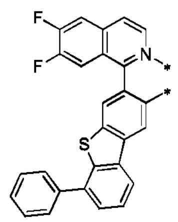
(A-29)
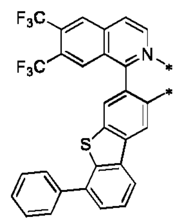
(A-30)
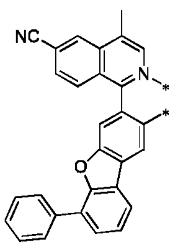
(A-31)
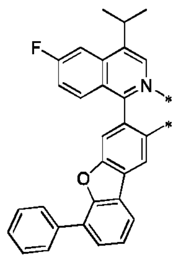
(A-32)
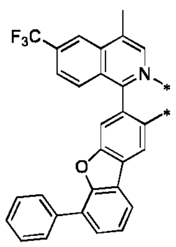
(A-33)
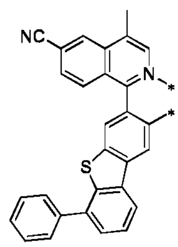
(A-34)
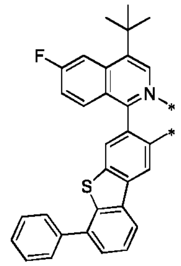
(A-35)
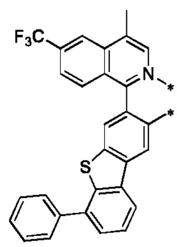
(A-36)
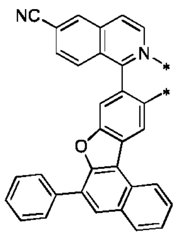
(A-37)
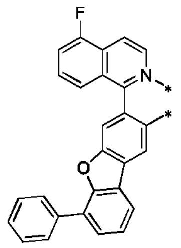
(A-38)
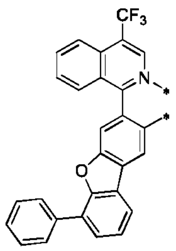
(A-39)
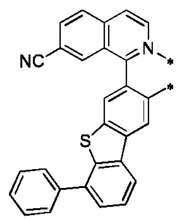
(A-40)
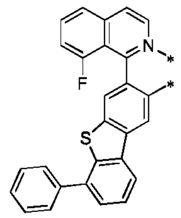
(A-41)
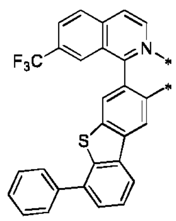
(A-42)
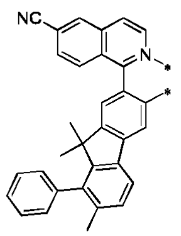
(A-43)
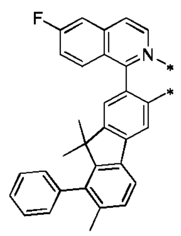
(A-44)
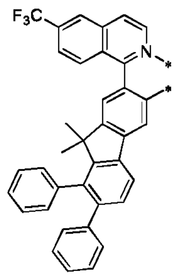
(A-45)
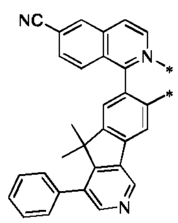
(A-46)
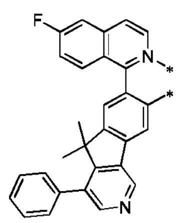
(A-47)
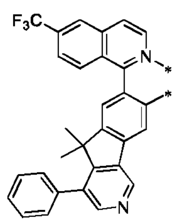
(A-48)

.

In which "*" represents the connecting site connected to Ir. Formulae (A-1) to (A-48) may be further substituted by R*.

In some embodiments, the

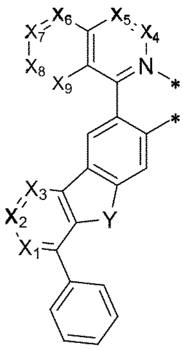

in formula (I) is selected from the group consisting of (B-1) to (B-24):

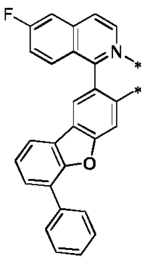
(B-1)

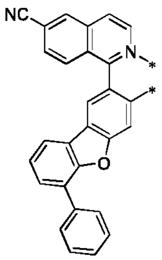
(B-2)

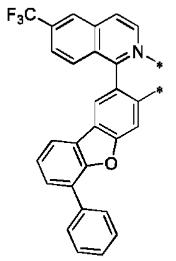
(B-3)

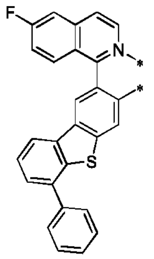
(B-4)

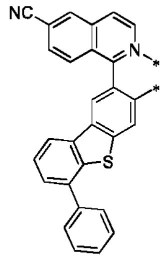
(B-5)

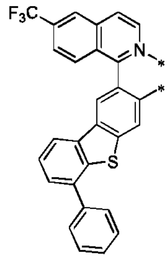
(B-6)

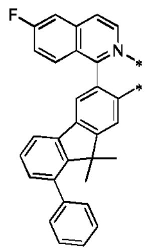
(B-7)

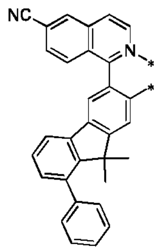
(B-8)

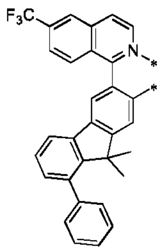
(B-9)

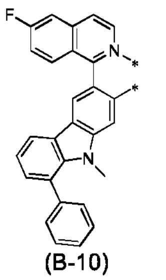
(B-10)

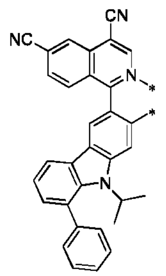
(B-11)

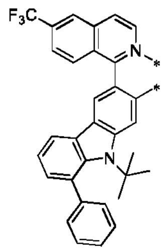
(B-12)

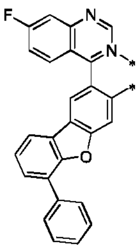
(B-13)

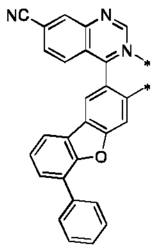
(B-14)

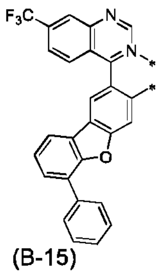
(B-15)

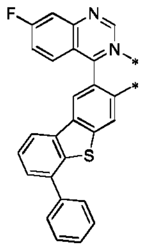
(B-16)

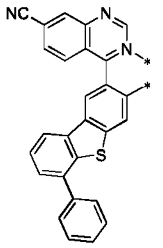
(B-17)

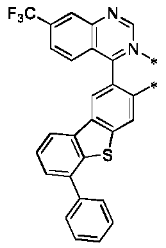
(B-18)

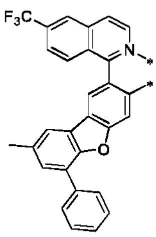
(B-19)

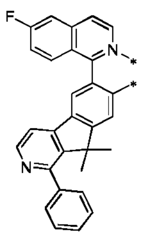
(B-20)

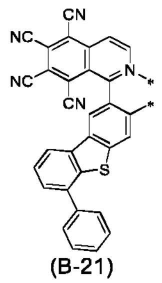
(B-21)

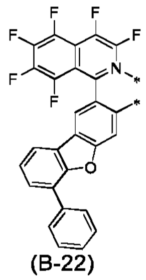
(B-22)

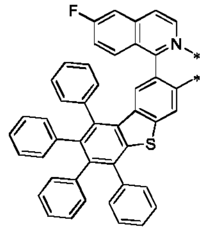
(B-23)

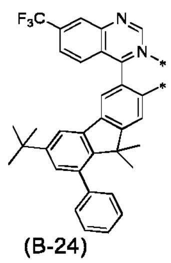
(B-24)

.

In which "*" represents the connecting site connected to Ir. Formulae (B-1) to (B-24) may be further substituted by R*.

In some embodiments, the

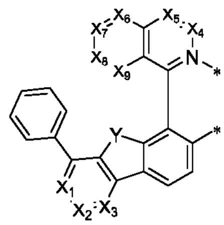

in formula (I) is selected from the group consisting of formulae (C-1) to (C-36):

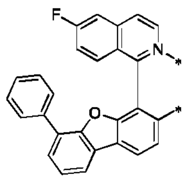
(C-1)

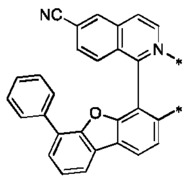
(C-2)

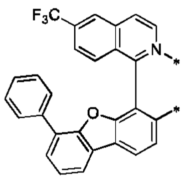
(C-3)

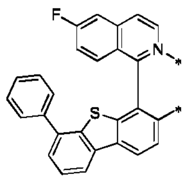
(C-4)

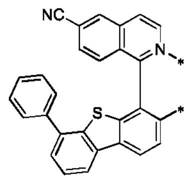
(C-5)

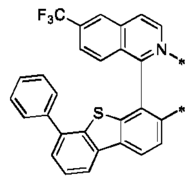
(C-6)

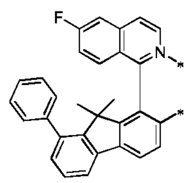
(C-7)

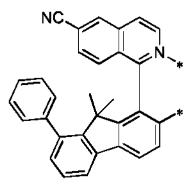
(C-8)

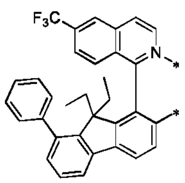
(C-9)

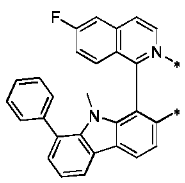
(C-10)

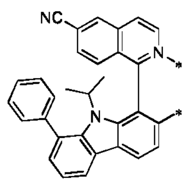
(C-11)

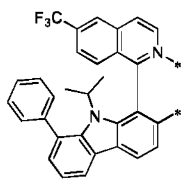
(C-12)

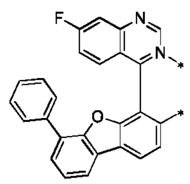
(C-13)

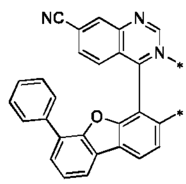
(C-14)

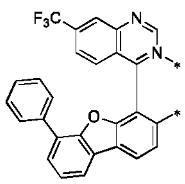
(C-15)

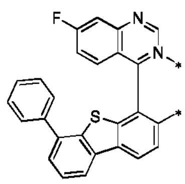
(C-16)

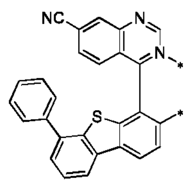
(C-17)

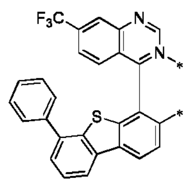
(C-18)

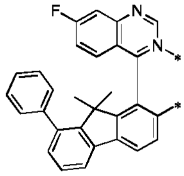
(C-19)

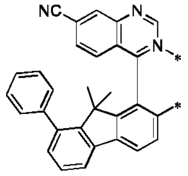
(C-20)

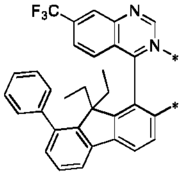
(C-21)

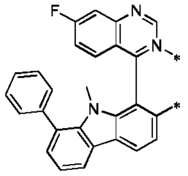
(C-22)

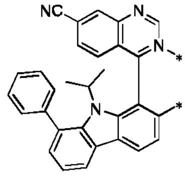
(C-23)

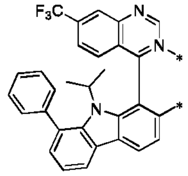
(C-24)

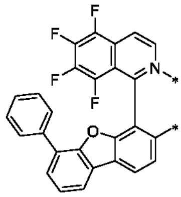
(C-25)

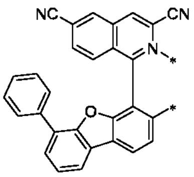
(C-26)

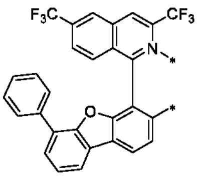
(C-27)

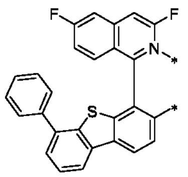
(C-28)

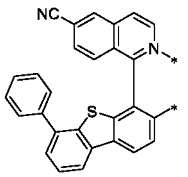
(C-29)

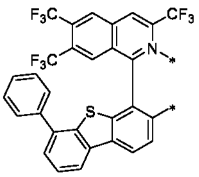
(C-30)

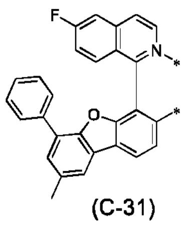
(C-31)

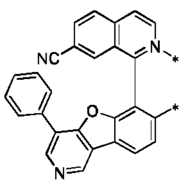
(C-32)

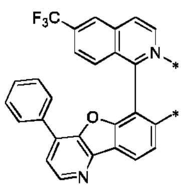
(C-33)

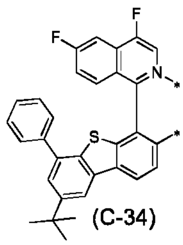
(C-34)

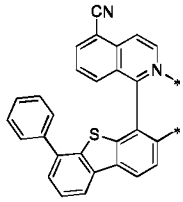
(C-35)

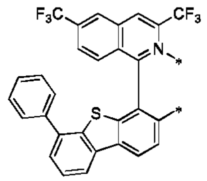
(C-36)

.

In which "*" represents the connecting site connected to Ir. Formulae (C-1) to (C-36) may be further substituted by R*.

In some embodiments, the

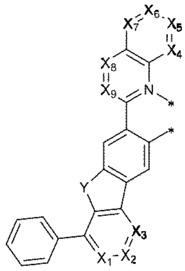

in formula (II) is selected from the group consisting of formulae (D-1) to (D-35):

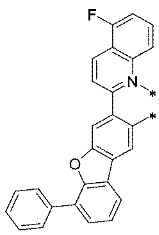
(D-1)

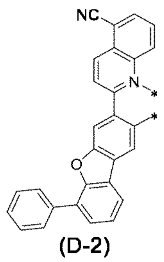
(D-2)

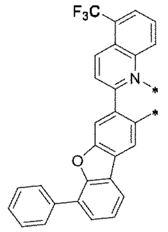
(D-3)

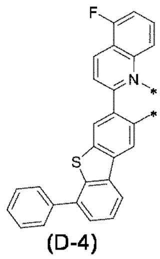
(D-4)

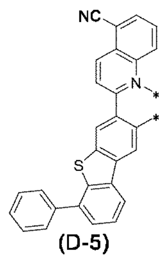
(D-5)

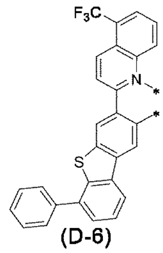
(D-6)

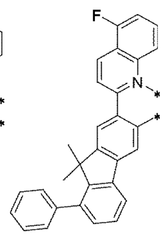
(D-7)

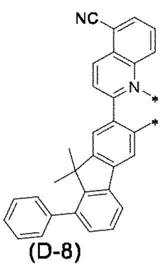 (D-8) 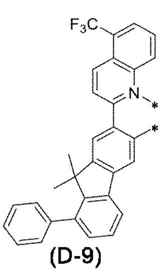 (D-9) 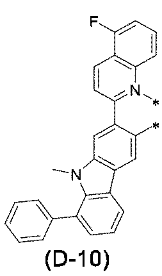 (D-10) 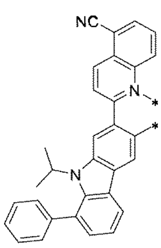 (D-11) 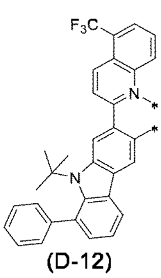 (D-12) 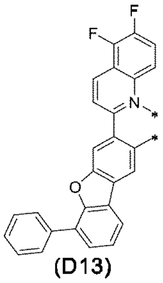 (D13) 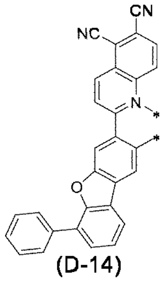 (D-14)

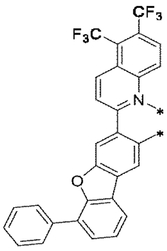 (D-15) 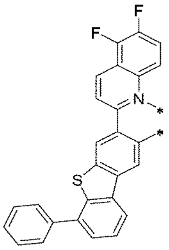 (D-16) 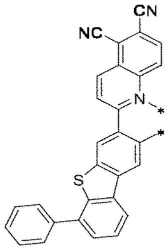 (D-17) 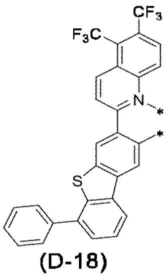 (D-18) 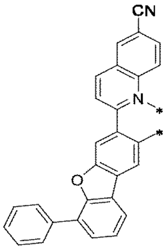 (D-19) 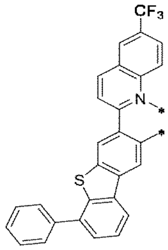 (D-20) 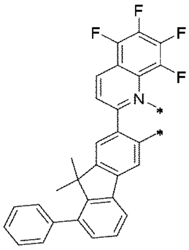 (D-21)

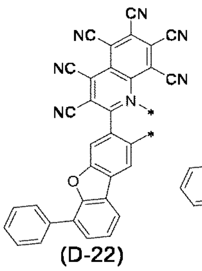 (D-22) 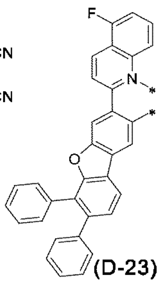 (D-23) 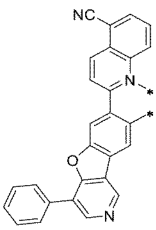 (D-24) 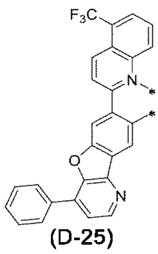 (D-25) 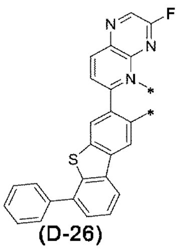 (D-26) 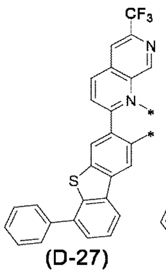 (D-27) 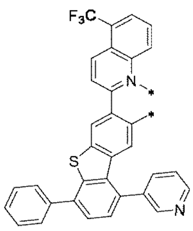 (D-28)

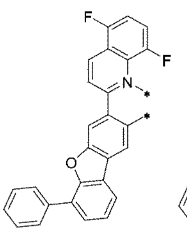 (D-29) 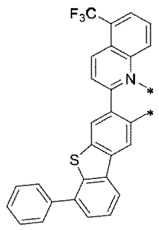 (D-30) 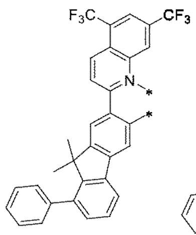 (D-31) 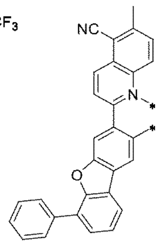 (D-32) 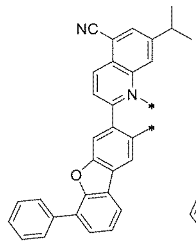 (D-33) 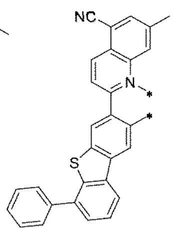 (D-34 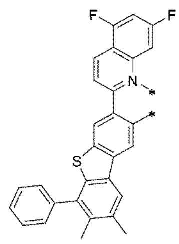 (D-35)

.

In which "*" represents the connecting site connected to Ir. Formulae (D-1) to (D-35) may be further substituted by R*.

In some embodiments, the

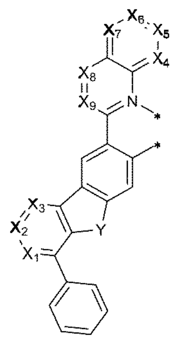

in formula (II) is selected from the group consisting of formulae (E-1) to (E-31):

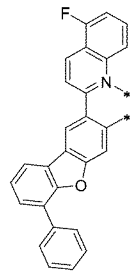
(E-1)
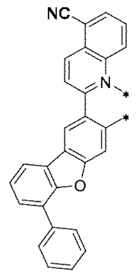
(E-2)
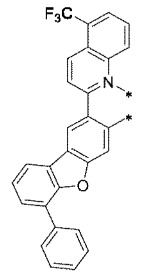
(E-3)
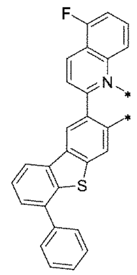
(E-4)
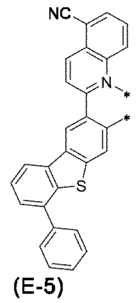
(E-5)
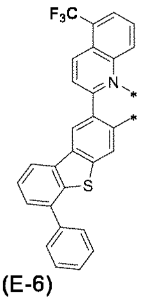
(E-6)
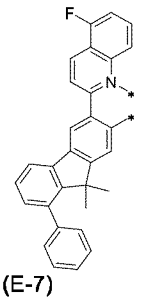
(E-7)
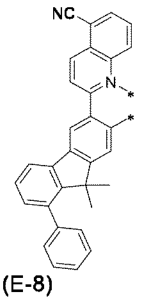
(E-8)

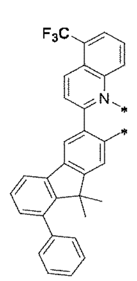
(E-9)
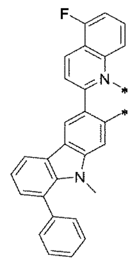
(E-10)
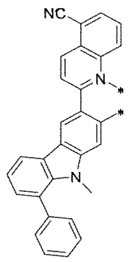
(E-11)
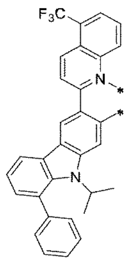
(E-12)
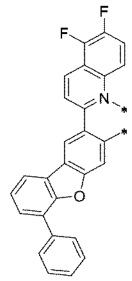
(E-13)
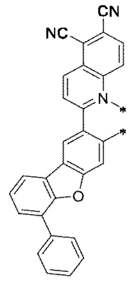
(E-14)
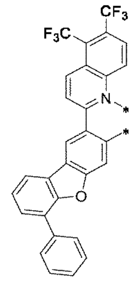
(E-15)
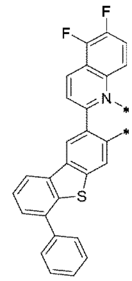
(E-16)

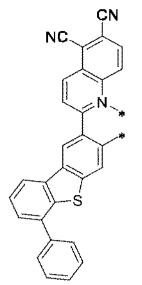
(E-17)
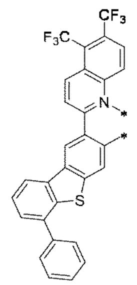
(E-18)
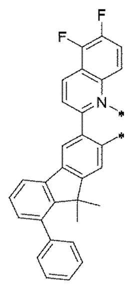
(E-19)
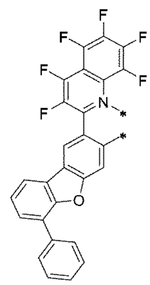
(E-20)
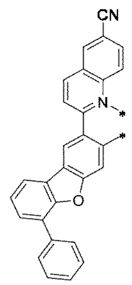
(E-21)
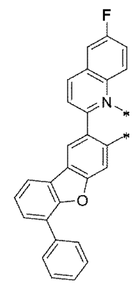
(E-22)
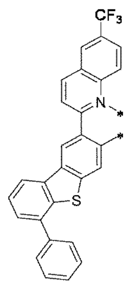
(E-23)
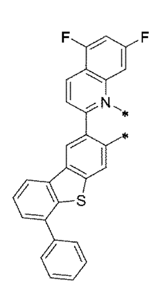
(E-24)

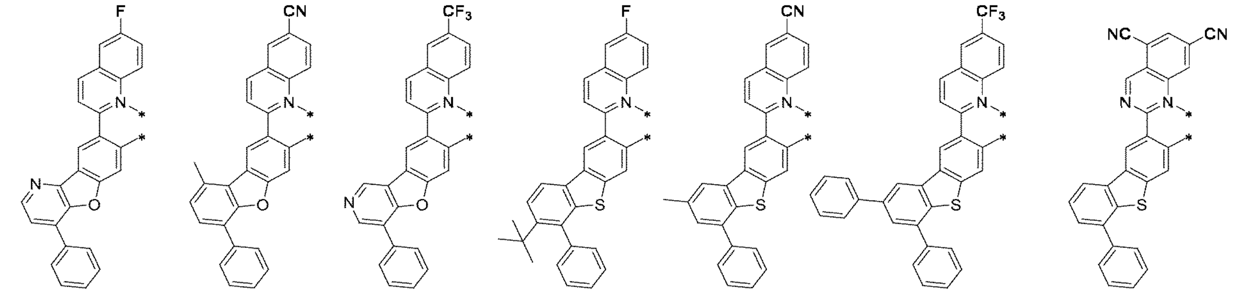

(E-25) (E-26) (E-27) (E-28) (E-29) (E-30) (E-31)

.

In which "*" represents the connecting site connected to Ir. Formulae (E-1) to (E-31) may be further substituted by R*.

In some embodiments, the

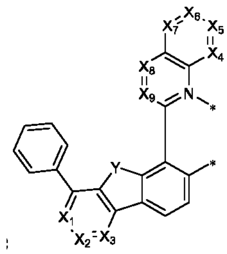

in formula (II) is selected from the group consisting of formulae (F-1) to (F-24):

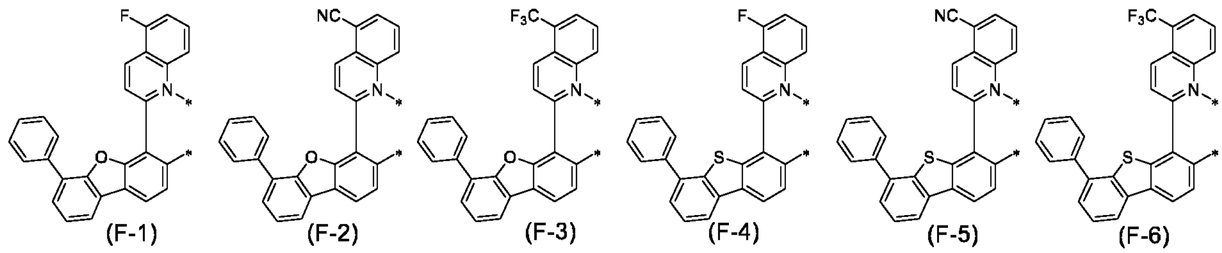

(F-1) (F-2) (F-3) (F-4) (F-5) (F-6)

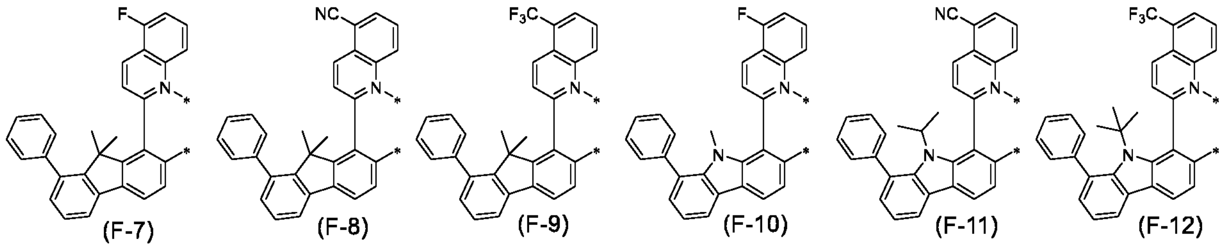

(F-7) (F-8) (F-9) (F-10) (F-11) (F-12)

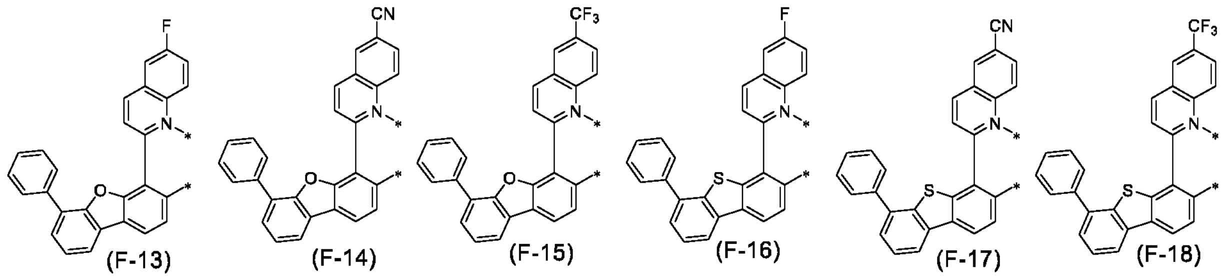

(F-13) (F-14) (F-15) (F-16) (F-17) (F-18)

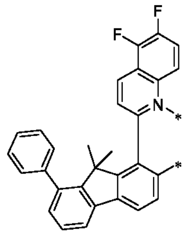 (F-19) 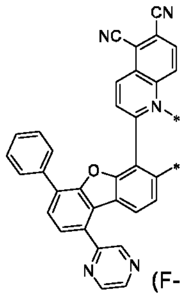 (F-20) 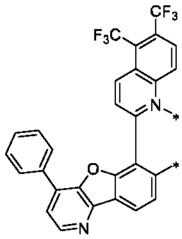 (F-21) 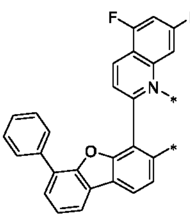 (F-22) 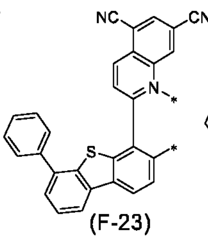 (F-23) 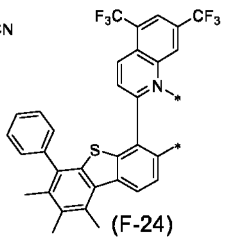 (F-24)

.

In which "*" represents the connecting site connected to Ir. Formulae (F-1) to (F-24) may be further substituted by R*.

In some embodiments, L is a monovalent bidentate anion ligand.

Further, L is selected from the following structural formulae:

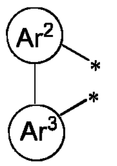 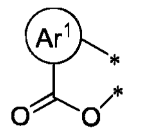 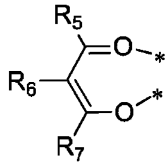 .

in which,

$Ar^1$, $Ar^2$ and $Ar^3$ are selected independently from the group consisting of a substituted or unsubstituted aromatic group having 5 to 30 ring atoms, a substituted or unsubstituted heteroaromatic group having 5 to 30 ring atoms, and a substituted or unsubstituted non-aromatic ring system having 5 to 30 ring atoms.

$R_5$, $R_6$ and $R_7$ are selected independently at each occurrence from the group consisting of -H, -D, a inear alkyl group having 1 to 20 carbon atoms, a linear alkoxy group having 1 to 20 carbon atoms, a linear thioalkoxy group having 1 to 20 carbon atoms, a branched alkyl group having 3 to 20 carbon atoms, a cyclic alkyl group having 3 to 20 carbon atoms, a cyclic alkoxy group having 3 to 20 carbon atoms, a branched thioalkoxy group having 3 to 20 carbon atoms, a cyclic thioalkoxy group having 3 to 20 carbon atoms, a cyclic thioalkoxy group having 3 to 20 carbon atoms, a ketone group having 1 to 20 carbon atoms, an alkoxycarbonyl group having 2 to 20 carbon atoms, an aryloxycarbonyl group having 7 to 20 carbon atoms, -CN, carbamoyl, haloformyl, formyl, an isocyano group, an isocyanate group, an thiocyanate group, an isothiocyanate group, hydroxyl, nitro, $-CF_3$, -Cl, -Br, -F, a substituted or unsubstituted aromatic group having 6 to 60 ring atoms, a substituted or unsubstituted heteroaromatic group having 5 to 60 ring atoms, a substituted or unsubstituted aryloxy group having 6 to 60 ring atoms, a substituted or unsubstituted heteroaryloxy group having 5 to 60 ring atoms, and any combination of the foregoing groups. "*" represents the site connected to Ir.

In some embodiments, $R_5$, $R_6$, $R_7$ are selected independently at each occurrence from the group consisting of -H, -D, a linear alkyl group having 1 to 10 carbon atoms, a branched alkyl group having 3 to 10 carbon atoms, a cyclic alkyl group having 3 to 10 carbon atoms, phenyl, biphenyl, naphthyl, pyrimidinyl, pyridyl, and any combination of the foregoing groups.

In some embodiments, $R_6$ is -H.

In some embodiments, $R_5$ and $R_7$ are selected from the same group.

In some embodiments, $R_5$ and $R_7$ are selected independently at each occurrence from the group consisting of methyl, ethyl, tert-butyl, phenyl, adamantyl, and cyclohexyl.

In some embodiments, $Ar^1$, $Ar^2$ and $Ar^3$ are selected independently of each other from the group consisting of the following groups:

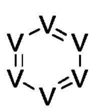 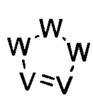 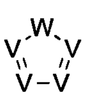 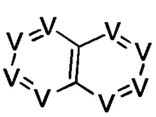 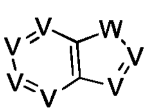 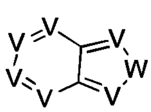 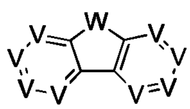 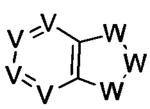

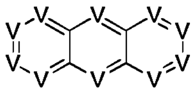 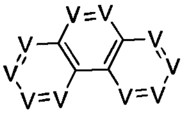 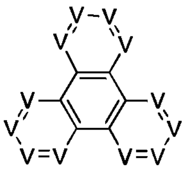 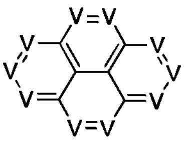 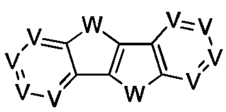 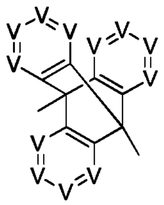

,

in which,

V is selected independently at each occurrence from the group consisting of C, $CR_8$ or N. Any two V may be the same or different.

W is selected independently at each occurrence from the group consisting of $CR_9R_{10}$, $NR_9$, O, S, N, $PR_9$, $BR_9$ and $SiR_9R_{10}$. When the number of W is greater than or equal to 2, any two W may be the same or different.

$R_8$, $R_9$, and $R_{10}$ are selected independently at each occurrence from the group consisting of -H, -D, a linear alkyl group having 1 to 20 carbon atoms, a linear alkoxy group having 1 to 20 carbon atoms, a linear thioalkoxy group having 1 to 20 carbon atoms, a branched alkyl group having 3 to 20 carbon atoms, a cyclic alkyl group having 3 to 20 carbon atoms, a branched alkoxy group having 3 to 20 carbon atoms, a cyclic alkoxy group having 3 to 20 carbon atoms, a branched thioalkoxy group having 3 to 20 carbon atoms, a cyclic thioalkoxy group having 3 to 20 carbon atoms, silicyl, a ketone group having 1 to 20 carbon atoms, an alkoxycarbonyl group having 2 to 20 carbon atoms, an aryloxycarbonyl group having 7 to 20 carbon atoms, -CN, carbamoyl, haloformyl, formyl, an isocyano group, an isocyanate group, a thiocyanate group, an isothiocyanate group, hydroxyl, nitro, $-CF_3$, -Cl, -Br, -F, a substituted or unsubstituted alkenyl group having 2 to 20 carbon atoms, a substituted or unsubstituted aromatic group having 6 to 60 ring atoms, a substituted or unsubstituted heteroaromatic group having 5 to 60 ring atoms, a substituted or unsubstituted aryloxy group having 6 to 60 ring atoms, a substituted or unsubstituted heteroaryloxy group having 5 to 60 ring atoms, and suitable combinations of the foregoing groups. Adjacent two $R_8$ form or do not form a ring, or adjacent two $R_9$ form or do not form a ring.

In an embodiment, the adjacent $R_8$ form a 6-membered ring with each other, referring to the structures (H-8), (H-25), (H-27), (H-28), (H-42), and the like. below.

In some embodiments, $R_8$, $R_9$ and $R_{10}$ are selected independently at each occurrence from the group consisting of the following groups: -H, -D, a linear alkyl group having 1 to 10 carbon atoms, a branched alkyl group having 3 to 10 carbon atoms, a cyclic alkyl group having 3 to 10 carbon atoms, -CN, nitro, $-CF_3$, -Cl, -Br, -F, -I, phenyl, biphenyl, naphthyl, or the like.

In some embodiments, V is independently selected from the group consisting of C, CH, C $(CH_3)$, or N.

In some embodiments, each W is independently selected from O, S, C $(CH_3)_2$, $CH_2$, NH, or N-Ph.

In some preferred embodiments, L is preferably selected from the group consisting of structures (G-1) to (G-28):

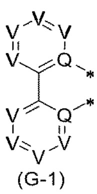
(G-1)
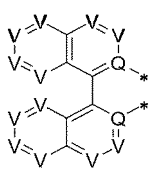
(G-2)
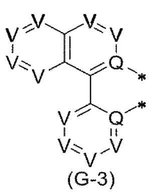
(G-3)
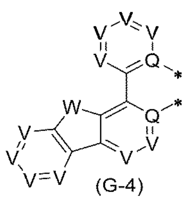
(G-4)
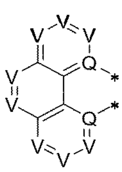
(G-5)
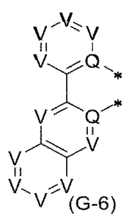
(G-6)
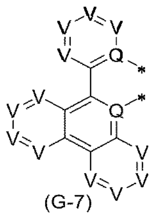
(G-7)

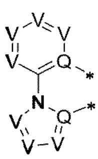
**(G-8)**
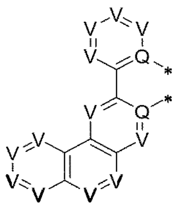
**(G-9)**
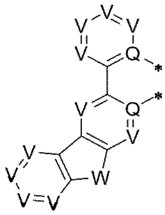
**(G-10)**
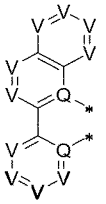
**(G-11)**
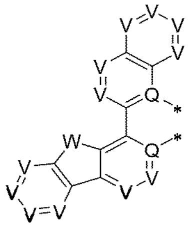
**(G-12)**
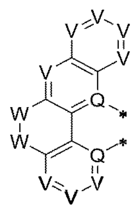
**(G-13)**
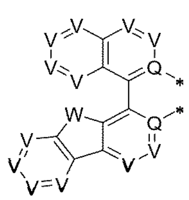
**(G-14)**

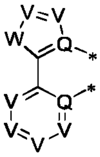
(G-15)
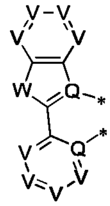
(G-16)
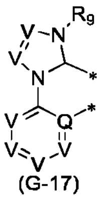
(G-17)
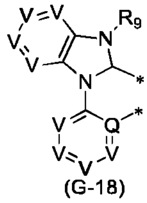
(G-18)
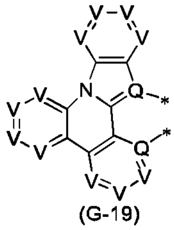
(G-19)
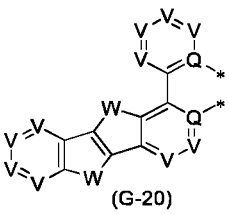
(G-20)
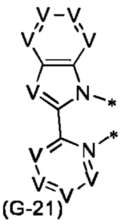
(G-21)
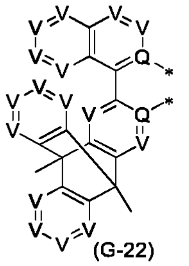
(G-22)
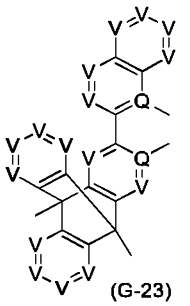
(G-23)
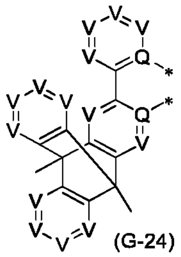
(G-24)
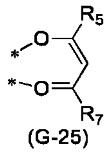
(G-25)
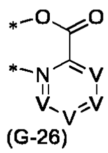
(G-26)
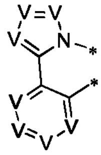
(G-27)
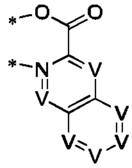
(G-28)

.

In which the definitions of V, W, $R_5$, $R_7$, and $R_8$ are consistent with the above.

In which one Q of the ligand is selected from C, and another one Q of the ligand is selected from N.

In which two $R_8$ form a ring in formula (G-13), and $R_8$ and $R_9$ form a ring in formula (G-19).

Preferably, L is selected from the group consisting of formulae (G-1) to (G-6), (G-16) to (G-18), (G-21), (G-25), and (G-26). More preferably, L is selected from the group consisting of formulae (G-1), (G-25), and (G-26).

In some embodiments, L is selected from the group consisting of the structures (H-1) to (H-42):

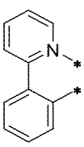
(H-1)
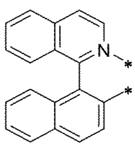
(H-2)
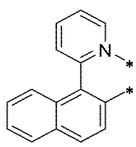
(H-3)
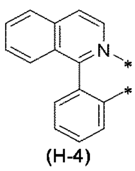
(H-4)
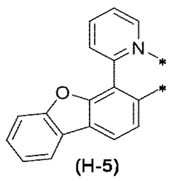
(H-5)
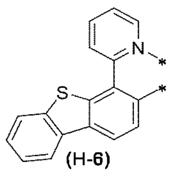
(H-6)
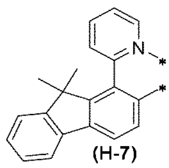
(H-7)
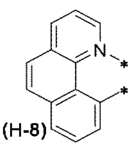
(H-8)
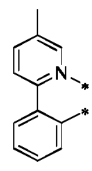
(H-9)
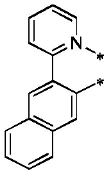
(H-10)
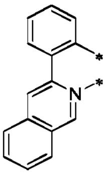
(H-11)
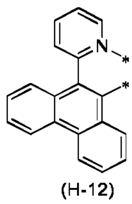
(H-12)
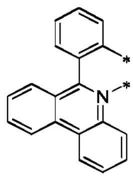
(H-13)
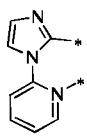
(H-14)
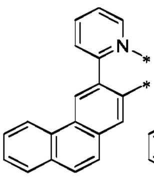
(H-15)
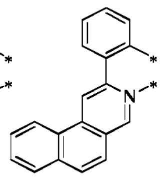
(H-16)
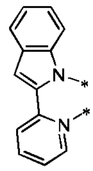
(H-17)
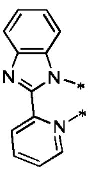
(H-18)
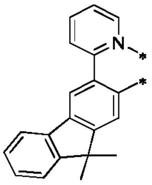
(H-19)
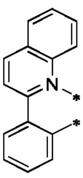
(H-20)
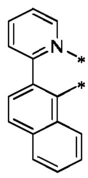
(H-21)
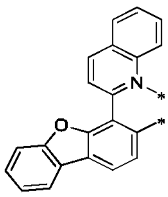
(H-22)
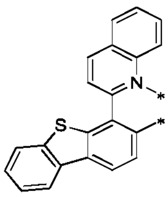
(H-23)
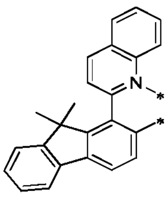
(H-24)
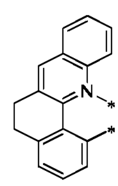
(H-25)

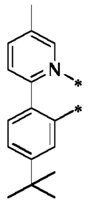
(H-26)
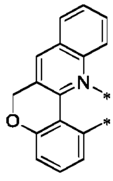
(H-27)
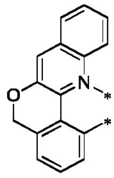
(H-28)
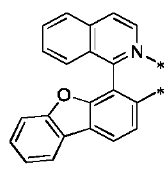
(H-29)
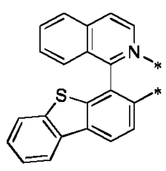
(H-30)
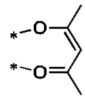
(H-31)
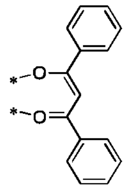
(H-32)
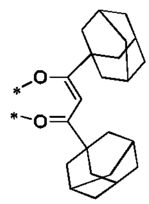
(H-33)

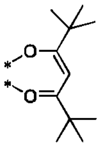
(H-34)
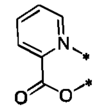
(H-35)
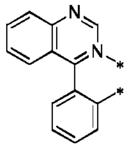
(H-36)
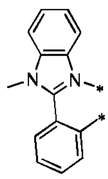
(H-37)
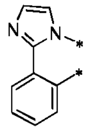
(H-38)
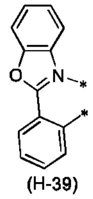
(H-39)
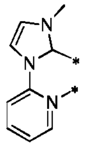
(H-40)
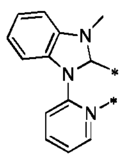
(H-41)
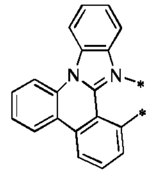
(H-42)

;

in which formulae (H-1) to (H-42) may be further substituted by R*.

In which two $R_8$ form a ring by a carbon-carbon double bond in formula (H-8).

In some embodiments, the metal complex is selected from the group consisting of formulae (2-1) to (2-16):

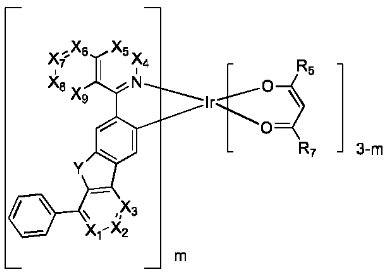
(2-1)
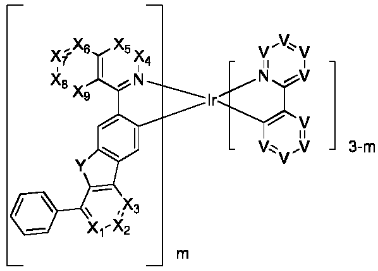
(2-2)
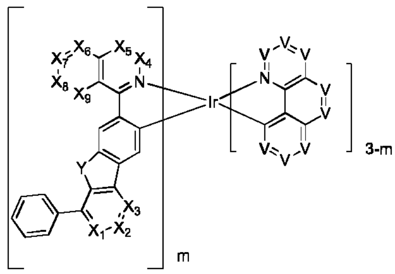
(2-3)

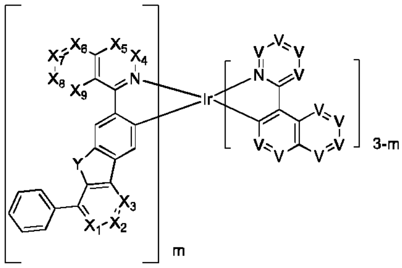
(2-4)
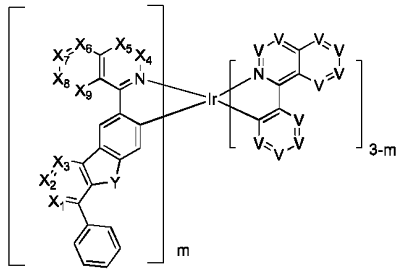
(2-5)
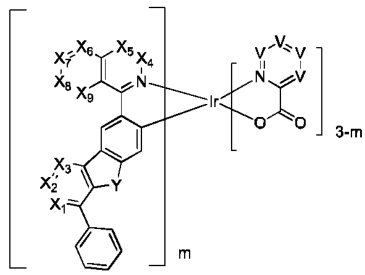
(2-6)

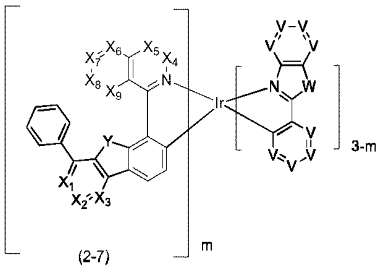
(2-7)
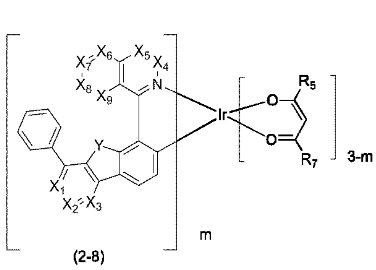
(2-8)
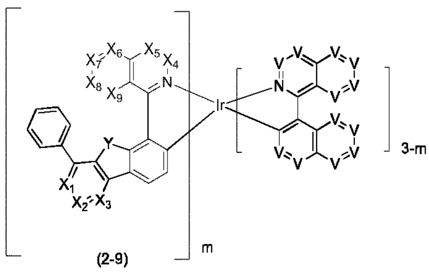
(2-9)

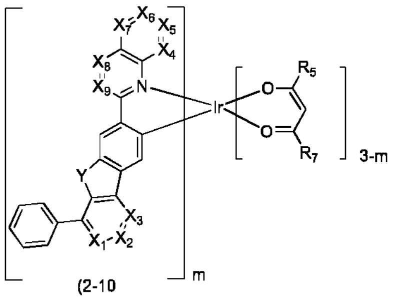

(2-10

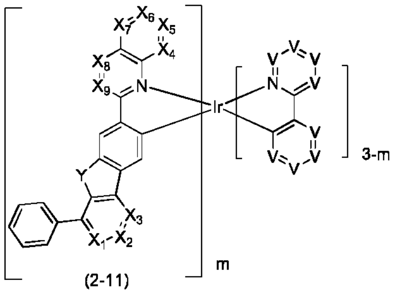

(2-11)

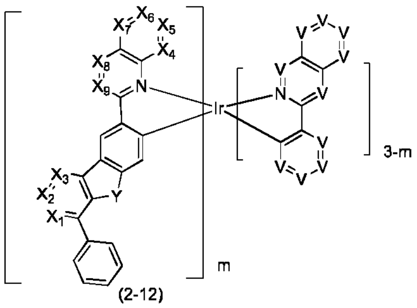

(2-12)

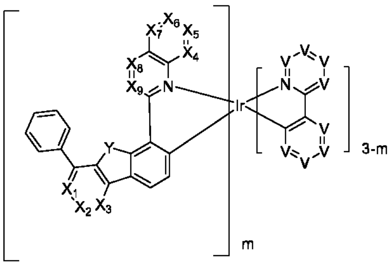

(2-13)

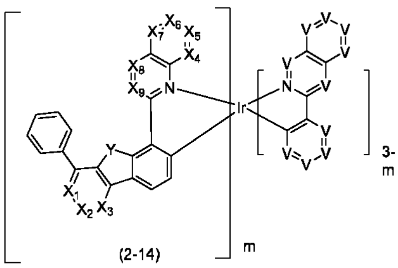

(2-14)

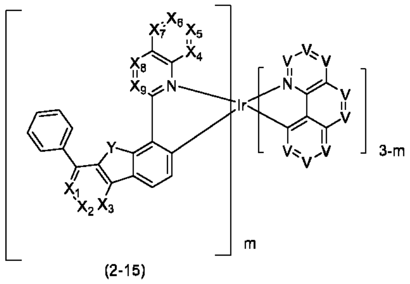

(2-15)

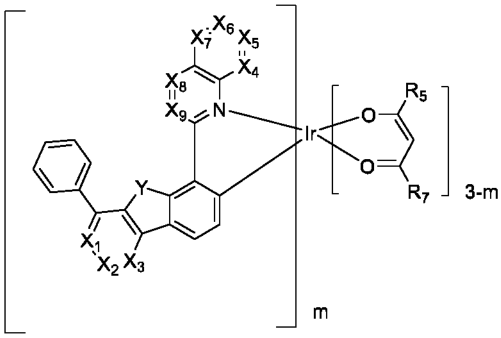

(2-16)

.

Preferably, X in formulae (2-1) to $(2\text{-}15)_7$ is selected from $CR_2$, and $R_2$ is selected from -CN, -F, or $-CF_3$.

Specific structures of suitable metal complexes according to the present disclosure are described below, but not limited thereto.

In some specific embodiments, the structure of the metal complexes is shown in Tables 1 and 2 below.

In Tables 1 and 2, L1 represents

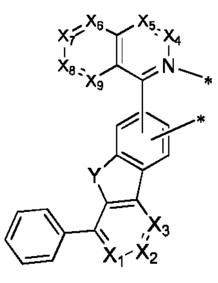

,

and L2 represents

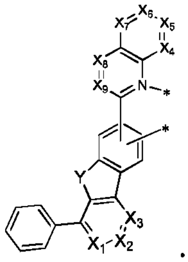

Table 1. Examples of structures of compounds as represented by formula (I).

| No. | L1 | L | m | No. | L1 | L | m |
|---|---|---|---|---|---|---|---|
| (1) | (A-1) | (H-1) | 1 | (2) | (A-1) | (H-1) | 2 |
| (3) | (A-1) | (H-3) | 1 | (4) | (A-1) | (H-4) | 2 |
| (5) | (A-1) | (H-8) | 1 | (6) | (A-1) | (H-8) | 2 |
| (7) | (A-1) | (H-31) | 2 | (8) | (A-1) | (H-39) | 1 |
| (9) | (A-2) | (H-1) | 2 | (10) | (A-2) | (H-8) | 1 |
| (11) | (A-2) | (H-27) | 2 | (12) | (A-2) | (H-33) | 1 |
| (13) | (A-2) | (H-34) | 1 | (14) | (A-3) | (H-1) | 2 |
| (15) | (A-3) | (H-9) | 1 | (16) | (A-3) | (H-42) | 2 |
| (17) | (A-4) | (H-1) | 2 | (18) | (A-4) | (H-11) | 1 |
| (19) | (A-4) | (H-31) | 1 | (20) | (A-4) | (H-35) | 2 |
| (21) | (A-5) | (H-9) | 1 | (22) | (A-5) | (H-32) | 2 |
| (23) | (A-5) | (H-36) | 2 | (24) | (A-5) | (H-41) | 1 |
| (25) | (A-6) | (H-1) | 1 | (26) | (A-6) | (H-2) | 2 |
| (27) | (A-6) | (H-8) | 1 | (28) | (A-6) | (H-18) | 1 |
| (29) | (A-6) | (H-26) | 2 | (30) | (A-6) | (H-34) | 2 |
| (31) | (A-7) | (H-2) | 1 | (32) | (A-7) | (H-6) | 2 |
| (33) | (A-8) | (H-9) | 1 | (34) | (A-8) | (H-40) | 1 |
| (35) | (A-9) | (H-1) | 2 | (36) | (A-9) | (H-28) | 1 |
| (37) | (A-10) | (H-8) | 1 | (38) | (A-10) | (H-34) | 1 |
| (39) | (A-11) | (H-4) | 2 | (40) | (A-11) | (H-42) | 1 |
| (41) | (A-12) | (H-26) | 1 | (42) | (A-12) | (H-33) | 2 |
| (43) | (A-13) | (H-14) | 2 | (44) | (A-13) | (H-36) | 1 |
| (45) | (A-14) | (H-1) | 1 | (46) | (A-14) | (H-33) | 2 |
| (47) | (A-15) |  | 3 | (48) | (A-15) | (H-1) | 1 |
| (49) | (A-16) | (H-12) | 2 | (50) | (A-16) | (H-37) | 2 |
| (51) | (A-17) | (H-26) | 2 | (52) | (A-17) | (H-31) | 1 |
| (53) | (A-18) | (H-9) | 1 | (54) | (A-18) | (H-34) | 2 |
| (55) | (A-19) | (H-3) | 1 | (56) | (A-19) | (H-4) | 2 |
| (57) | (A-20) | (H-8) | 2 | (58) | (A-20) | (H-32) | 1 |
| (59) | (A-21) | (H-32) | 1 | (60) | (A-21) | (H-37) | 1 |

(continued)

| No. | L1 | L | m | No. | L1 | L | m |
|---|---|---|---|---|---|---|---|
| (61) | (A-22) | (H-1) | 2 | (62) | (A-23) | (H-8) | 1 |
| (63) | (A-24) | (H-9) | 1 | (64) | (A-25) | (H-17) | 1 |
| (65) | (A-26) | (H-26) | 2 | (66) | (A-27) | (H-30) | 2 |
| (67) | (A-28) | (H-1) | 2 | (68) | (A-29) | (H-31) | 1 |
| (69) | (A-30) | (H-25) | 2 | (70) | (A-31) | (H-33) | 1 |
| (71) | (A-32) | (H-34) | 1 | (72) | (A-33) | (H-36) | 1 |
| (73) | (A-34) | (H-1) | 1 | (74) | (A-35) | (H-8) | 2 |
| (75) | (A-36) | (H-2) | 2 | (76) | (A-37) | (H-34) | 2 |
| (77) | (A-38) | (H-8) | 1 | (78) | (A-38) | (H-39) | 1 |
| (79) | (A-39) | (H-3) | 1 | (80) | (A-40) | (H-22) | 2 |
| (81) | (A-41) | (H-5) | 2 | (82) | (A-42) | (H-15) | 1 |
| (83) | (A-43) | (H-9) | 2 | (84) | (A-44) | (H-32) | 1 |
| (85) | (A-45) | (H-4) | 1 | (86) | (A-46) | | 3 |
| (87) | (A-47) | (H-6) | 2 | (88) | (A-47) | (H-8) | 2 |
| (89) | (A-48) | (H-26) | 2 | (90) | (A-48) | (H-36) | 1 |
| (91) | (B-1) | (H-1) | 1 | (92) | (B-1) | (H-4) | 1 |
| (93) | (B-1) | (H-8) | 2 | (94) | (B-2) | (H-9) | 2 |
| (95) | (B-2) | (H-18) | 1 | (96) | (B-2) | (H-31) | 2 |
| (97) | (B-3) | (H-1) | 1 | (98) | (B-3) | (H-4) | 2 |
| (99) | (B-3) | (H-34) | 2 | (100) | (B-4) | | 3 |
| (101) | (B-4) | (H-26) | 1 | (102) | (B-4) | (H-36) | 2 |
| (103) | (B-5) | (H-4) | 2 | (104) | (B-5) | (H-10) | 2 |
| (105) | (B-5) | (H-29) | 2 | (106) | (B-6) | (H-36) | 1 |
| (107) | (B-6) | (H-9) | 1 | (108) | (B-6) | (H-27) | 1 |
| (109) | (B-7) | (H-26) | 1 | (110) | (B-7) | (H-4) | 2 |
| (111) | (B-8) | (H-9) | 1 | (112) | (B-8) | (H-42) | 2 |
| (113) | (B-9) | (H-35) | 2 | (114) | (B-9) | (H-36) | 1 |
| (115) | (B-10) | (H-1) | 2 | (116) | (B-10) | (H-4) | 1 |
| (117) | (B-11) | (H-2) | 2 | (118) | (B-11) | (H-33) | 2 |
| (119) | (B-12) | (H-4) | 1 | (120) | (B-12) | (H-17) | 2 |
| (121) | (B-13) | (H-9) | 2 | (122) | (B-13) | (H-31) | 2 |
| (123) | (B-14) | (H-26) | 1 | (124) | (B-14) | (H-36) | 2 |
| (125) | (B-15) | (H-7) | 1 | (126) | (B-14) | (H-8) | 1 |
| (127) | (B-16) | (H-9) | 1 | (128) | (B-16) | (H-11) | 1 |
| (129) | (B-17) | (H-26) | 2 | (130) | (B-17) | (H-36) | 2 |
| (131) | (B-18) | (H-1) | 1 | (132) | (B-18) | (H-37) | 2 |
| (133) | (B-19) | (H-4) | 1 | (134) | (B-20) | (H-40) | 1 |
| (135) | (B-21) | (H-8) | 1 | (136) | (B-21) | (H-12) | 2 |

(continued)

| No. | L1 | L | m | No. | L1 | L | m |
|---|---|---|---|---|---|---|---|
| (137) | (B-22) | (H-4) | 1 | (138) | (B-22) | (H-26) | 2 |
| (139) | (B-23) | (H-26) | 2 | (140) | (B-24) | (H-4) | 2 |
| (141) | (C-1) | (H-1) | 1 | (142) | (C-1) | (H-2) | 1 |
| (143) | (C-1) | (H-32) | 1 | (144) | (C-2) | (H-2) | 1 |
| (145) | (C-2) | (H-8) | 2 | (146) | (C-2) | (H-31) | 2 |
| (147) | (C-3) | (H-9) | 2 | (148) | (C-3) | (H-32) | 2 |
| (149) | (C-3) | (H-37) | 2 | (150) | (C-4) | (H-3) | 1 |
| (151) | (C-4) | (H-17) | 1 | (152) | (C-4) | (H-33) | 1 |
| (153) | (C-5) | (H-2) | 1 | (154) | (C-5) | (H-26) | 1 |
| (155) | (C-5) | (H-34) | 2 | (156) | (C-6) | (H-39) | 2 |
| (157) | (C-6) | (H-4) | 2 | (158) | (C-6) | (H-39) | 2 |
| (159) | (C-7) | (H-21) | 2 | (160) | (C-7) | (H-34) | 2 |
| (161) | (C-7) | (H-39) | 2 | (162) | (C-8) | (H-9) | 1 |
| (163) | (C-8) | (H-31) | 1 | (164) | (C-8) | (H-41) | 2 |
| (165) | (C-9) | (H-2) | 1 | (166) | (C-9) | (H-27) | 1 |
| (167) | (C-10) | (H-12) | 1 | (168) | (C-10) | (H-31) | 1 |
| (169) | (C-11) | (H-33) | 2 | (170) | (C-11) | (H-37) | 2 |
| (171) | (C-12) | (H-4) | 1 | (172) | (C-12) | (H-26) | 2 |
| (173) | (C-13) | (H-2) | 2 | (174) | (C-13) | (H-37) | 1 |
| (175) | (C-14) | (H-4) | 2 | (176) | (C-14) | (H-33) | 1 |
| (177) | (C-15) | (H-30) | 2 | (178) | (C-15) | (H-39) | 1 |
| (179) | (C-16) | (H-35) | 1 | (180) | (C-16) | | 3 |
| (181) | (C-17) | (H-1) | 1 | (182) | (C-17) | (H-2) | 2 |
| (183) | (C-18) | (H-31) | 1 | (184) | (C-18) | (H-39) | 2 |
| (185) | (C-19) | (H-8) | 2 | (186) | (C-19) | (H-26) | 2 |
| (187) | (C-20) | (H-2) | 2 | (188) | (C-20) | (H-32) | 1 |
| (189) | (C-21) | (H-34) | 1 | (190) | (C-22) | (H-39) | 1 |
| (191) | (C-23) | (H-1) | 1 | (192) | (C-24) | (H-31) | 2 |
| (193) | (C-25) | (H-37) | 2 | (194) | (C-26) | (H-2) | 2 |
| (195) | (C-27) | (H-39) | 1 | (196) | (C-28) | (H-1) | 2 |
| (197) | (C-29) | (H-2) | 2 | (198) | (C-29) | (H-8) | 2 |
| (199) | (C-29) | (H-32) | 1 | (200) | (C-30) | (H-36) | 2 |
| (201) | (C-31) | (H-2) | 1 | (202) | (C-32) | (H-37) | 1 |
| (203) | (C-33) | (H-33) | 1 | (204) | (C-34) | (H-42) | 1 |
| (205) | (C-35) | (H-1) | 2 | (206) | (C-36) | (H-18) | 1 |

Table 2. Examples of structures of compounds as represented by formula (II).

| No. | L2 | L | m | No. | L2 | L | m |
|---|---|---|---|---|---|---|---|
| (207) | (D-1) | (H-1) | 2 | (208) | (D-1) | (H-31) | 1 |
| (209) | (D-2) | (H-1) | 1 | (210) | (D-2) | (H-8) | 2 |
| (211) | (D-3) | (H-9) | 2 | (212) | (D-3) | (H-17) | 2 |
| (213) | (D-4) | (H-32) | 2 | (214) | (D-4) | (H-36) | 1 |
| (215) | (D-5) | (H-26) | 1 | (216) | (D-5) | (H-34) | 1 |
| (217) | (D-6) | | 3 | (218) | (D-6) | (H-32) | 1 |
| (219) | (D-7) | (H-1) | 1 | (220) | (D-7) | (H-2) | 2 |
| (221) | (D-8) | (H-9) | 1 | (222) | (D-8) | (H-33) | 2 |
| (223) | (D-9) | (H-26) | 2 | (224) | (D-9) | (H-42) | 2 |
| (225) | (D-10) | (H-9) | 1 | (226) | (D-10) | (H-34) | 2 |
| (227) | (D-11) | (H-1) | 1 | (228) | (D-11) | (H-8) | 2 |
| (229) | (D-12) | (H-4) | 2 | (230) | (D-12) | (H-26) | 1 |
| (231) | (D-13) | (H-31) | 2 | (232) | (D-14) | (H-35) | 1 |
| (233) | (D-15) | (H-26) | 2 | (234) | (D-16) | (H-34) | 1 |
| (235) | (D-17) | (H-1) | 1 | (236) | (D-18) | (H-27) | 1 |
| (237) | (D-19) | (H-9) | 1 | (238) | (D-20) | (H-18) | 2 |
| (239) | (D-21) | (H-23) | 1 | (240) | (D-21) | (H-33) | 2 |
| (241) | (D-22) | (H-1) | 2 | (242) | (D-22) | (H-31) | 2 |
| (243) | (D-23) | (H-9) | 2 | (244) | (D-24) | (H-32) | 1 |
| (245) | (D-25) | (H-26) | 1 | (246) | (D-26) | (H-34) | 2 |
| (247) | (D-27) | (H-2) | 2 | (248) | (D-28) | (H-8) | 1 |
| (249) | (D-29) | (H-9) | 1 | (250) | (D-30) | (H-42) | 1 |
| (251) | (D-31) | (H-1) | 2 | (252) | (D-32) | (H-9) | 2 |
| (253) | (D-33) | (H-26) | 1 | (254) | (D-34) | (H-31) | 1 |
| (255) | (D-35) | (H-33) | 1 | (256) | (D-35) | (H-34) | 2 |
| (257) | (E-1) | (H-1) | 2 | (258) | (E-1) | (H-10) | 2 |
| (259) | (E-1) | (H-25) | 1 | (260) | (E-2) | (H-2) | 2 |
| (261) | (E-2) | (H-11) | 1 | (262) | (E-2) | (H-27) | 1 |
| (263) | (E-2) | (H-3) | 1 | (264) | (E-3) | (H-8) | 1 |
| (265) | (E-3) | (H-10) | 1 | (266) | (E-3) | (H-11) | 2 |
| (267) | (E-4) | (H-9) | 2 | (268) | (E-4) | (H-1) | 2 |
| (269) | (E-4) | (H-34) | 2 | (270) | (E-5) | (H-4) | 2 |
| (271) | (E-5) | (H-11) | 2 | (272) | (E-5) | (H-36) | 1 |
| (273) | (E-6) | (H-10) | 2 | (274) | (E-6) | (H-25) | 1 |
| (275) | (E-6) | (H-39) | 1 | (276) | (E-7) | (H-1) | 1 |
| (277) | (E-7) | (H-11) | 2 | (278) | (E-7) | (H-32) | 2 |
| (279) | (E-8) | (H-4) | 1 | (280) | (E-8) | (H-10) | 2 |
| (281) | (E-9) | (H-27) | 2 | (282) | (E-9) | (H-34) | 1 |

(continued)

| No. | L2 | L | m | No. | L2 | L | m |
|---|---|---|---|---|---|---|---|
| (283) | (E-10) | (H-8) | 2 | (284) | (E-10) | (H-28) | 2 |
| (285) | (E-11) | (H-31) | 1 | (286) | (E-11) | (H-6) | 1 |
| (287) | (E-12) | (H-10) | 1 | (288) | (E-12) | (H-11) | 2 |
| (289) | (E-13) | (H-37) | 1 | (290) | (E-13) | (H-33) | 2 |
| (291) | (E-14) | | 3 | (292) | (E-14) | (H-26) | 1 |
| (293) | (E-15) | (H-11) | 2 | (294) | (E-16) | (H-11) | 1 |
| (295) | (E-17) | (H-25) | 2 | (296) | (E-18) | (H-32) | 2 |
| (297) | (E-19) | (H-36) | 1 | (298) | (E-20) | (H-37) | 2 |
| (299) | (E-21) | (H-10) | 1 | (300) | (E-22) | (H-25) | 1 |
| (301) | (E-23) | (H-1) | 1 | (302) | (E-24) | (H-27) | 1 |
| (303) | (E-25) | (H-11) | 2 | (304) | (E-26) | (H-35) | 2 |
| (305) | (E-27) | (H-28) | 2 | (306) | (E-28) | (H-30) | 1 |
| (307) | (E-29) | (H-9) | 2 | (308) | (E-30) | (H-11) | 2 |
| (309) | (E-31) | (H-27) | 1 | (310) | (E-15) | (H-28) | 1 |
| (311) | (F-1) | (H-1) | 1 | (312) | (F-1) | (H-8) | 1 |
| (313) | (F-1) | (H-31) | 2 | (314) | (F-2) | (H-2) | 2 |
| (315) | (F-2) | (H-9) | 2 | (316) | (F-2) | (H-32) | 1 |
| (317) | (F-3) | (H-3) | 1 | (318) | (F-3) | (H-8) | 2 |
| (319) | (F-3) | (H-26) | 2 | (320) | (F-4) | (H-4) | 1 |
| (321) | (F-4) | (H-9) | 2 | (322) | (F-4) | (H-33) | 2 |
| (323) | (F-5) | (H-5) | 1 | (324) | (F-5) | (H-8) | 2 |
| (325) | (F-5) | (H-26) | 1 | (326) | (F-6) | (H-2) | 1 |
| (327) | (F-6) | (H-1) | 1 | (328) | (F-6) | (H-34) | 2 |
| (329) | (F-7) | (H-10) | 2 | (330) | (F-7) | (H-31) | 1 |
| (331) | (F-8) | (H-8) | 2 | (332) | (F-8) | (H-9) | 1 |
| (333) | (F-9) | (H-1) | 2 | (334) | (F-9) | (H-34) | 1 |
| (335) | (F-10) | (H-31) | 1 | (336) | (F-10) | (H-39) | 1 |
| (337) | (F-11) | (H-8) | 2 | (338) | (F-11) | (H-29) | 2 |
| (339) | (F-12) | (H-9) | 2 | (340) | (F-12) | (H-33) | 2 |
| (341) | (F-13) | (H-26) | 1 | (342) | (F-13) | (H-27) | 1 |
| (343) | (F-14) | (H-8) | 1 | (344) | (F-14) | (H-34) | 2 |
| (345) | (F-15) | (H-1) | 1 | (346) | (F-16) | (H-20) | 2 |
| (347) | (F-17) | | 3 | (348) | (F-18) | (H-9) | 1 |
| (349) | (F-19) | (H-26) | 2 | (350) | (F-20) | (H-33) | 1 |
| (351) | (F-21) | (H-8) | 2 | (352) | (F-21) | (H-31) | 2 |
| (353) | (F-22) | (H-10) | 1 | (354) | (F-22) | (H-26) | 1 |
| (355) | (F-23) | (H-34) | 2 | (356) | (F-24) | (H-42) | 2 |

The metal complex according to the present disclosure may be used as a functional material in electronic devices. Organic functional materials include, but not limited to, a hole injection material (HIM), a hole transport material (HTM), an electron transport material (ETM), an electron injection material (EIM), an electron blocking material (EBM), a hole blocking material (HBM), a luminescent material (Emitter), a host material (Host), and the like.

In an embodiment, the metal complex is a luminescent material having an emission wavelength ranging from 300 nm to 1000 nm. Further, the emission wavelength of the metal complex ranges from 350 nm to 900 nm. More further, the emission wavelength of the metal complex ranges from 400 nm to 800 nm. It should be noted that luminescence in this paper refers to photoluminescence or electroluminescence.

In some embodiments, the electroluminescence efficiency of the metal complex is greater than or equal to 30%. Further, the electroluminescence efficiency of the metal complex is greater than or equal to 40%. More further, the electroluminescence efficiency of the metal complex is greater than or equal to 50%. In particular, the electroluminescence efficiency of the metal complex is greater than or equal to 60%.

In some embodiments, the metal complex is used as a phosphorescent guest in a light emitting layer. The phosphorescent guest material needs to have appropriate triplet energy levels ($T_1$). In some embodiments, $T_1$ of the metal complex is greater than or equal to 2.0 eV. Further, $T_1$ of the metal complex is greater than or equal to 2.2 eV. Further, $T_1$ of the metal complex is greater than or equal to 2.4 eV. In particular, $T_1$ of the metal complex is greater than or equal to 2.6 eV.

As a functional material, it is hoped to have good thermal stability. In some embodiments, the glass transition temperature Tg of the metal complex is greater than or equal to 100 °C. In some embodiments, the glass transition temperature Tg of the metal complex is greater than or equal to 120 °C. In some embodiments, the glass transition temperature Tg of the metal complex is greater than or equal to 160 °C. In some embodiments, the glass transition temperature Tg of the metal complex is greater than or equal to 180 °C.

Further, a mixture is provided by the present disclosure, including the metal complex as described above and at least an organic functional material.

The organic functional material may be selected from a Hole injection material (HIM), a hole transport material (HTM), an electron transport material (ETM), an electron injection material (EIM), an electron barrier material (EBM), a hole barrier material (HBM), a luminescent material (Emitter), a host material (Host), or an organic dye. Various organic functional materials are described in detail in WO2010135519A1, US20090134784A1 and WO2011110277A1, and all contents of these three patent documents are hereby incorporated herein for reference.

In some embodiments, a mass content of the metal complex ranges from 0.01 wt% to 30 wt% in the mixture. In some further embodiments, the mass content of the metal complex ranges from 0.5 wt% to 20 wt%. In some more further embodiments, the mass content of the metal complex ranges from 2 wt% to 15 wt%. In some particular embodiments, the mass content of the metal complex ranges from 5 wt% to 15 wt%.

In some embodiments, in the mixture, the other organic functional material is selected from the host material. In some embodiment, the mixture includes the metal complex as described above and two different host materials.

The present disclosure further relates to a composition, which includes the metal complex or the mixture as described above and at least an organic solvent (denoted as a first solvent).

In some embodiments, the organic solvent is selected from any one of aromatic series, heteroaromatic series, ester, aromatic ketone, aromatic ether, aliphatic ketone, aliphatic ether, cycloaliphatic, olefin-based compounds, borate esters and phosphate esters, or a mixture of any two or more of the aforementioned solvents.

In some embodiments, the organic solvent includes an aromatic or heteroaromatic-based solvent.

In some embodiments, examples of the aromatic or heteroaromatic-based solvent suitable for the present disclosure include, but not limited to, p-diisopropylbenzene, pentylbenzene, tetrahydronaphthalene, cyclohexylbenzene, chloronaphthalene, 1,4-dimethylnaphthalene, 3-isopropylbiphenyl, p-methylisopropylbenzene, dipentylbenzene, tripentylbenzene, pentyltoluene, o-diethylbenzene, m-diethylbenzene, p-diethylbenzene, 1,2,3,4-tetramethylbenzene, 1,2,3,5-tetramethylbenzene, 1,2,4. 5-tetramethylbenzene, butylbenzene, dodecylbenzene, dihexylbenzene, dibutylbenzene, p-diisopropylbenzene, cyclohexylbenzene, benzylbutylbenzene, dimethylnaphthalene, 3-isopropylbiphenyl, p-methylisopropylbenzene, 1-methylnaphthalene, 1,2,4-trichlorobenzene, 4,4-difluorodiphenylmethane, 1,2-dimethoxy-4-(1-propenyl) benzene, diphenylmethane, 2-phenylpyridine, 3-phenylpyridine, N-methyldiphenylamine, 4-isopropylbiphenyl, $\alpha$, $\alpha$-dichlorodiphenylmethane, 4-(3-phenylpropyl) pyridine, benzyl benzoate, 1. 1-Bis (3,4-dimethylphenyl) ethane, 2-isopropyl naphthalene, quinoline, isoquinoline, methyl 2-furoate, ethyl 2-furoate, or the like.

In some embodiments, examples of aromatic ketone-based solvents suitable for the present disclosure include, but not limited to, 1-tetralinone, 2-tetralinone, 2-(phenylepoxy) tetralinone, 6-(methoxy) tetralinone, acetophenone, phenylpropanone, benzophenone, and derivatives thereof, such as 4-methylacetophenone, 3-methylacetophenone, 2-methylacetophenone, 4-methylpropiophenone, 3-methylpropiophenone, 2-methylpropiophenone, and the like.

In some embodiments, examples of aromatic ether-based solvents suitable for the present disclosure include, but not limited to, 3-phenoxytoluene, butoxybenzene, p-anisaldehyde dimethyl acetal, tetrahydro-2-phenoxy-2H-pyran, 1,2-dimethoxy-4- ( 1-propenyl) benzene, 1,4-benzodioxane, 1,3-dipropylbenzene, 2,5-dimethoxytoluene, 4-ethoxyethyl

ether, 1,3-dipropoxybenzene, 1,2,4-trimethoxybenzene, 4- ( 1-propenyl) - 1,2-dimethoxybenzene, 1. 3-dimethoxybenzene, glycidyl phenyl ether, dibenzyl ether, 4-tert-butyl anisole, trans-p-propenyl anisole, 1,2-dimethoxybenzene, 1-methoxynaphthalene, diphenyl ether, 2-phenoxymethyl ether, 2-phenoxytetrahydrofuran, ethyl-2-naphthyl ether, and the like.

In some embodiments, examples of aliphatic ketone-based solvents suitable for the present disclosure include, but not limited to, 2-nonanone, 3-nonanone, 5-nonanone, 2-decone, 2,5-hexanedione, 2,6,8-trimethyl-4-nonanone, fenchone, 2,6-dimethyl-2,5-heptadien-4-one, isophorone, 6-undecanone, or the like; or aliphatic ethers, such as amyl ether, hexyl ether, dioctyl ether, ethylene glycol dibutyl ether, diethylene glycol diethyl ether, diethylene glycol butyl methyl ether, diethylene glycol dibutyl ether, triethylene glycol dimethyl ether, triethylene glycol ethyl methyl ether, triethylene glycol butyl methyl ether, tripropylene glycol dimethyl ether, tetraethylene glycol dimethyl ether, and the like.

In some embodiments, examples of ester-based solvents suitable for the present disclosure include, but not limited to, alkyl octoates, alkyl sebacates, alkyl stearates, alkyl benzoates, alkyl phenylacetates, alkyl cinnamate, alkyl oxalates, and maleates, alkyl lactones, alkyl oleates, and the like. The ester-based solvent is preferably octyl caprylate, diethyl sebacate, diallyl phthalate, isononyl isononate, and the like.

The above organic solvent may be used alone or as a mixture of two or more organic solvents.

In some embodiments, the composition may further include another organic solvent (denoted as a second organic solvent). Examples of another organic solvent (the second organic solvent) include, but not limited to, any of methanol, ethanol, 2-methoxyethanol, dichloromethane, chloroform, chlorobenzene, o-dichlorobenzene, tetrahydrofuran, anisole, morpholine, toluene, o-xylene, m-xylene, p-xylene, 1, 4 dioxane, acetone, 2-butanone, 1, 2 dichloroethane, 3-phenoxytoluene, 1, 1, 1-trichloroethane, 1, 1, 2-tetrachloroethane, ethyl acetate, butyl acetate, dimethylformamide, dimethyl acetamide, dimethyl sulfoxide, tetrahydronaphthalene, naphthene, and indene, or sutiable mixtures of the foregoing solvents.

In some embodiments, solvents particularly suitable for the present disclosure are solvents with Hansen solubility parameters in the following range:

$\delta_d$ (dispersion force) in the range of 17.0 ~ 23.2 $Mpa^{1/2}$, especially in the range of 18.5 ~ 21.0 $MPa^{1/2}$; and/or,
$\delta_p$ (polarity force) in the range of 0.2 ~ 12.5 $MPa^{1/2}$, especially in the range of 2.0 ~ 6.0 $MPa^{1/2}$; and/or,
$\delta_h$ (hydrogen bonding force) in the range of 0.9 ~ 14.2 $MPa^{1/2}$, especially in the range of 2.0 ~ 6.0 $MPa^{1/2}$.

In the composition of the present disclosure, the boiling point parameters of the organic solvent should be considered when selecting the organic solvent. In the preparation of an organic electronic device, a composition containing an organic solvent is ejected from an inkjet print head and adhered to a substrate, and then the organic solvent evaporates to form a thin film containing the metal complex of the present disclosure. Therefore, choosing organic solvent with suitable boiling point can prevent nozzle blockage of inkjet printer head.

In some embodiments, the organic solvent has a boiling point greater than or equal to 150 °C. Further, the boiling point of the organic solvent is greater than or equal to 180 °C. Further, the boiling point of the organic solvent is greater than or equal to 200 °C. Further, the boiling point of the organic solvent is greater than or equal to 250 °C. In particular, the boiling point of the organic solvent is greater than or equal to 275 °C, or greater than or equal to 300 °C. Boiling points in these ranges are beneficial to prevent nozzle blockage of inkjet printing heads. The organic solvent can be evaporated from the solvent group to form a film containing the functional material.

In one embodiment, the composition according to the present disclosure is a solution.

In another embodiment, the composition according to the present disclosure is a suspension.

In some embodiments, the composition provided by the third aspect of the present disclosure includes the metal complex of the first aspect of the present disclosure or the mixture of the second aspect of the present disclosure, the mass content of the metal complex or the mixture in the composition ranges from 0.01 wt% to 10wt%, further 0.1 wt% to 5wt%, more further 0.2 wt% to 5wt%, and in particular 0.25 wt% to 3wt%.

The present disclosure further relates to the use of the composition as a coating or printing ink in the preparation of organic electronic devices, in particular preparation methods by printing or coating.

Suitable printing or coating methods include, but not limited to, ink jet printing, letterpress printing, screen printing, dip coating, rotary coating, scraper coating, roller printing, torsion roller printing, lithography, flexographic printing, rotary printing, spraying, brush coating, shift printing, or slit extrusion coating. The preferred is gravure printing, a nozzle printing and an inkjet printing. The solution or suspension may additionally include one or more components (such as surface active compounds, lubricants, wetting agents, dispersants, hydrophobic agents, adhesives, and the like) for adjusting viscosity, film forming properties, improving adhesion, and the like.

The present disclosure further provides a use of the above-mentioned metal complex, mixture or composition in organic electronic devices.

The present disclosure further provides an organic electronic device including the above-mentioned metal complex or mixture, or prepared by the composition above.

Further, an organic electronic device includes a functional layer including the above-mentioned metal complex or mixture, or prepared by the above-mentioned composition.

The organic electronic device may be selected from, but not limited to, an organic light emitting diode (OLED), an organic photovoltaic cell (OPV), an organic light emitting cell (OLEEC), an organic field effect transistor (OFET), an organic light emitting field effect transistor, an organic laser, an organic spin electronic device, an organic sensor, an organic plasmon emitting diode, and the like. In some embodiments, the organic electronic device is an electroluminescent device such as an OLED, an OLEEC, an organic light emitting field effect transistor, and the like. In some preferred embodiments, the organic electronic device is an OLED.

In some embodiments, the organic electronic device is an organic electroluminescent device including at least a cathode, an anode, and a light emitting layer. The light emitting layer includes the above-mentioned metal complex or mixture, or is prepared by the above-mentioned composition.

Further, the organic electroluminescent device further includes one or more other functional layers selected from a hole injection layer (HIL), a hole transport layer (HTL), an electron barrier layer (EBL), an electron injection layer (EIL), an electron transport layer (ETL), and a hole barrier layer (HBL). Materials suitable for the use in these functional layers are described in detail above and in WO2010135519A1, US20090134784A1 and WO2011110277A1, the entire contents of which are hereby incorporated herein by reference.

The light emitting device, especially the OLED, includes a substrate, an anode, at least a light emitting layer, and a cathode.

In the present disclosure, the substrate may be opaque or transparent. A transparent substrate may be used to manufacture a transparent light emitting component, for example, reffering to Bulovic et al., Nature 1996, 380, p29, and Gu et al., Appl. Phys. Lett. 1996, 68, p2606. The substrate may be rigid or elastic. The substrate may be plastic, metal, semiconductor chip or glass. In some particular embodiments, the substrate has a smooth surface. In the present disclosure, a substrate without surface defects is a particularly ideal choice.

In some embodiments, the substrate is flexible, optional from a polymer film or plastic, preferably having a glass transition temperature Tg above 150 °C. Further, Tg exceeds 200 °C. Furthermore, Tg exceeds 250 °C. In particular, Tg exceeds 300 °C. Examples of suitable flexible substrates include, but not limited to, polyethylene terephthalate (PET), polyethylene glycol PEG-2000 (PEN), and the like.

In the present disclosure, the anode may include a conductive metal, a metal oxide, or a conductive polymer. The anode can easily inject holes into the hole injection layer (HIL), the hole transport layer (HTL), or the light emitting layer.

In some embodiments, the absolute value of the difference between the work function of the anode and the HOMO level or valence band level of the luminous body in the light emitting layer or the p-type semiconductor material as HIL, HTL or the electron blocking layer (EBL) is less than 0.5 eV. Further, the absolute value is less than 0.3 eV. In particular, the absolute value is less than 0.2 eV.

In some embodiments, examples of anode materials include, but not limited to, Al, Cu, Au, Ag, Mg, Fe, Co, Ni, Mn, Pd, Pt, ITO, aluminum doped zinc oxide (AZO), and the like. Other anode materials are known and can be easily selected for use by those ordinary skilled in the art. The anode material may be deposited using any suitable technique such as suitable physical vapor deposition methods including radio frequency magnetron sputtering, vacuum thermal evaporation, electron beam (e-beam), and the like.

In some embodiments, the anode is patterned. The patterned ITO conductive substrates are commercially available and can be used to prepare organic electronic devices of the present disclosure.

In the present disclosure, the cathode may include a conductive metal or metal oxide. The cathode can easily inject electrons into the EIL or ETL or directly into the light emitting layer.

In some embodiments, the absolute value of the difference between the work function of the cathode and the LUMO level or conduction band level of the luminous body or n-type semiconductor material in the light emitting layer as the electron injection layer (EIL), the electron transport layer (ETL), or the hole blocking layer (HBL) is less than 0.5 eV. Further, the absolute value is less than 0.3 eV. In particular, the absolute value is less than 0.2 eV.

In principle, all materials that can be used as cathodes for OLEDs may be used as cathode materials for devices of the present disclosure. Examples of cathode materials include, but not limited to, Al, Au, Ag, Ca, Ba, Mg, LiF/Al, MgAg alloys, $BaF_2$/Al, Cu, Fe, Co, Ni, Mn, Pd, Pt, ITO, and the like. Cathode materials can be deposited using any suitable technique such as suitable physical vapor deposition methods including radio frequency magnetron sputtering, vacuum thermal evaporation, electron beam (e-beam), and the like.

The present disclosure further relates to a use of the electroluminescent device according to the present disclosure in various electronic devices, including, but not limited to, display devices, lighting devices, light sources, sensors, and the like.

The present disclosure will be described below in combination with embodiments, but the present disclosure is not limited to the following embodiments. It should be understood that the appended claims encapsulate the scope of the present disclosure. Those skilled in the art should realize that certain changes made to the embodiments of the present disclosure will be covered by the spirit and scope of the claims of the present disclosure, guided by the inventive

concept.

In which eq represents the molar equivalent. % (w/w) represents the percentage of mass.

### 1.1. Structure and synthetic route of transition metal complexes

Synthesis example 1: organometallic complex (5)

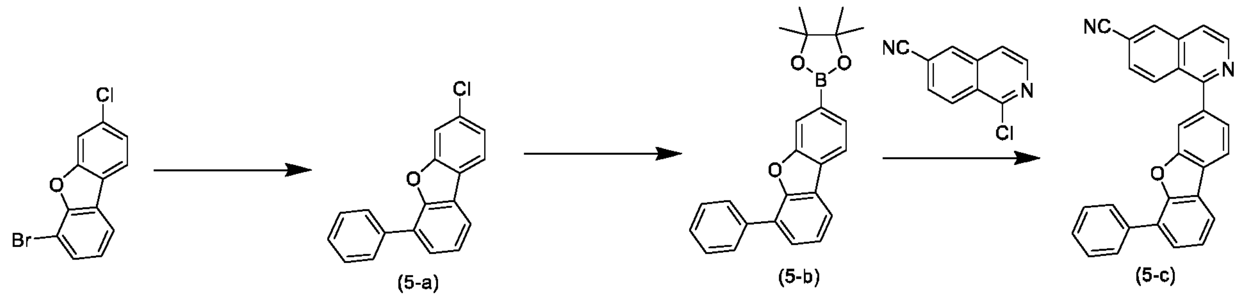

(5-a) (5-b) (5-c)

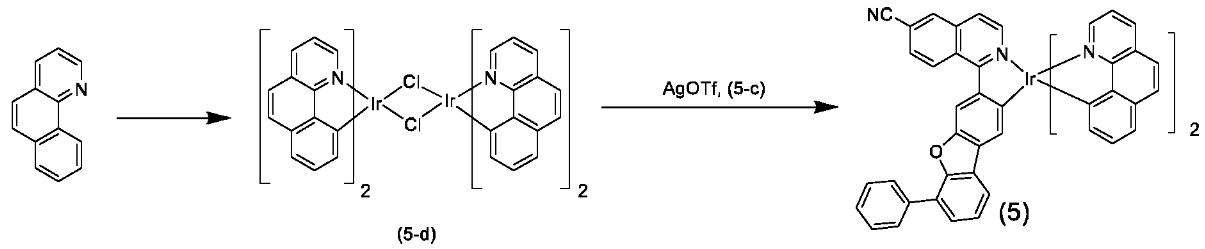


(5-d) (5)

2.1. Synthesis of intermediate **(5-a):**

Phenylboronic acid (1 eq), 3-chloro-6-bromodibenzofuran (1 eq, 200g), Pd $(PPh_3)_4$ (0.05 eq, tetrakis(triphenylphosphine)palladium), and potassium carbonate (4 eq) were placed in a dry double-mouth bottle to obtain a mixture, and then 250 mL of a mixed solution of dioxane and water with a volume ratio of 3: 1 was added into the mixture. The mixture reacted at 90° C while stirring for 12 hours, and then cooled to room temperature. After the reaction was ended, the reaction solution was spin-dried, layered with dichloromethane and water, spin-dried after dried with magnesium sulfate, and then separated and purified with a silica gel column to obtain 138.6 g of a solid intermediate **(5-a).** The yield was 70 %. EI mass spectrometry showed the charge peak m/z = 278.51.

2.2. Synthesis of intermediate **(5-b):**

Bis(pinacolato)diboron (1.5 eq), the intermediate **(5-a)** (leq, 135 g), Pd $(dppf)_2Cl_2$ (0.05 eq), and potassium acetate (4 eq) were placed in a dry double-mouth bottle to obtain a mixture, and then 250 mL of a mixed solution of dioxane and water in a volume ratio of 3: 1was added into the mixture. The mixture reacted at 90° C while stirring for 12 hours, and then cooled to room temperature. After the reaction was ended, the reaction solution was spin-dried, layered with dichloromethane and water, spin-dried after dried with magnesium sulfate, and then separated and purified with a silica gel column. 145.7 g of a solid intermediate **(5-b)** was obtained, the yield was 81%, and EI mass spectrometry showed the charge peak m/z = 370.17.

2.3. Synthesis of intermediate **(5-c):**

Referring to the synthesis method of the compound intermediate **(5-a),** the difference was that phenylboronic acid was changed to the intermediate **(5-b)** (1 eq, 140 g), and 3-chloro-6-bromodibenzofuran was changed to 1-chloroisoquinoline-6-carbonitrile. 101.9 g of a solid intermediate **(5-c)** was obtained, the yield was 68%, and EI mass spectrometry showed the charge peak m/z = 396.13.

2.4. Synthesis of intermediate **(5-d):**

7, 8-benzoquinoline (4.4 eq, 50 g) and iridium trichloride trihydrate (2 eq) were placed in a dry 250 mL bottle.

The bottle was evacuated and filled with nitrogen, and the cycle was repeated three times. Then a mixed solution of ethyl glycol: water (120 mL) in a volume ratio of 3: 1 was added into the mixture. The mixture reacted at 90° C while stirring for 12 hours, then water (1000 mL) was added into the reaction solution, and the solid was filtered to obtain 25.1 g of a reddish-brown intermediate **(5-d)** , the yield was 34%. EI mass spectrometry showed the charge peak m/z = 1163.13.

2.5. Synthesis of organometallic complex **(5).**

The intermediate **(5-d)** (1 eq, 20 g) was placed in a dry 250 mL bottle, and dissolved in a mixed solution of 300 mL dichloromethane and 100 mL methanol to obtain a mixture, and then silver trifluoromethane sulfonate (3 eq) was added into the mixture. After the mixture reacted for 12 hours at room temperature, the solid was filtered off, and the filtrate was spin-dried in vacuum to obtain a red solid. The red solid was placed in a dry 250 mL bottle, the intermediate **(5-c)** (1 eq) and sodium carbonate (5 eq) were added into the bottle, and then diethanol ether (60 mL) and water (20 mL) were added into the bottle as a solvent. After nitrogen was purged, the mixture reacted at 60°C for 6 hours. A large amount of water (1000 mL) was added into the bottle, the precipitated red solid was filtered and obtained, and then was washed with water and methanol. After the obtained solid was dried, the obtained solid was separated and purified with silica gel chromatographic column. After recrystallizing, 8.1 g of a deep red solid metal complexe **(5)** was obtained, the yield was 25%. EI mass spectrometry showed the charge peak m/z = 944.21.

**Example 3. Synthesis of organometallic complex (7):**

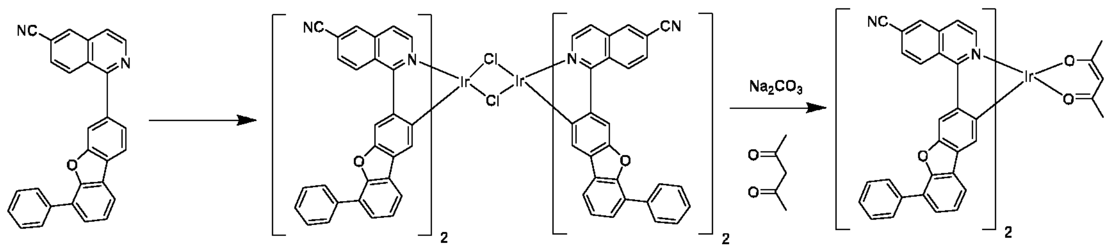


(5-c) (7-a) (7)

.

3.1. Synthesis of intermediate **(7-a):**

Referring to the synthesis method of the compound intermediate **(5-d),** the difference was that 7, 8-benzoquinoline was changed to the intermediate **(5-c)** (4.4 eq, 50 g). 17.5 g of a reddish-brown intermediate **(7-a)** was obtained, the yield was 30%, and EI mass spectrometry showed charge peak m/z = 2036.34.

3.2. Synthesis of organometallic complex **(7):**

The intermediate (7-a) (1 eq, 15 g) was placed in a dry 250 mL bottle, sodium carbonate (5 eq) and acetylacetone (3 eq) was added into the bottle to obtain a mixture. The mixture was dissolved in a mixed solution of 300 mL dichloromethane and 100 mL methanol, and the mixture reacted at room temperature for 24 hours. The solution was evaporated in vacuum, and extracted with water and dichloromethane to obtain the organic layer, then the organic layer was evaporated in vacuum to obtain a red solid. After drying, the red solid was separated and purified with silica gel chromatographic column. After recrystallizing, 7.3 g of a deep red solid metal complex (7) was obtained, and the yield was 46%. EI mass spectrometry showed charge peak m/z= 1082.24.

**Example 4. Synthesis of organometallic complex (17):**

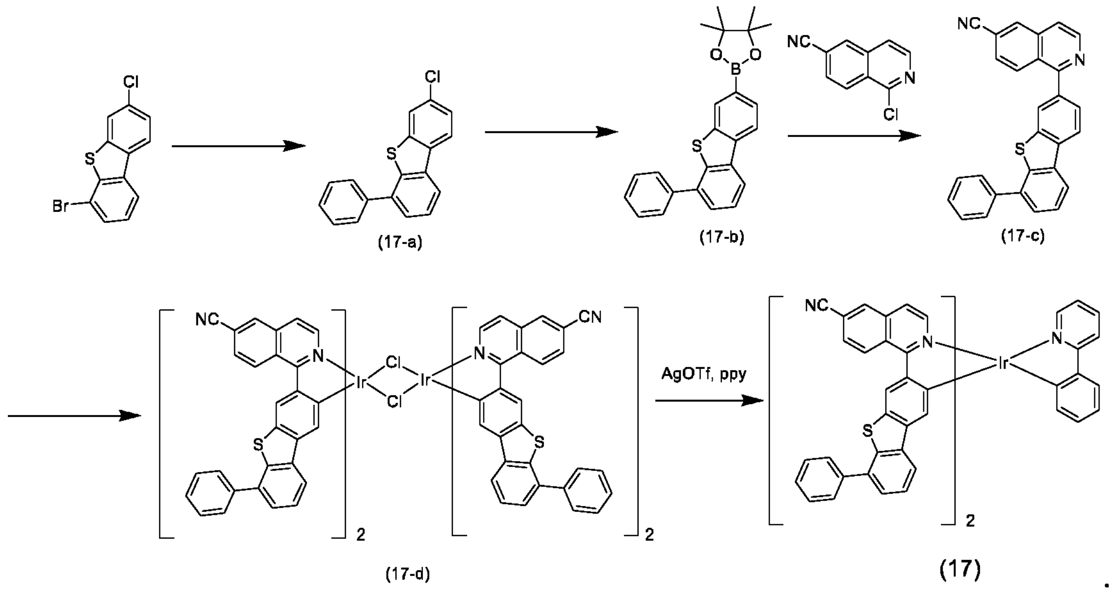


(17-a) (17-b) (17-c)

(17-d) (17)

4.1. Synthesis of intermediate **(17-a):**

Referring to the synthesis method of compound intermediate **(5-a),** the difference was that 3-chloro-6-bromodibenzofuran was changed to 3-chloro-6-bromodibenzothiophene (leq, 200 g). 109.3 g of a solid intermediate **(17-a)** was obtained, and the yield was 55%. EI mass spectrometry showed the charge peak m/z = 294.03.

4.2. Synthesis of intermediate **(17-b):**

Referring to the synthesis method of compound intermediate **(5-b),** the difference was that the intermediate**(5-a)** was changed to intermediate **(17-a)** (leq, 100 g). 94.8 g of a solid intermediate **(17-b)** was obtained, the yield was 72%, and EI mass spectrometry showed the charge peak m/z = 386.15.

4.3. Synthesis of intermediate **(17-c):**

Referring to the synthesis method of compound intermediate **(5-a),** the difference was that phenylboronic acid was changed to intermediate **(17-b)** (leq, 100 g), and 3-chloro-6-bromodibenzofuran was changed to 1-chloroisoquinoline-6-carbonitrile. 64.9 g of a solid intermediate (17-c) was obtained, the yield was 58%, and EI mass spectrometry showed the charge peak m/z = 412.10.

4.4. Synthesis of intermediate **(17-d):**

Referring to the synthesis method of compound intermediate **(5-d),** the difference was that 7, 8-benzoquinoline was changed to an intermediate **(17-c)** (4.4 eq, 60 g). 19.5 g of a reddish-brown intermediate **(17-d)** was obtained, the yield was 28%, and EI mass spectrometry showed the charge peak m/z= 2100.25.

4.5. Synthesis of organometallic complex **(17):**

Referring to the synthesis method of organometallic complex **(5),** the difference was that the intermediate **(5-d)** was changed to intermediate **(17-d)** (leq, 18 g), and intermediate **(5-c)** was changed to 2-phenylpyridine. 10 g of a crimson metal complex **(17)** was obtained, the yield was 50%, and EI mass spectrometry showed the charge peak m/z = 1169.22.

**Example 5. Synthesis of organometallic complex (54):**

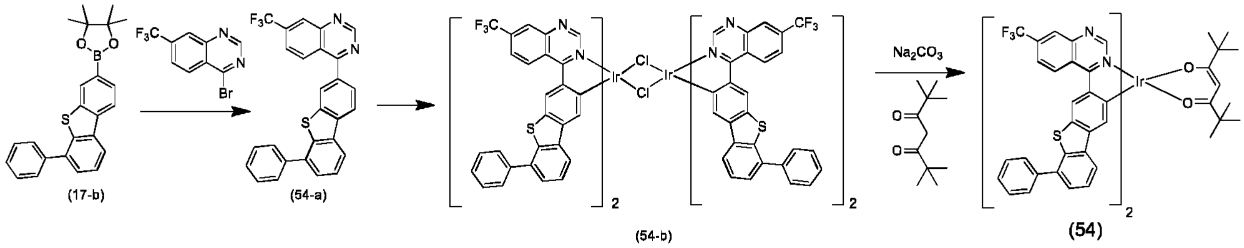


(17-b) (54-a) (54-b) (54)

.

5.1. Synthesis of intermediate **(54-a):**

Referring to the synthesis method of compound intermediate **(5-a),** the difference was that phenylboronic acid was changed to intermediate **(17-b)** (leq, 100 g), and 3-chloro-6-bromodibenzofuran was changed to 4-bromo-7-trifluoromethyl quinazoline. 55.5 g of solid intermediate **(54-a)** was obtained, and the yield was 47%. EI mass spectrometry showed the charge peak m/z = 456.09.

5.2. Synthesis of intermediate **(54-b):**

Referring to the synthesis method of compound intermediate **(5-d),** the difference was that 7, 8-benzoquinoline was changed to the intermediate **(54-a)** (4.4 eq, 50 g). 14.7 g of a reddish-brown intermediate **(54-b)** was obtained, and the yield was 26%. EI mass spectrometry showed a charge peak m/z = 2276.20.

5.3. Synthesis of organometallic complexe **(54):**

Referring to the synthesis method of metal complex **(7),** the difference was that the intermediate(**7-a)** was changed to intermediate **(54-b)** (leq, 14 g), and acetylacetone was changed to 2, 2, 6, 6-tetramethyl-3, 5-heptadione. 6.6 g of a crimson metal complex **(54)** was obtained, and the yield was 42%. EI mass spectrometry showed a charge peak m/z = 1286.27.

**Example 6. Synthesis of organometallic complex (79):**

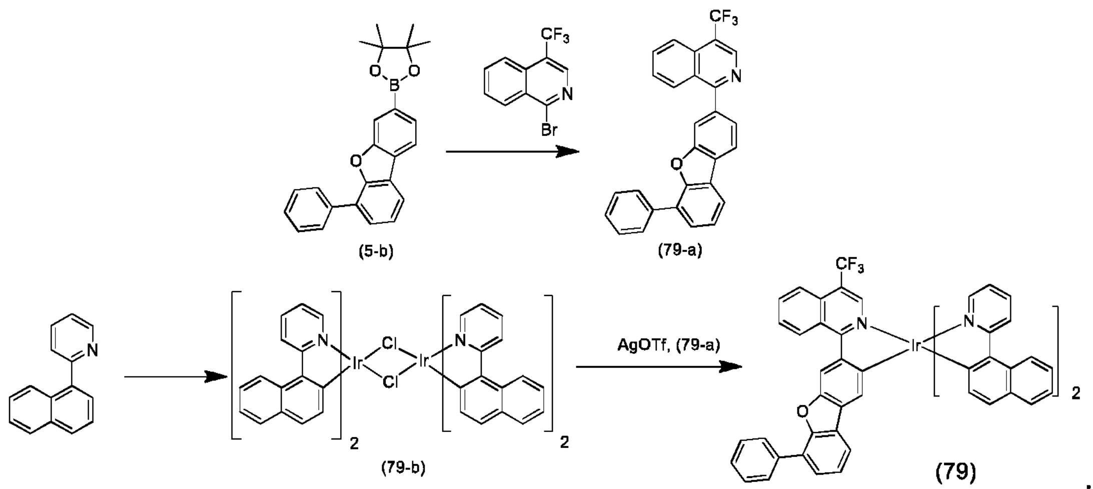


(5-b) (79-a) (79-b) (79)

.

6.1. Synthesis of intermediate **(79-a):**

Referring to the synthesis method of compound intermediate **(5-a),** the difference was that phenylboronic acid was changed to intermediate **(5-b)** (leq, 100 g), and 3-chloro-6-bromodibenzofuran was changed to 1-bromo-4-trifluoromethyl isoquinoline. 81.8 g of a solid intermediate **(79-a)** was obtained, and the yield was 69%. EI mass spectrometry showed the charge peak m/z = 439.12.

6.2. Synthesis of intermediate **(79-b):**

Referring to the synthesis method of compound intermediate **(5-d),** the difference was that 7, 8-benzoquinoline was changed to 2-(naphthalen-1-yl) pyridine (4.4 eq, 50 g). 14.8 g of yellow intermediate **(79-b)** was obtained, the yield was 45%, and the EI mass spectrum showed the charge peak m/z = 1272.19.

6.3. Synthesis of organometallic complexe **(79):**

Referring to the synthesis method of metal complex **(5),** the difference was that the intermediate**(5-d)** was changed to intermediate **(79-b)** (leq, 14 g), and intermediate **(5-c)** was changed to intermediate **(79-a).** 8.69 g of a crimson metal complex **(79)** was obtained, the yield was 38%. EI mass spectrometry showed a charge peak m/z = 1039.24.

**Example 7. Synthesis of organometallic complex (113):**

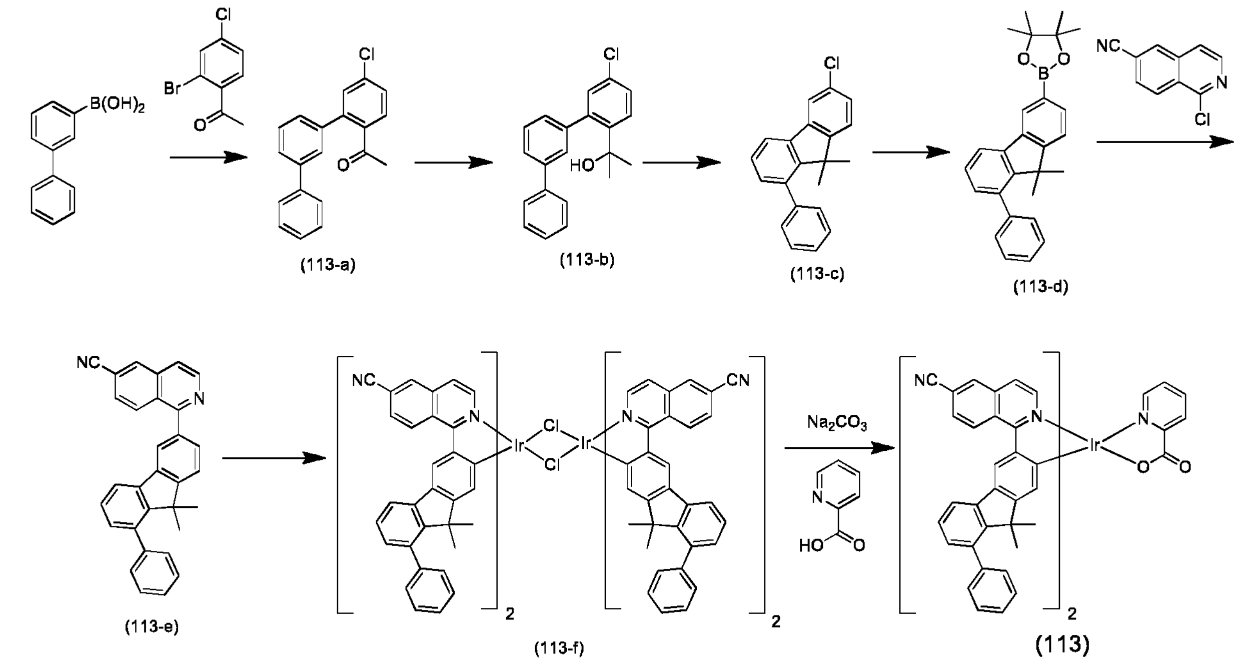

(113-a) (113-b) (113-c) (113-d)

(113-e) (113-f) (113)

7.1. Synthesis of intermediate **(113-a):**

Referring to the synthesis method of compound intermediate **(5-a),** the difference was that phenylboronic acid was changed to 3-biphenylboronic acid (leq, 200 g), and 3-chloro-6-bromodibenzofuran was changed to 3-bromo-4-chlorobenzophenone. 182.3 g of a solid intermediate **(113-a)** of was obtained, the yield was 59%, and EI mass spectrometry showed the charge peak m/z= 306.08.

7.2. Synthesis of intermediate **(113-b):**

The intermediate **(113-a)** (1 eq, 150 g) was placed in a dry double-mouth bottle, and 500 mL anhydrous tetrahydrofuran was added to dissolve theintermediate **(113-a),** and then magnesium methyl (2.1 eq) was added into the bottle. The mixture reacted at 50 °C while stirring for 12 hours. The reaction solution was cooled to room temperature and spin-dried after the reaction was ended. The reaction solution was layered with dichloromethane and water, dried with magnesium sulfate, and then spin-dried. The obtained mixture was separated and purified with silica gel chromatographic column to obtain 72.6 g of the solid intermediate **(113-b),** the yield was 46%, EI mass spectrometry showed the charge peak m/z = 322.11.

7.3. Synthesis of intermediate **(113-c):**

a dry 250ml bottle was evacuated and filled with nitrogen, and the cycle was repeated three times. The intermediate **(113-b)** (1 eq, 70 g) was placed in the bottle, glacial acetic acid (50 mL) was added as solvent, then concentrated sulfuric acid (10 eq) was slowly dripped and heated to 80 °C, and the mixture reacted for 2 hours. After the reaction ended, 1 L of ice water was poured in the bottle, the precipitated solid was filtered, and then washed with water and methanol for three times to obtain 47.6 g of a white solid intermediate **(113-c),** the yield was 72%. EI mass spectrometry showed charge peak m/z = 304.10.

7.4. Synthesis of intermediate **(113-d):**

Referring to the synthesis method of compound intermediate **(5-b),** the difference was that the intermediate **(5-a)** was changed to intermediate **(113-c)** (1 eq, 45 g). 41.0 g of a solid intermediate **(113-d)** was obtained, the yield was 70%, and EI mass spectrometry showed the charge peak m/z = 396.23.

7.5. Synthesis of intermediate **(113-e):**

Referring to the synthesis method of compound intermediate **(5-a),** the difference was that phenylboronic acid was changed to intermediate **(113-d)** (1 eq, 40 g), and 3-chloro-6-bromodibenzofuran was changed to 1-chloroisoquinoline-6-carbonitrile. 26 g of solid intermediate **(113-e)** was obtained, the yield was 61%, and EI mass spectrometry showed charge peak m/z = 422.18.

7.6. Synthesis intermediate **(113-f):**

Referring to the synthesis method of compound intermediate**(5-d)**, the difference was that 7, 8-benzoquinoline was changed to an intermediate **(113-e)** (4.4 eq, 26 g). 9.9 g of a reddish brown intermediate **(113-f)** was obtained, the yield was 33%. EI mass spectrometry showed charge peak m/z = 2140.55.

7.7. Synthesis of organometallic complex **(113):**

Referring to the synthesis method of metal complex **(7),** the difference was that the intermediate **(7-a)** was changed to intermediate **(113-f)** (1 eq, 9.9 g), and acetylacetone was changed to 2-pyridinecarboxylic acid. 6.5 g of a crimson metal complex **(113)** was obtained, the yield was 61%, and EI mass spectrometry showed the charge peak m/z = 1157.34.

**Synthesis Example 8 Synthesis of organometallic complex (133):**

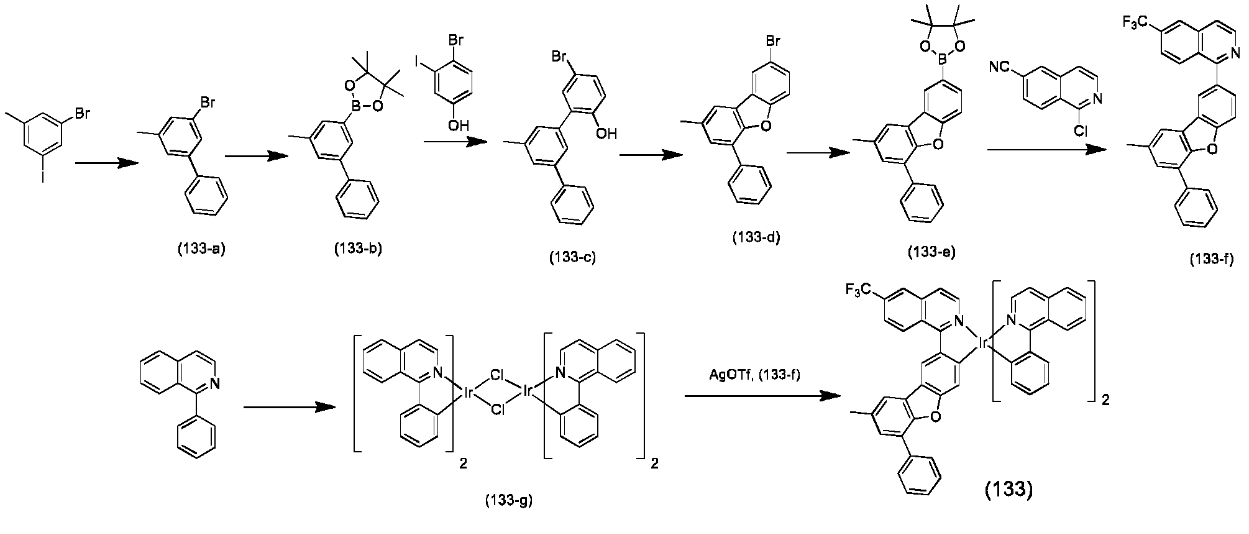


(133-a) (133-b) (133-c) (133-d) (133-e) (133-f)

(133-g) (133)

8.1. Synthesis of intermediate **(133-a):**

Referring to the synthesis method of compound intermediate**(5-a),** the difference was that 3-chloro-6-bromodibenzofuran was changed to 3-bromo-5-iodotoluene (leq, 200 g). 129.7 g of a solid intermediate **(133-a)** was obtained, and the yield was 78%. EI mass spectrometry showed the charge peak m/z = 246.00.

8.2. Synthesis of intermediate **(133-b):**

Referring to the synthesis method of compound intermediate**(5-b)**, the difference was that the intermediate**(5-a)** was changed to intermediate**(133-a)** (leq, 129.7 g). 116.3 g of a solid intermediate **(133-b)** was obtained, the yield was 75%, and EI mass spectrometry showed the charge peak m/z = 294.18.

8.3. Synthesis of intermediate **(133-c):**

Referring to the synthesis method of compound intermediate **(5-a),** the difference was that phenylboronic acid was changed to intermediate**(133-b)** (leq, 115 g), and 3-chloro-6-bromodibenzofuran was changed to 3-bromo-4-iodophenol. 87.2 g of a solid intermediate (133-c) was obtained, the yield was 66%, and EI mass spectrometry showed the charge peak m/z = 338.03.

8.4. Synthesis of intermediate **(133-d):**

Referring to the synthesis method of compound intermediate **(113-c),** the difference was that the intermediate **(113-b)** was changed to intermediate **(133-c)** (leq, 85 g). 61.7 g of a solid intermediate **(133-d)** was obtained, the yield was 73%, and EI mass spectrometry showed the charge peak m/z = 336.01.

8.5. Synthesis of intermediates **(133-e):**

Referring to the synthesis method of compound intermediate **(5-b),** the difference was that the intermediate **(5-a)** was changed to intermediate **(133-d)** (leq, 60 g). 46.0 g of a solid intermediate **(133-e)** was obtained, the yield was 69%, and EI mass spectrometry showed charge peak m/z = 384.19.

8.6. Synthesis of intermediates**(133-f)**:

Referring to the synthesis method of compound intermediate **(5-a),** the difference was that phenylboronic acid was changed to intermediate **(133-e)** (leq, 45 g), and 3-chloro-6-bromodibenzofuran was changed to 1-chloroisoquinoline-6-carbonitrile. 35.5 g of a solid intermediate **(133-f)** was obtained, the yield was 67%. and EI mass spectrometry showed charge peak m/z = 453.13.

8.7. Synthesis of intermediates **(133-g):**

Referring to the synthesis method of compound intermediate **(5-d),** the difference was that 7, 8-benzoquinoline was changed to 1-phenylisoquinoline (4.4 eq, 50 g). 31.0 g of a reddish-brown intermediate **(133-g)** was obtained, and the yield was 44%. EI mass spectrometry showed charge peak m/z = 1272.20.

8.8. Synthesis of organometallic complex **(133):**

Referring to the synthesis method of metal complex **(5),** the difference was that the intermediate **(5-d)** was changed to intermediate **(133-g)** (leq, 10 g), and intermediate**(5-c)** was changed to intermediate **(133-f).** 6.79 g of a crimson metal complex **(133)** was obtained, the yield was 41%, and EI mass spectrometry showed the charge peak m/z = 1053.26.

**Example 9. Synthesis of organometallic complex (146):**

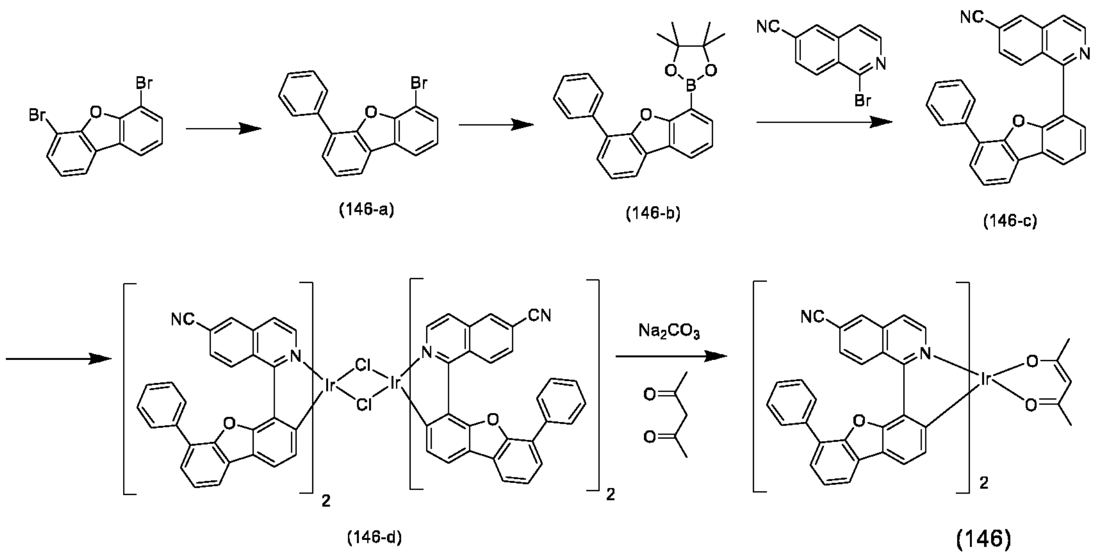


(146-a) (146-b) (146-c) (146-d) (146)

9.1. Synthesis of intermediate **(146-a):**

Referring to the synthesis method of compound intermediate **(5-a),** the difference was that 3-chloro-6-bromodibenzofuran was changed to 4, 6-dibromodibenzofuran (leq, 200 g). 139.2 g of a solid intermediate **(146-a)** was obtained, and the yield was 70%. EI mass spectrometry showed the charge peak m/z = 322.00.

9.2. Synthesis of intermediate **(146-b):**

Referring to the synthesis method of compound intermediate(5-b), the difference was that the intermediate**(5-a)** was changed to intermediate**(146-a)** (leq, 139 g). 115.1 g of a solid intermediate **(146-b)** was obtained, the yield was 72%, and EI mass spectrometry showed the charge peak m/z = 370.17.

9.3. Synthesis of intermediate **(146-c):**

Referring to the synthesis method of compound intermediate**(5-a)**, the difference was that phenylboronic acid was changed to intermediate**(146-b) (**leq, 115 g), and 3-chloro-6-bromodibenzofuran was changed to 1-chloroisoquinoline-6-carbonitrile. 84.9 g of a solid intermediate (146-c) was obtained, the yield was 69%, and EI mass spectrometry showed the charge peak m/z = 396.13.

9.4. Synthesis of intermediate **(146-d):**

Referring to the synthesis method of compound intermediate**(5-d)**, the difference was that 7, 8-benzoquinoline was changed to an intermediate **(146-c) (**4.4 eq, 80 g). 37.4 g of a reddish-brown intermediate **(146-d)** was obtained, and the yield was 40%. EI mass spectrometry showed the charge peak m/z = 2036.35.

9.5. Synthesis of organometallic complex **(146):**

Referring to the synthesis method of metal complex **(7),** the difference was that the intermediate**(7-a)** was changed to intermediate **(146-d)** (leq, 30 g). 12.4 g of a crimson metal complex **(146)** was obtained, the yield was 39%, and EI mass spectrometry showed the charge peak m/z = 1082.25.

**Example 10. Synthesis of organometallic complex (158):**

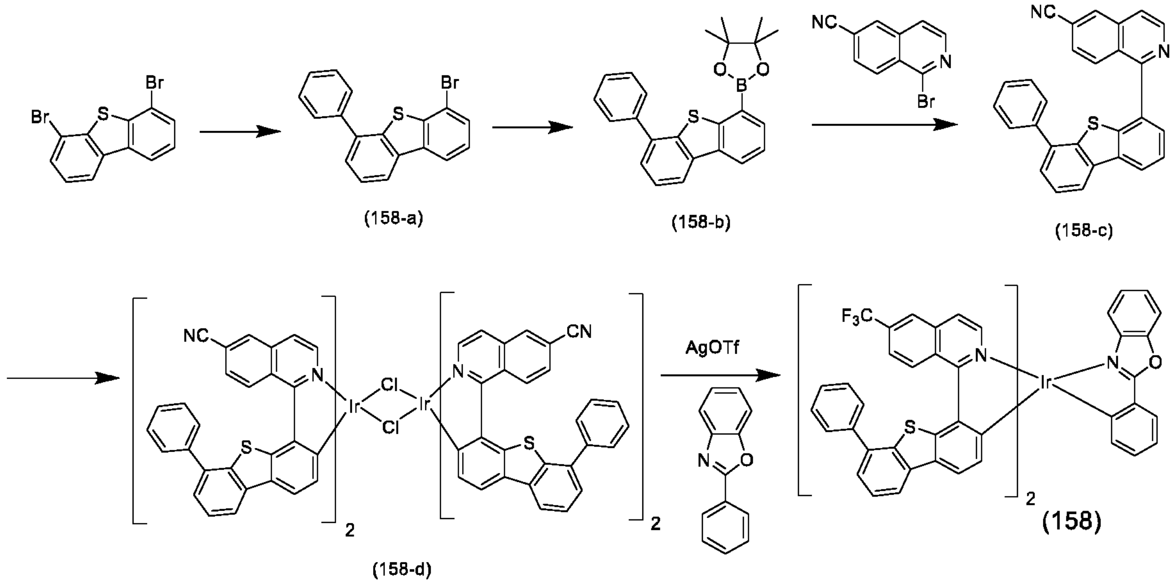


(158-a) (158-b) (158-c)

(158-d) (158)

10.1. Synthesis of intermediate **(158-a):**

Referring to the synthesis method of compound intermediate **(5-a),** the difference was that 3-chloro-6-bromodibenzofuran was changed to 4, 6-dibromodibenzothiophene (leq, 200 g). 135.2 g of a solid intermediate **(158-a)** was obtained, and the yield was 68%. EI mass spectrometry showed the charge peak m/z = 337.98.

10.2. Synthesis of intermediate **(158-b):**

Referring to the synthesis method of compound intermediate **(5-b),** the difference was that the intermediate **(5-a)** was changed to intermediate**(158-a)** (leq, 130 g). 106.9 g of a solid intermediate **(158-b)** was obtained, the yield was 72%, and EI mass spectrometry showed the charge peak m/z = 386.15.

10.3. Synthesis of intermediate **(158-c):**

Referring to the synthesis method of compound intermediate **(5-a),** the difference was that phenylboronic acid was changed to intermediate **(158-b)** (leq, 105 g), and 3-chloro-6-bromodibenzofuran was changed to 1-chloroisoquinoline-6-carbonitrile. 77.3 g of a solid intermediate (158-c) was obtained, the yield was 69%, and EI mass spectrometry showed the charge peak m/z = 412.10.

10.4. Synthesis of intermediate **(158-d):**

Referring to the synthesis method of compound intermediate **(5-d),** the difference was that 7, 8-benzoquinoline was changed to an intermediate **(158-c)** (4.4 eq, 75 g). 34.7 g of a reddish-brown intermediate **(158-d)** was obtained, and the yield was 40%. EI mass spectrometry shows charge peak m/z = 2100.26.

10.5. Synthesis of organometallic complex **(158):**

Referring to the synthesis method of metal complex **(5),** the difference was that the intermediate **(5-d)** was changed to intermediate**(158-d)** (1eq, 30 g), and intermediate **(5-c)** was changed to 2-phenylbenzoxazole. 9.7 g of a crimson metal complex **(158)** was obtained, the yield was 27%, and EI mass spectrometry showed the charge peak m/z = 1253.21.

**Example 11. Synthesis of organometallic complex (197):**

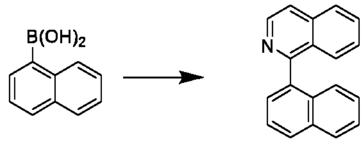

(197-a)

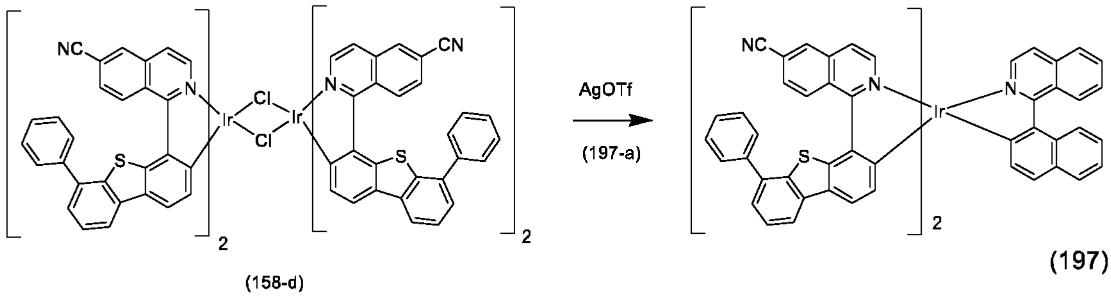


(197)

(158-d)

11.1. Synthesis of intermediate **(197-a):**

Referring to the synthesis method of compound intermediate**(5-a)**, the difference was that phenylboronic acid was changed to 1-naphthalene boronic acid (leq, 50 g), and 3-chloro-6-bromodibenzofuran was changed to 1-bromoisoquinoline. 60.8 g of a solid intermediate **(197-a)** was obtained, and the yield was 82%. EI mass spectrometry showed the charge peak m/z = 255.10.

11.2. Synthesis of organometallic complex **(197):**

Referring to the synthesis method of metal complex (**5),** the difference was that the intermediate **(5-d)** was changed to intermediate**(158-d)** (leq, 30 g), intermediate **(5-c)** was changed to intermediate **(197-a).** 16.7 g of a crimson metal complex **(197)** was obtained, the yield was 46%, and EI mass spectrometry showed the charge peak m/z = 1269.26.

**Example 12. Synthesis of organometallic complex (209):**

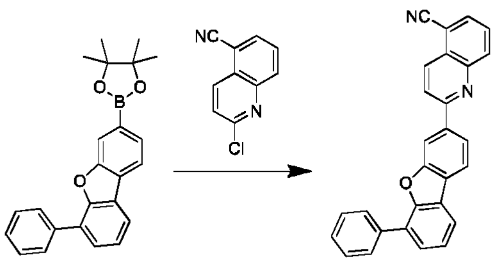

(5-b) (209-a)

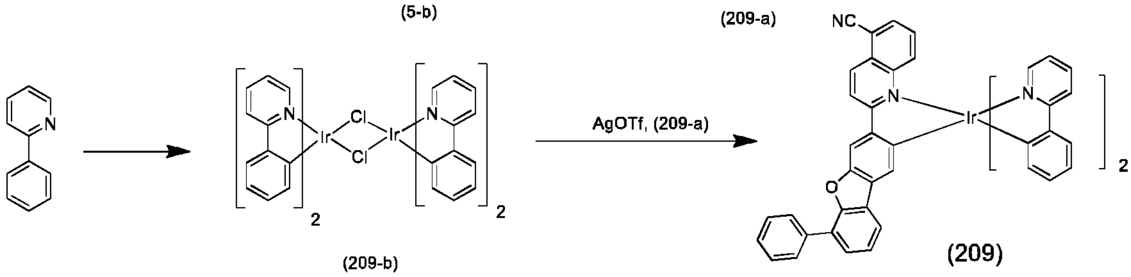


(209-b) (209)

12.1 Synthesis of intermediate **(209-a):**

Referring to the synthesis method of compound intermediate**(5-a)**, the difference was that phenylboronic acid was changed to intermediate**(5-b)** (1eq, 200 g), and 3-chloro-6-bromodibenzofuran was changed to 2-chloro-5-cyanoquinoline. 167.0 g of a solid intermediate **(209-a)** was obtained, and the yield was 78%. EI mass spectrometry showed the charge peak m/z = 396.13.

12.2. Synthesis of intermediate **(209-b):**

Referring to the synthesis method of compound intermediate**(5-d)**, the difference was that 7, 8-benzoquinoline was changed to 2-phenylpyridine (4.4 eq, 30 g). 41.0 g of a yellow intermediate **(209-b)** was obtained, the yield was 87%, and the EI mass spectrum showed the charge peak m/z = 1072.14.

12.3 Synthesis of Organometallic Complexe **(209):**

Referring to the synthesis method of metal complex **(5),** the difference was that the intermediate **(5-d) was** changed to intermediate **(209-b) (**1eq, 15 g), and the intermediate**(5-c)** was changed to intermediate **(209-a).** 10.3 g of a crimson metal complex **(209)** was obtained, the yield was 41%, and EI mass spectrometry showed the charge peak m/z = 896.22.

**Example 13. Synthesis of organometallic complex (240):**

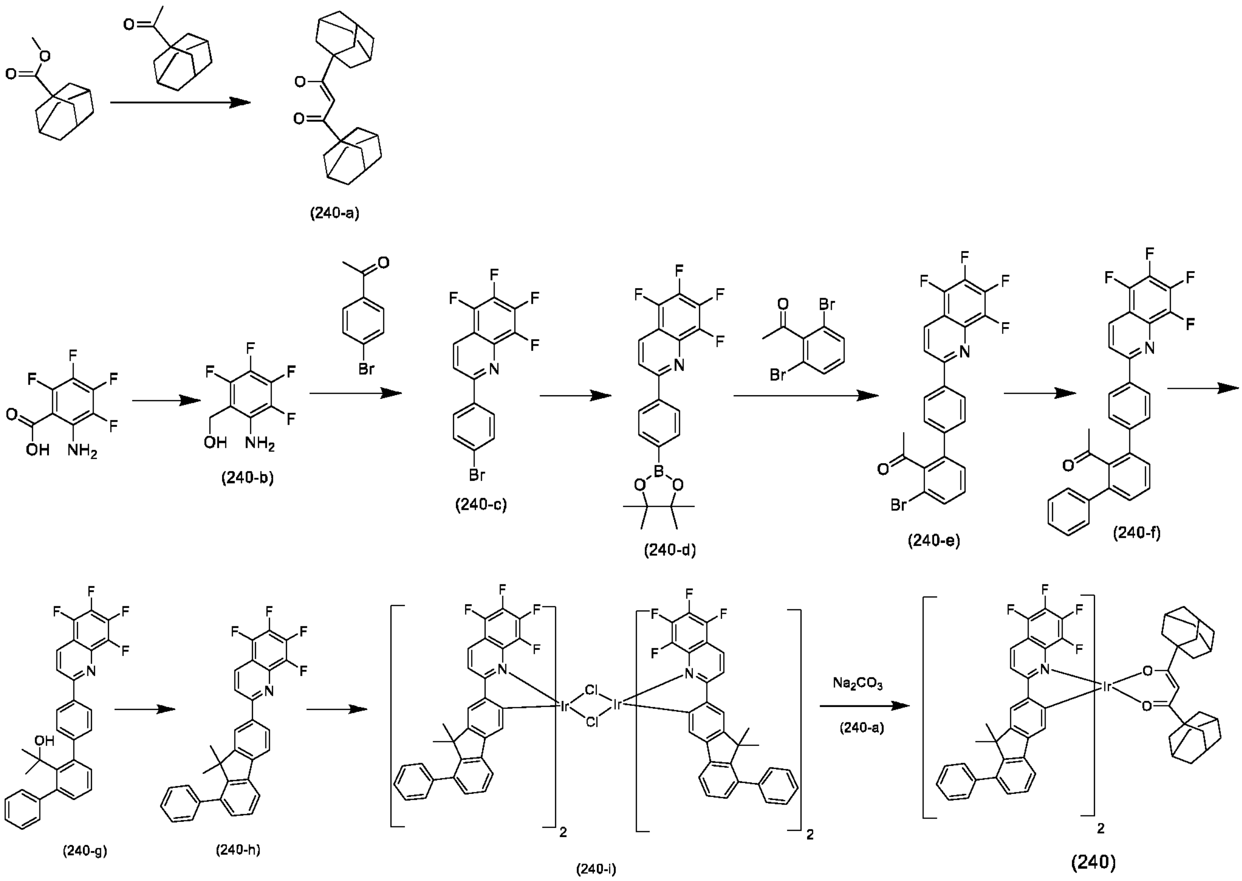


(240-a) (240-b) (240-c) (240-d) (240-e) (240-f) (240-g) (240-h) (240-i) (240)

13.1. Synthesis of intermediate **(240-a):**

a dry 250 mL bottle was evacuated and filled with nitrogen, and the cycle was repeated three times. Sodium hydrogen (10 eq) was placed in the bottle, then 1-adamantaneate (1 eq, 50 g) was added into the bottle. After the mixture was stirred at room temperature for 40 minutes, 1-adamantaneone (1 eq) was slowly added, and heated to 60°C. The mixture reacted for 4 hours, then ice water (1000 mL) was slowly added to quench the remaining sodium hydrogen, then the mixture was extracted with dichloromethane, and concentraed to obtain the reddish-brown liquid, and the liquid was distillied to obtain 48.1 g of a transparent liquid intermediate **(240-a),** and the yield was 55%. EI mass spectrometry

showed charge peak m/z = 339.23.

13.2. Synthesis of intermediate **(240-b):**

2, 3, 4, 5-tetrafluoro-6-aminobenzoic acid (1 eq, 500 g) was added to a dry 250 mL bottle, the bottle was evacuated and filled with nitrogen, and the cycle was repeated three times. Anhydrous tetrahydrofuran (100 Ml) was added in the bottle, then tetrahydrofuran solution of lithium aluminum tetrahydrate (1.5 eq) was slowly dripped at 0°C, and was stirred at room temperature for 4 hours. Ice water (1000 mL) was slowly added to quench the remaining lithium aluminum tetrahydrate, and the mixture was extracted with dichloromethane. The dichloromethane was rotary evaporated. After drying, 284.6 g of a solid intermediate**(240-b)** was obtained, and the yield was 61%. EI mass spectrometry showed charge peak m/z = 195.03.

13.3. Synthesis of intermediate **(240-c):**

P-bromoacetophenone (1.1 eq), intermediate **(240-b)** (1 eq, 280 g), $RuCl_2(PPh_3)_3$ (0.01 eq), and potassium hydroxide (2 eq) were placed in a dry 250 mL bottle, then the bottle was evacuated and filled with nitrogen, and the cycle was repeated three times. Anhydrous toluene (100 mL) was added in thr bottle, and then the the mixture reacted at 120 °C while stirring for 24 hours. After the reaction solution was spin-dried, dichloromethane was added for extraction, and the obtained solution was concentrated, and then purified by column at the ratio of petroleum ether to ethyl acetate of 12: 1 to obtain 407.7 g of a light white intermediate **(240-c),** and the yield was 80%. EI mass spectrometry showed charge peak m/z = 354.96.

13.4. Synthesis of intermediate **(240-d):**

Referring to the synthesis method of compound intermediate **(5-b),** the difference was that the intermediate **(5-a)** was changed to intermediate **(240-c) (**1 eq, 400 g). 308.9 g of a solid intermediate **(240-d)** was obtained, the yield was 68%, and EI mass spectrometry showed the charge peak m/z = 403.14.

13.5. Synthesis of intermediate **(240-e):**

Referring to the synthesis method of compound intermediate **(5-a),** the difference was that phenylboronic acid was changed to intermediate **(240-d)** (1 eq, 300 g), and 3-chloro-6-bromodibenzofuran was changed to 2, 6-dibromoacetophenone. 123.2 g of a solid intermediate **(240-e)** was obtained, the yield was 35%, and EI mass spectrometry showed charge peak m/z = 473.00.

13.6. Synthesis of intermediate **(240-f):**

Referring to the synthesis method of compound intermediate**(5-a)**, the difference was that 3-chloro-6-bromodibenzofuran was changed to an intermediate **(240-e) (**1 eq, 123 g). 96.8 g of a solid intermediate **(240-f)** was obtained, and the yield was 79%. EI mass spectrometry showed charge peak m/z = 471.12.

13.7 Synthesis of intermediate **(240-g):**

Referring to the synthesis method of compound intermediate**(113-b)**, the difference was that the intermediate**(113-a)** was changed to intermediate**(240-f) (**1 eq, 96.8 g). 80.1 g of a solid intermediate **(240-g)** was obtained, the yield was 80%, and EI mass spectrum showed the charge peak m/z = 487.16.

13.8. Synthesis of intermediates **(240-h):**

Referring to the synthesis method of compound intermediate **(113-c),** the difference was that the intermediate **(113-b)** was changed to intermediate **(240-g)** (1 eq, 80 g). 27.7 g of a solid intermediate **(240-h)** was obtained, the yield was 36%. EI mass spectrometry showed charge peak m/z = 469.15.

13.9. Synthesis of intermediate **(240-i):**

Referring to the synthesis method of compound intermediate**(5-d)**, the difference was that 7, 8-benzoquinoline was changed to an intermediate**(240-h)** (4.4 eq, 27.7 g). 5.3 g of a yellow intermediate **(240-i)** was obtained, the yield was 17%, and the EI mass spectrum showed the charge peak m/z = 2328.43.

13.10. Synthesis of organometallic complex **(240):**

Referring to the synthesis method of metal complex **(7),** the difference was that the intermediate **(7-a)** was changed to intermediate **(240-i)** (1 eq, 5.3 g), and acetylacetone was changed to the intermediate **(240-a).** 2.1 g of a crimson metal complex **(240)** was obtained, and the yield was 31%. EI mass spectrometry showed a charge peak m/z = 1468.48.

**Example 14. Synthesis of organometallic complex (268):**

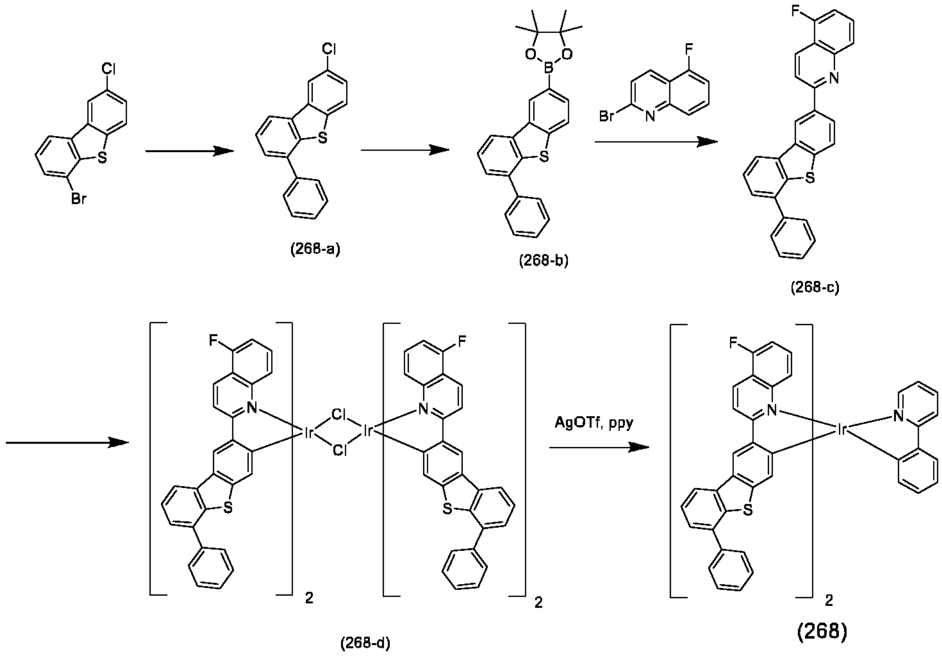


(268-a) (268-b) (268-c)

(268-d) (268)

14.1. Synthesis of intermediate **(268-a):**

Referring to the synthesis method of compound intermediate**(5-a)**, the difference was that 3-chloro-6-bromodibenzofuran was changed to 2-chloro-6-bromodibenzothiophene (1 eq, 200 g). 149.0 g of a solid intermediate **(268-a)** was obtained, and the yield was 75%. EI mass spectrometry showed the charge peak m/z = 294.03.

14.2. Synthesis of intermediate **(268-b):**

Referring to the synthesis method of compound intermediate**(5-b),** the difference was that the intermediate**(5-a)** was changed to intermediate**(268-a)** (1 eq, 149 g). 150.7 g of a solid intermediate **(268-b)** was obtained, the yield was 77%, and EI mass spectrometry showed the charge peak m/z = 386.15.

14.3. Synthesis of intermediate **(268-c):**

Referring to the synthesis method of compound intermediate **(5-a),** the difference was that phenylboronic acid was changed to intermediate **(268-b)** (1 eq, 150 g), and 3-chloro-6-bromodibenzofuran was changed to 2-bromo-5-fluoroquinoline. 72.4 g of a solid intermediate (268-c) was obtained, the yield was 46%, and EI mass spectrometry showed the charge peak m/z = 405.10.

14.4. Synthesis of intermediate **(268-d):**

Referring to the synthesis method of compound intermediate**(5-d)**, the difference was that 7, 8-benzoquinoline was changed to an intermediate**(268-c)** (4.4 eq, 70 g). 26.9 g of a reddish-brown intermediate **(268-d)** was obtained, the yield was 33%, and EI mass spectrometry shows charge peak m/z = 2072.24.

14.5. Synthesis of organometallic complex **(268):**

Referring to the synthesis method of metal complex (5), the difference was that the intermediate **(5-d)** was changed to intermediate **(268-d)** (1 eq, 20 g), and the intermediate **(5-c)** was changed to 2-phenylpyridine. 13.2 g of a crimson metal complex **(268)** was obtained, and the yield was 59%. EI mass spectrometry showed a charge peak m/z = 1155.22.

**Example 15. Synthesis of organometallic complex (293):**

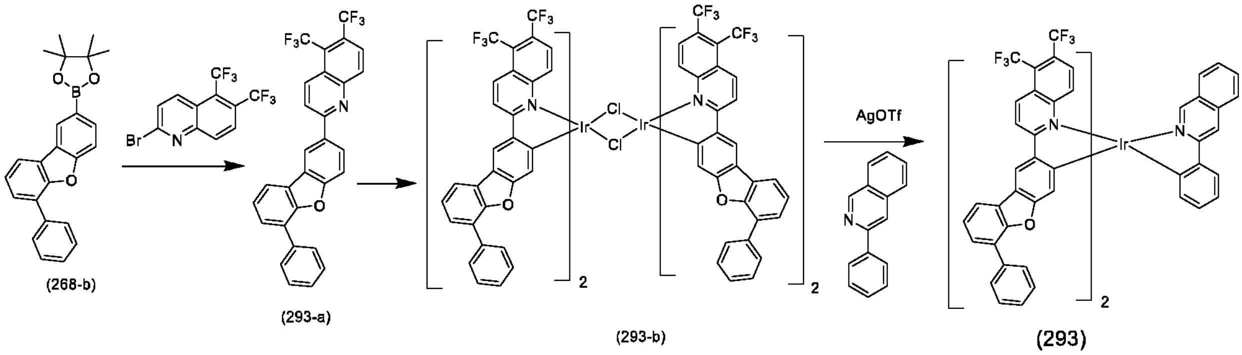


(268-b) (293-a) (293-b) (293)

15.1. Synthesis of intermediate **(293-a):**

Referring to the synthesis method of compound intermediate **(5-a),** the difference was that phenylboronic acid was changed to intermediate **(268-b)** (1 eq, 150 g), and 3-chloro-6-bromodibenzofuran was changed to 2-bromo-5, 6-bis(trifluoromethyl)quinoline. 68.9 g of a solid intermediate **(293-a)** was obtained the yield was 35%. EI mass spectrometry showed the charge peak m/z = 507.11.

15.2. Synthesis of intermediate **(293-b):**

Referring to the synthesis method of compound intermediate **(5-d),** the difference was that 7, 8-benzoquinoline was changed to the intermediate **(293-a)** (4.4 eq, 68.9 g). 34.5 g of a reddish-brown intermediate**(293-b)** was obtained, and the yield was 45%. EI mass spectrometry showed a charge peak m/z = 2480.27.

15.3. Synthesis of organometallic complex **(293):**

Referring to the synthesis method of metal complex **(5),** the difference was that the intermediate **(5-d)** was changed to intermediate **(293-b)** (1 eq, 30 g), and the intermediate **(5-c)** was changed to 3-phenylisoquinoline. 11.6 g of a crimson metal complex **(293)** was obtained, and the yield was 34%. EI mass spectrometry showed a charge peak m/z = 1409.25.

**Example 16. Synthesis of organometallic complex (327):**

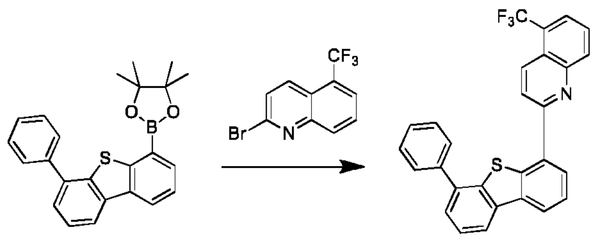

(158-b) (327-a)

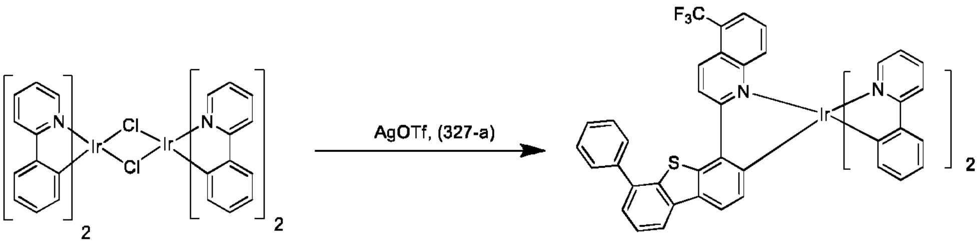


(209-b) **(327)**

16.1. Synthesis of intermediate **(327-a):**

Referring to the synthesis method of compound intermediate **(5-a),** the difference was that phenylboronic acid was changed to intermediate **(158-b)** (1 eq, 50 g), and 3-chloro-6-bromodibenzofuran was changed to 2-bromo-5-trifluoromethylquinoline. 16.5 g of a solid intermediate **(327-a)** was obtained, and the yield was 28%. EI mass spectrometry showed the charge peak m/z = 455.10.

16.2. Synthesis of organometallic complex **(327):**

Referring to the synthesis method of metal complex **(5),** the difference was that the intermediate **(5-d)** was changed to intermediate **(209-b)** (1 eq, 15 g), and the intermediate **(5-c)** was changed to intermediate **(327-a).** 12.6 g of a crimson metal complex **(327)** was obtained, and the yield was 47%. EI mass spectrometry showed a charge peak m/z = 956.19.

**Example 17. Synthesis of organometallic complex (343):**

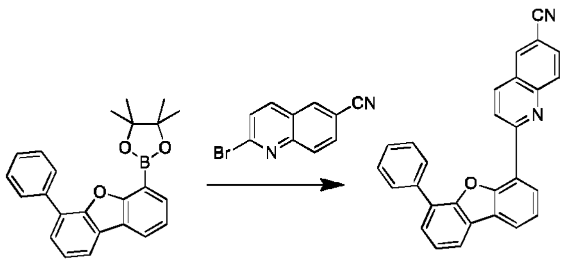

(146-b) (343-a)

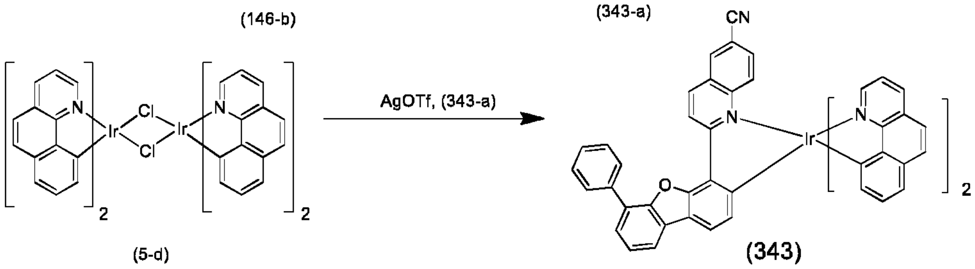


(5-d) **(343)**

17.1. Synthesis of intermediate **(343-a):**

Referring to the synthesis method of compound intermediate**(5-a)**, the difference was that phenylboronic acid was changed to intermediate**(146-b)** (1 eq, 50 g), and 3-chloro-6-bromodibenzofuran was changed to 2-bromo-6-cyanoquinoline. 25.7 g of a solid intermediate **(343-a)** was obtained, and the yield was 48%. EI mass spectrometry showed the charge peak m/z = 396.13.

17.2. Synthesis of organometallic complex **(343):**

Referring to the synthesis method of metal complex **(5),** the difference was that the intermediate **(5-c)** was changed to intermediate **(343-a)** (1 eq, 12.5 g). 15.2 g of a crimson metal complex **(343)** was obtained, and the yield was 51%. EI mass spectrometry showed the charge peak m/z = 944.22.

**Example 18. Synthesis of an organometallic complex (352):**

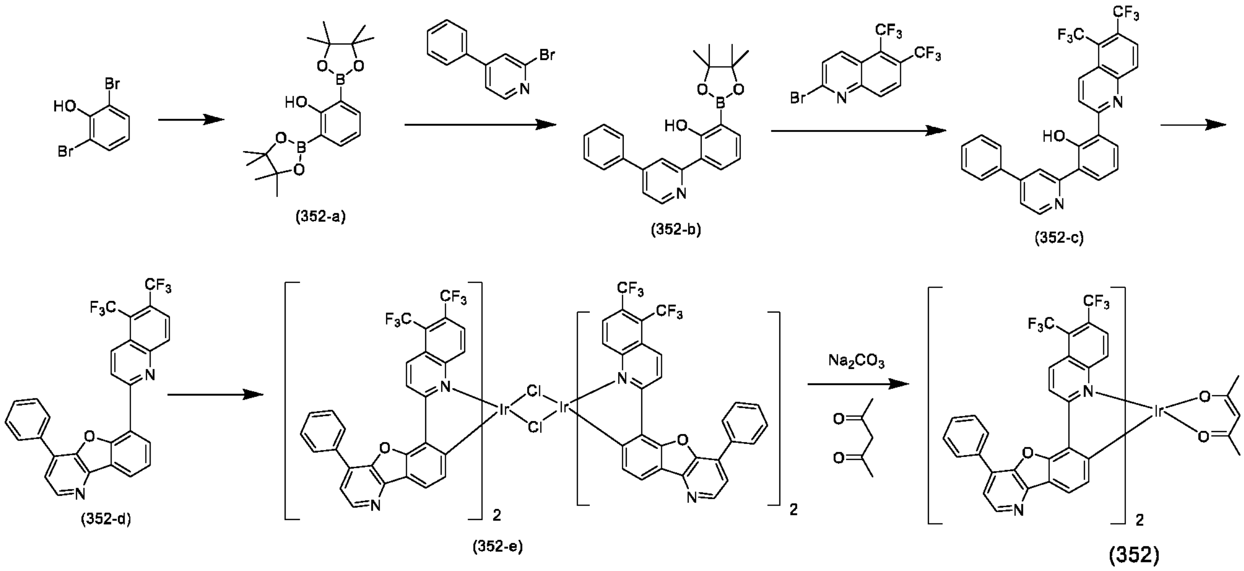


(352-a) (352-b) (352-c) (352-d) (352-e)

**(352)**

18.1. Synthesis of intermediate **(352-a):**

Pinacol diboronate (3eq), 2,6-dibromophenol (1eq, 300 g), Pd (dppf) $_2Cl_2$ (0.2eq), potassium acetate (6eq) were placed in a dry double bottle, and then 250 mL of a mixed solution of dioxane and water with a ratio of 3: 1 was added. The reaction was stirred at 90 oC for 12 hours. The reaction solution was cooled to room temperature. The obtained solution was dried after the reaction was ended, dried with dichloromethane and water solution, dried with magnesium sulfate, and then separated and purified by silica gel column. 291.0 g of a solid intermediate **(352-a)** was obtained, and the yield was 70%. EI mass spectrometry showed the charge peak m/z = 346.21.

18.2. Synthesis of intermediate **(352-b):**

Referring to the synthesis method of compound intermediate **(5-a),** the difference was that phenylboronic acid was changed to intermediate **(352-a)** (1eq, 300 g), and 3-chloro-6-bromodibenzofuran was changed to 2-bromo-4-phenylpyridine. 181.9 g of a solid intermediate **(352-b)** was obtained, the yield was 58%, and EI mass spectrometry showed the charge peak m/z = 373.18.

18.3. Synthesis of intermediate **(352-c):**

Referring to the synthesis method of compound intermediate **(5-a),** the difference was that phenylboronic acid was changed to intermediate **(352-b)** (1eq, 181.9 g), and 3-chloro-6-bromodibenzofuran was changed to 2-bromo-5, 6-bis (trifluoromethyl) quinoline. 129.3 g of a solid intermediate (352-c) was obtained, the yield was 52%, and EI mass

spectrometry showed the charge peak m/z = 510.12.

18.4. Synthesis of intermediate **(352-d):**

Referring to the synthesis method of compound intermediate **(113-c),** the difference was that the intermediate **(113-b)** was changed to intermediate **(352-c)** (1eq, 129.3 g). 46.4 g of a solid intermediate **(352-d)** was obtained, the yield was 36%, and EI mass spectrometry showed the charge peak m/z = 508.10.

18.5. Synthesis of intermediate **(352-e):**

Referring to the synthesis method of compound intermediate **(5-d),** the difference was that 7, 8-benzoquinoline was changed to an intermediate **(352-d)** (4.4 eq, 46.4 g). 21.1 g of a reddish-brown intermediate **(352-e)** was obtained, the yield was 41%, and EI mass spectrometry showed charge peak m/z = 2484.25.

18.6. Synthesis of organometallic complex **(352):**

Referring to the synthesis method of metal complex **(7),** the difference was that the intermediate **(7-a)** was changed to intermediate **(352-e)** (1eq, 20 g). 6.5 g of a crimson metal complex **(352)** was obtained, and the yield was 31%. EI mass spectrometry showed a charge peak m/z = 1306.20.

**1.2 Calculation of energy level data of transition metal complexes:**

By time-dependent density functional theory (TD-DFT) and Gaussian 09W (Gaussian Inc.), firstly, the molecular geometry structure was optimized by using the Semi-empirical method of "Ground State/Semi-empirical/Default Spin! AM1" (Charge 0/Spin Singlet), and then the energy structure of organic molecules was calculated by TD-DFT to obtain "TD-SCF/DFT/Default Spin/B3PW91" and the basis set "6-31G (d)" (Charge 0/Spin Singlet). The HOMO and LUMO energy levels were calculated according to the following calibration formula, and S1, T1 and resonance factor f(S1) were used directly.

$$\text{HOMO (eV)} = (\text{HOMO (G)} \times 27.212)-0.9899)/1.1206;$$

$$\text{LUMO (eV)} = ((\text{LUMO (G)} \times 27.212)-2.0041)/1.385.$$

In which HOMO, LUMO, T1 and S1 are the direct calculation results of Gaussian 09W, and the unit is Hartree. The results are shown in Table 1 below. The energy level data of the transition metal complexes are shown in Table 1, in which HOMO represents the Highest Occupied Molecular Orbital, LUMO represents the Lowest Unoccupied Molecular Orbital, and $S_1$ represents the lowest single energy level, $T_1$ represents the triplet energy level.

Table 1. Energy level data of transition metal complexes

| Metal Complex | HOMO | LUMO | S1 | T1 |
|---|---|---|---|---|
| **(5)** | -4.42 | -3.25 | 2.17 | 1.91 |
| **(7)** | -4.53 | -3.13 | 2.28 | 1.96 |
| **(17)** | -4.66 | -2.95 | 2.39 | 2.04 |
| **(54)** | -4.50 | -3.15 | 2.18 | 1.95 |
| **(79)** | -4.61 | -3.01 | 2.37 | 2.02 |
| **(113)** | -4.57 | -3.09 | 2.33 | 2.00 |
| **(133)** | -4.46 | -3.20 | 2.22 | 1.93 |
| **(146)** | -4.55 | -3.10 | 2.31 | 1.98 |
| **(158)** | -4.59 | -3.05 | 2.35 | 2.01 |
| **(197)** | -4.44 | -3.22 | 2.16 | 1.91 |
| **(209)** | -4.71 | -2.90 | 2.44 | 2.14 |
| **(240)** | -4.31 | -3.39 | 2.05 | 1.79 |
| **(268)** | -4.64 | -2.99 | 2.40 | 2.04 |

(continued)

| Metal Complex | HOMO | LUMO | S1 | T1 |
|---|---|---|---|---|
| **(293)** | -4.35 | -3.33 | 2.13 | 1.85 |
| **(327)** | -4.68 | -2.93 | 2.41 | 2.07 |
| **(343)** | -4.40 | -3.30 | 2.14 | 1.88 |
| **(352)** | -4.38 | -3.31 | 2.09 | 1.86 |
| REF1 | -5.10 | -2.68 | 2.63 | 2.36 |
| REF2 | -4.95 | -2.77 | 2.58 | 2.32 |

In which, the structures of REF1 and REF2 are as follows:

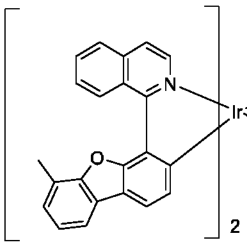

REF1

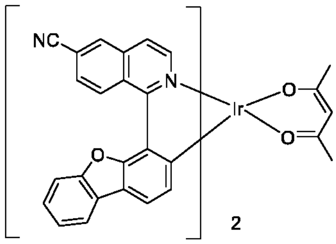

REF2

### 1.3. Fabrication and Characterization of OLED Devices

Structure of OLED Devices:

The structure of the device is as follows: ITO/HIL (100 Å)/HTL (450 Å)/EBM (50 Å)/EML (400 Å)/ETL (350 Å)/cathode.

EML is composed of H-Host, E-Host and transition metal complexes. The mass ratio of H-Host to E-Host is 6: 4, and the doping amount of transition metal complexes is 10% (w/w) of the total mass of H-Host and E-Host. The guest material of the light emitting layer uses the transition metal complex of the embodiment of the present disclosure: **(5), (7), (17), (54) (79), (113), (133), (146), (158), (197), (209), (240), (268), (293), (327), (343), (352),** REF1 or REF2. ETL consists of LiQ (8-hydroxyquinoline-lithium) doped 40% (w/w) ETM.

The material structure used in OLED devices is as follows:

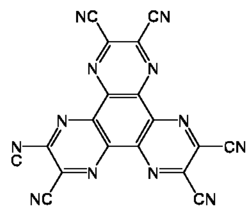

HIL

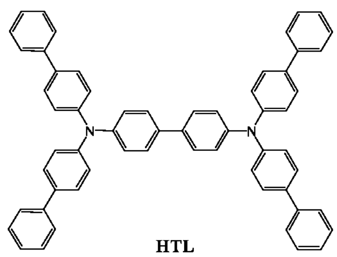

HTL

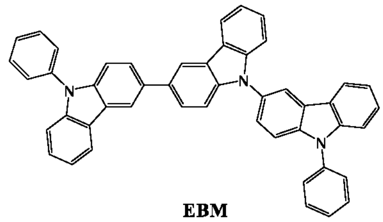

EBM

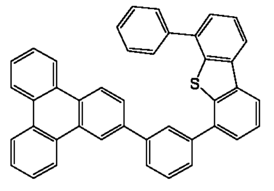

H-Host

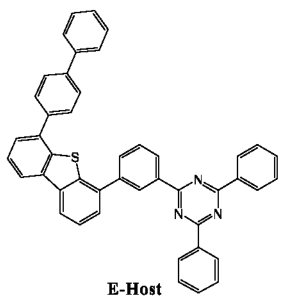

E-Host

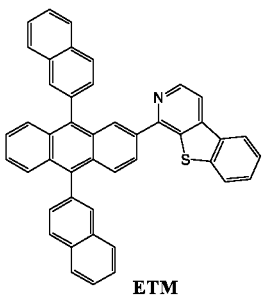

ETM

.

19.2. Fabrication of OLED Devices

a. Cleaning of conductive glass substrate: When used for the first time, various solvents may be used for cleaning, such as chloroform, ketone and isopropanol, and then ultraviolet ozone plasma treatment. In this example, the following cleaning methods are specifically adopted: the substrate was rinsed and immersied in ultrasonic vibration for 5 minutes, and then dried by air.

b. HIL (100 Å), HTM (450 Å), EBM (50 Å), EML (400 Å), ETL (350 Å) were deposited by thermal evaporation in high vacuum $(1\times 10)^{-6}$ Millibar, mbar).

c. Cathode: LiF/Al (1nm/150nm) was deposited by thermal evaporation in high vacuum ($1\times10^{-6}$ mbar).

d. Encapsulation: The device was encapsulated with ultraviolet hardening resin in a nitrogen glove box.

19.3. Characterization of OLED Devices

The current-voltage luminance (JVL) characteristics of the OLED devices 1 to 17 are characterized by a characterization device while recording important parameters such as emission peak wavelengths, external quantum efficiency and device lifetime. The relative parameters of OLED devices are shown in Table 4:

Table 4. Relative data of devices made of different dopants

| Device Example | Guest Material | Luminescence Peak Wavelength (nm) | External Quantum Efficiency (EQE) | Lifetime (LT50h) @ 50mA/$cm^2$ |
|---|---|---|---|---|
| OLED-1 | **(5)** | 679 | 1.15 | 1.17 |
| OLED-2 | **(7)** | 668 | 1.11 | 1.14 |
| OLED-3 | **(17)** | 649 | 1.09 | 1.08 |
| OLED-4 | **(54)** | 670 | 1.17 | 1.11 |
| OLED-5 | **(79)** | 654 | 1.16 | 1.13 |
| OLED-6 | **(113)** | 661 | 1.12 | 1.15 |
| OLED-7 | **(133)** | 673 | 1.19 | 1.21 |
| OLED-8 | **(146)** | 663 | 1.09 | 1.22 |
| OLED-9 | **(158)** | 655 | 1.10 | 1.09 |
| OLED-10 | **(197)** | 676 | 1.13 | 1.08 |
| OLED-11 | **(209)** | 640 | 1.06 | 1.09 |
| OLED-12 | **(240)** | 695 | 1.05 | 1.07 |
| OLED-13 | **(268)** | 650 | 1.12 | 1.08 |
| OLED-14 | **(293)** | 690 | 1.09 | 1.08 |
| OLED-15 | **(327)** | 645 | 1.11 | 1.13 |
| OLED-16 | **(343)** | 680 | 1.09 | 1.06 |
| OLED-17 | **(352)** | 687 | 1.08 | 1.10 |
| REF1 | REF1 | 614 | 1 | 1 |
| REF2 | REF2 | 625 | 1.02 | 1.04 |

It can be seen from the data in Table 4 that compared with the device made of metal complexes REF1 and REF2, the external quantum efficiency and device lifetime of the OLED device are significantly improved by using the metal complex material of the present disclosure as the doping material of EML (light emitting layer), and the light emitting wave wavelength of the device is larger than that of the comparative ratio (REF1 and REF2), that is, the light color is red shifted.

As to the cause of the beneficial effect, it is inferred that the metal complex provided by the present disclosure

contains at least one electron-pulling group such as -CN, -F or $-CF_3$. These electron-pulling groups can help the electron transmission in the device, so that the electrons can be used effectively, the luminous efficiency of the device can be improved, and the starting voltage and prolonging the life of the device can be reduced. In addition, the substitution of electron-pulling groups can greatly stabilize the LUMO energy level of the metal complexes, furthermore, the conjugated system of the metal complexes can further be increased by the limited phenyl groups in the heteroatom-containing system. The coordinated use of the two groups can greatly shift the luminescence of metal complexes to red, thus realizing high-efficiency deep-red light color.

If the present disclosure is further optimized, such as optimizing the structure of the device and optimizing the combination of HTM, ETM and the host material, the performance of the device, especially the efficiency, the driving voltage and the life of the device will be further improved.

The technical features of the above-described implementation ways and embodiments may be combined in any suitable manner, and all possible combinations of the technical features in the above-described implementation way and embodiments have not been described for concise description. However, as long as there is no contradiction in the combinations of these technical features, they should be considered to be within the scope described in this specification. The above-described embodiments only represent a few embodiments of the present disclosure, but it cannot be understood as a limitation on the scope of the present disclosure. It should be noted that a number of modifications and modifications may be made to one of those ordinary skilled in the art without departing from the concept of the present disclosure, which fall within the scope of the present disclosure. In addition, it should be understood that after reading the above described contents of the present disclosure, various modifications or improvement may be made to the present disclosure by those skilled in the art, resulting in equivalent forms that also fall within the scope of the present disclosure. It should also be understood that the technical solutions obtained by those skilled in the art through logical analysis, reasoning or limited experiments on the basis of the technical solutions provided by the present disclosure are within the scope of protection of the appended claims of the present disclosure. Therefore, the scope of protection of the present disclosure patent shall be subject to the appended claims, and the specification can be used to explain the contents of the claims.

## Claims

1. A metal complex having a structure as represented by formula (I) or formula (II):

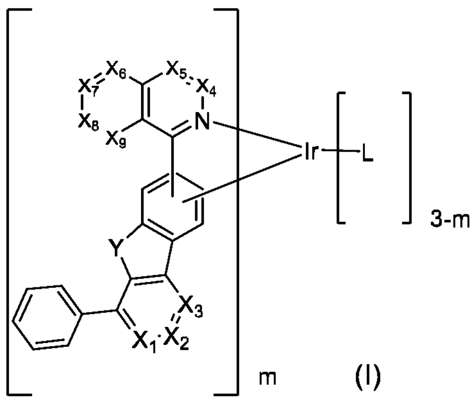
(I)

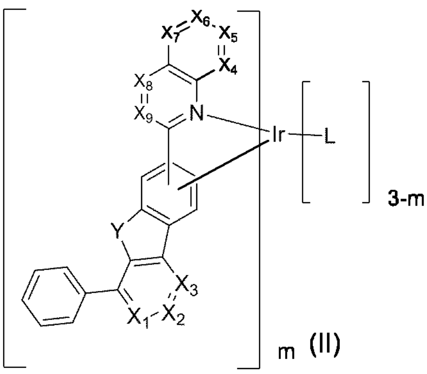
(II) ;

wherein,

L is a monovalent anionic organic ligand;
m is selected from 1 or 2 or 3;
$X_1$, $X_2$, and $X_3$ are selected independently at each occurrence from $CR_1$ or N;
$X_4$, $X_5$, $X_6$, $X_7$, $X_8$, and $X_9$ are selected independently at each occurrence from $CR_2$ or N;
Y is selected independently at each occurrence from $CR_3R_4$, $NR_3$, O, S or SOz;
$R_1$, $R_2$, $R_3$, and $R_4$ are selected independently at each occurrence from the group consisting of -H, -D, a linear alkyl group having 1 to 20 carbon atoms, a linear alkoxy group having 1 to 20 carbon atoms, a linear thioalkoxy group having 1 to 20 carbon atoms, a branched alkyl group having 3 to 20 carbon atoms, a cyclic alkyl group having 3 to 20 carbon atoms, a branched alkoxy group having 3 to 20 carbon atoms, a cyclic alkoxy group having 3 to 20 carbon atoms, a branched thioalkoxy group having 3 to 20 carbon atoms, a cyclic thioalkoxy

group having 3 to 20 carbon atoms, silicyl, a ketone group having 1 to 20 carbon atoms, an alkoxycarbonyl group having 2 to 20 carbon atoms, an aryloxycarbonyl group having 7 to 20 carbon atoms, -CN, carbamoyl, haloformyl, formyl, an isocyano group, an isocyanate group, a thiocyanate group, an isothiocyanate group, hydroxyl, nitro, $-CF_3$, -Cl, -Br, -F, a substituted or unsubstituted aromatic group having 6 to 60 ring atoms, a substituted or unsubstituted heteroaromatic group having 5 to 60 ring atoms, a substituted or unsubstituted aryloxy group having 6 to 60 ring atoms, a substituted or unsubstituted heteroaryloxy group having 5 to 60 ring atoms, and any combination of the groups; and adjacent two $R_1$ form or do not form a ring, or adjacent two $R_2$ form or do not form a ring; and
at least a $R_2$ is selected from -CN, -F, or $-CF_3$.

**2.** The metal complex of claim 1, wherein the metal complex is selected from any one of the structures represented by formulae (1-1) to (1-6):

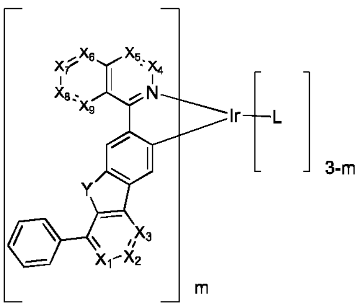
(1-1)

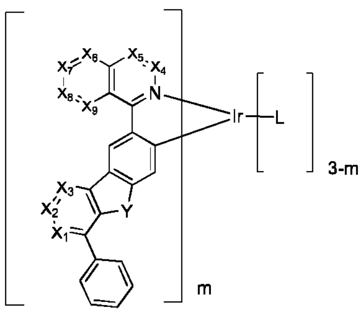
(1-2)

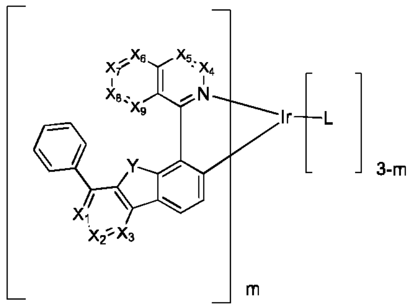
(1-3)

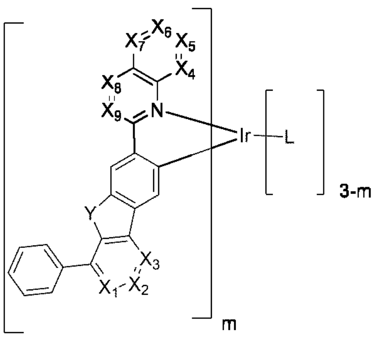
(1-4)

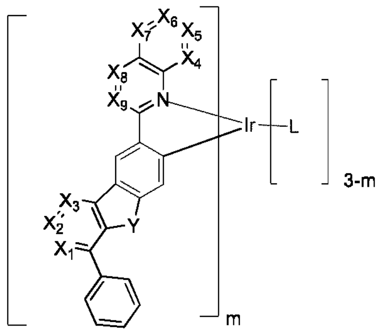
(1-5)

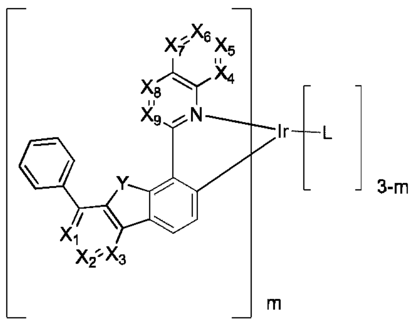
(1-6)

.

**3.** The metal complex of claim 2, wherein $X_7$ is selected from $CR_2$, and $R_2$ is selected from -CN, -F, or $-CF_3$.

**4.** The metal complex of claim 2, wherein

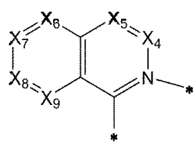

is selected from any of following groups:

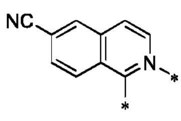 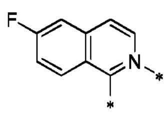 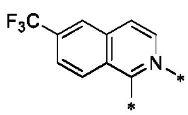 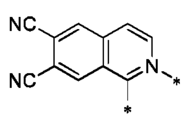 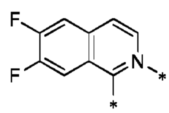 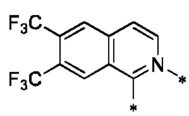

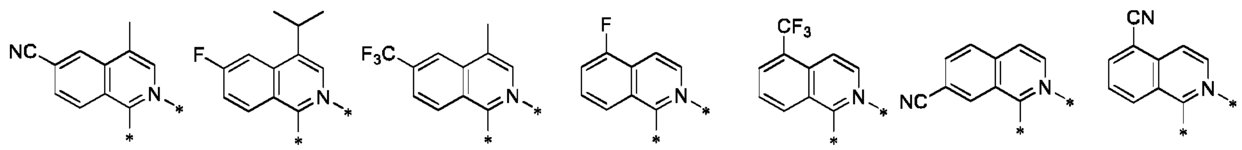

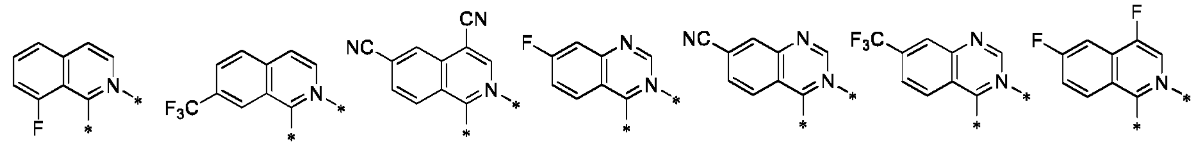

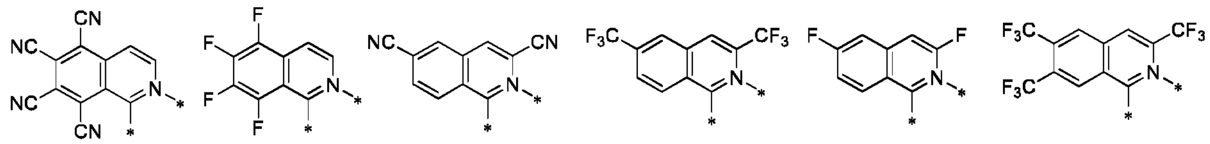

;

and/or,

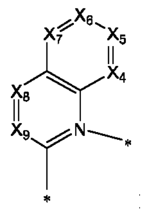

is selected from any one of following groups:

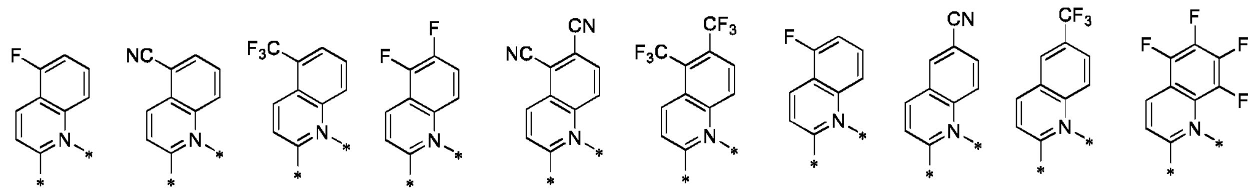

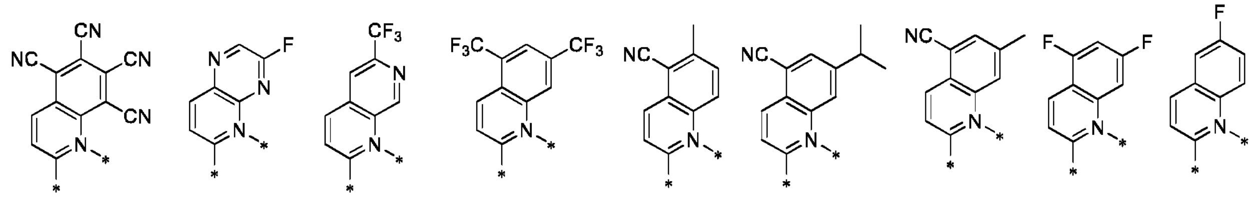

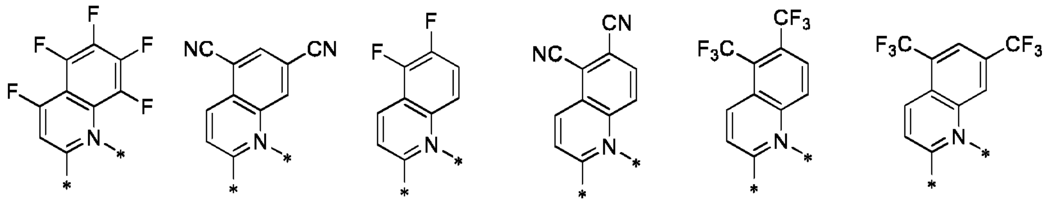

;

wherein: "*" represents a connecting site.

**5.** The metal complex of claim 2, wherein

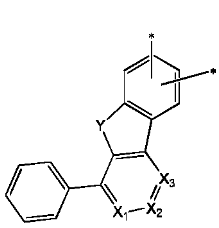

is selected independently of each other from any one of following groups:

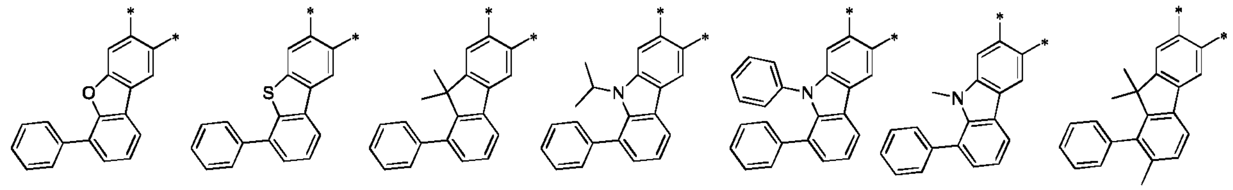

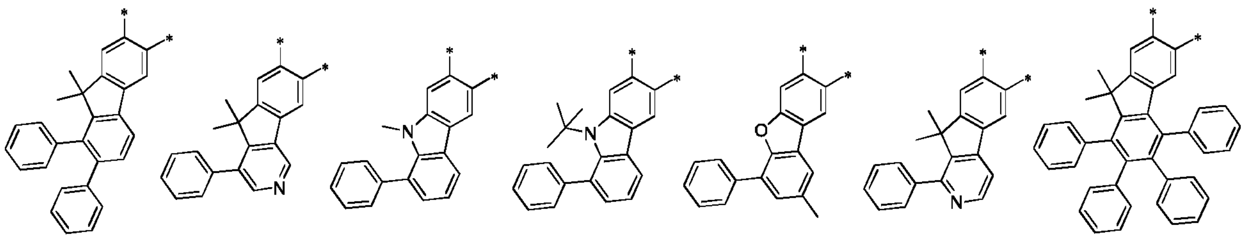

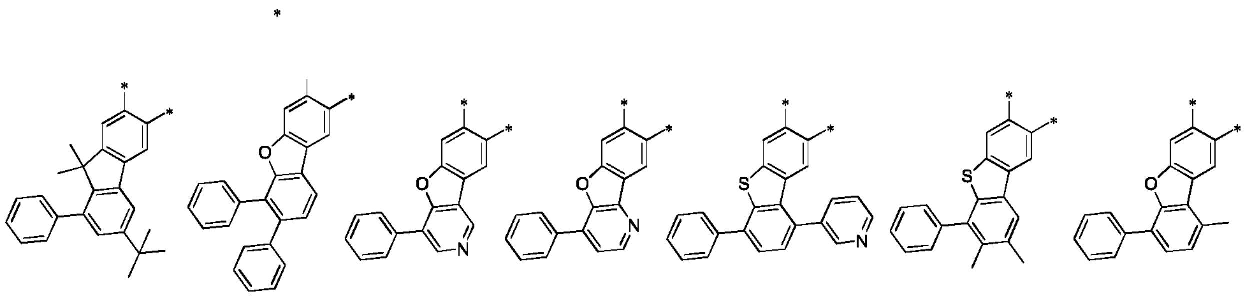

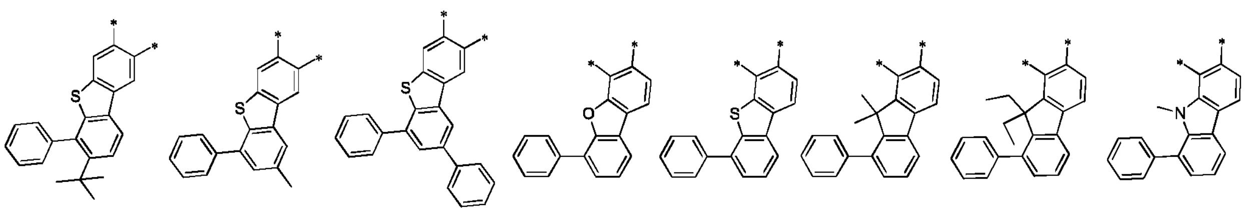

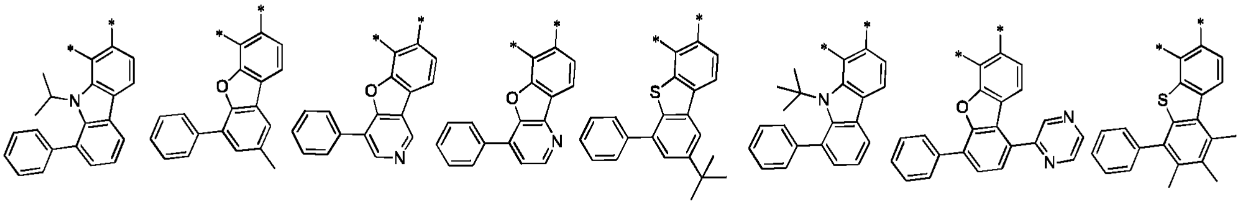

;

wherein: "*" represents a connecting site.

**6.** That metal complex of claim 1, wherein L is selected from the group consisting of following structural formulae:

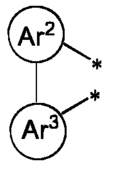 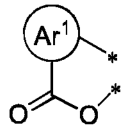 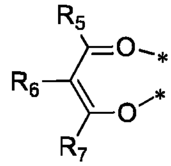 ;

wherein,

$Ar^1$, $Ar^2$ and $Ar^3$ are selected independently of each other from the group consisting of a substituted or unsubstituted aromatic group having 5 to 30 ring atoms, a substituted or unsubstituted heteroaromatic group having 5 to 30 ring atoms, and a substituted or unsubstituted non-aromatic ring system having 5 to 30 ring atoms;
$R_5$, $R_6$, $R_7$ are selected independently of each other at each occurrence from the group consisting of -H, -D, a linear alkyl group having 1 to 20 carbon atoms, a linear alkoxy group having 1 to 20 carbon atoms, a linear thioalkoxy group having 1 to 20 carbon atoms, a branched alkyl group having 3 to 20 carbon atoms, a cyclic alkyl group having 3 to 20 carbon atoms, a branched alkoxy group having 3 to 20 carbon atoms, a cyclic alkoxy group having 3 to 20 carbon atoms, a branched thioalkoxy group having 3 to 20 carbon atoms, a cyclic thioalkoxy group having 3 to 20 carbon atoms, silicyl, a ketone group having 1 to 20 carbon atoms, an alkoxycarbonyl group having 2 to 20 carbon atoms, an aryloxycarbonyl group having 7 to 20 carbon atoms, -CN, carbamoyl, haloformyl, formyl, an isocyano group, an isocyanate group, a thiocyanate group, an isothiocyanate group, hydroxyl, nitro, $-CF_3$, -Cl, -Br, -F, a substituted or unsubstituted aromatic group having 6 to 60 ring atoms, a substituted or unsubstituted heteroaromatic group having 5 to 60 ring atoms, a substituted or unsubstituted aryloxy group having 6 to 60 ring atoms, a substituted or unsubstituted heteroaryloxy group having 5 to 60 ring atoms, and any suitable combination of the groups; and
"*" represents a site connected to Ir.

**7.** The metal complex of claim 6, wherein $Ar^1$, $Ar^2$, and $Ar^3$ are selected independently of each other from the group consisting of following groups:

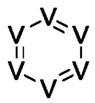 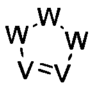 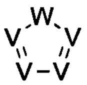 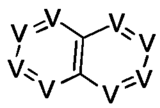 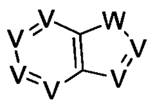 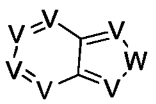 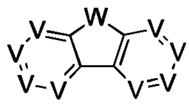 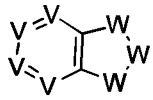

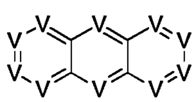 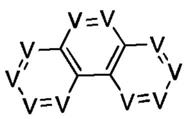 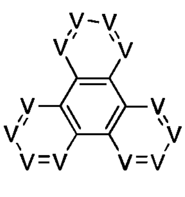 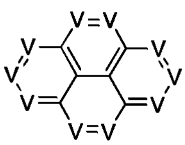 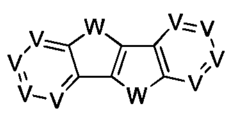 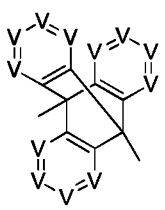

;

wherein,

V is selected independently at each occurrence from C, $CR_8$ or N;
W is selected independently at each occurrence from $CR_9R_{10}$, $NR_9$, O, S, N, $PR_9$, $BR_9$ or $SiR_9R_{10}$;
$R_8$, $R_9$, $R_{10}$ are selected independently at each occurrence from the group consisting of -H, -D, a linear alkyl group having 1 to 20 carbon atoms, a linear alkoxy group having 1 to 20 carbon atoms, a linear thioalkoxy group having 1 to 20 carbon atoms, a branched alkyl group having 3 to 20 carbon atoms, a cyclic alkyl group having 3 to 20 carbon atoms, a branched alkoxy group having 3 to 20 carbon atoms, a cyclic alkoxy group having 3 to 20 carbon atoms, a branched thioalkoxy group having 3 to 20 carbon atoms, a cyclic thioalkoxy group having 3 to 20 carbon atoms, silicyl, a ketone group having 1 to 20 carbon atoms, an alkoxycarbonyl group having 2 to 20 carbon atoms, an aryloxycarbonyl group having 7 to 20 carbon atoms, -CN, carbamoyl, haloformyl, formyl, an isocyano group, an isocyanate group, a thiocyanate group, an isothiocyanate group, hydroxyl, nitro, $-CF_3$,

-Cl, -Br, -F, a substituted or unsubstituted alkenyl group having 2 to 20 carbon atoms, a substituted or unsubstituted aromatic group having 6 to 60 ring atoms, a substituted or unsubstituted heteroaromatic group having 5 to 60 ring atoms, a substituted or unsubstituted aryloxy group having 6 to 60 ring atoms, a substituted or unsubstituted heteroaryloxy group having 5 to 60 ring atoms, and any combination of the groups; and adjacent two $R_8$ form or do not form a ring, and/or adjacent two $R_9$ form or do not form a ring.

**8.** The metal complex of claim 7, wherein L is preferably selected from any one of structures (G-1) to (G-28):

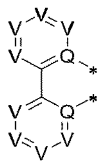
(G-1)
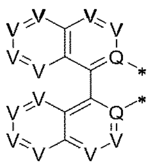
(G-2)
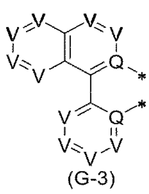
(G-3)
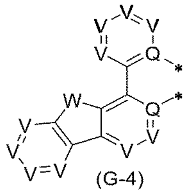
(G-4)
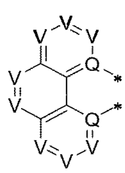
(G-5)
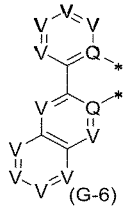
(G-6)
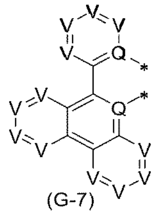
(G-7)
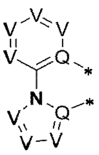
**(G-8)**
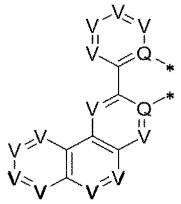
**(G-9)**
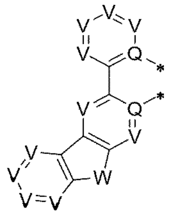
**(G-10)**
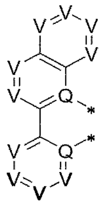
**(G-11)**
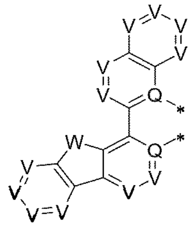
**(G-12)**
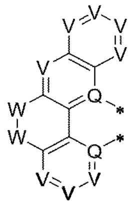
**(G-13)**
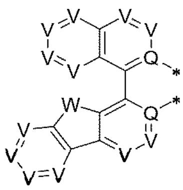
**(G-14)**
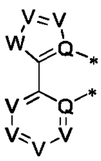
**(G-15)**
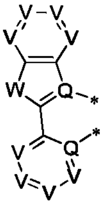
**(G-16)**
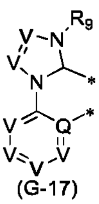
**(G-17)**
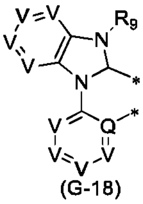
**(G-18)**
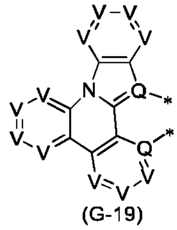
**(G-19)**
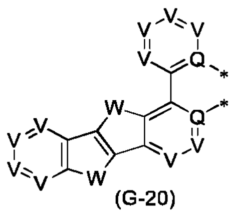
**(G-20)**
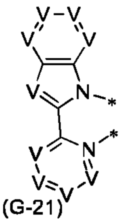
**(G-21)**
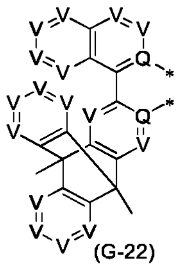
**(G-22)**
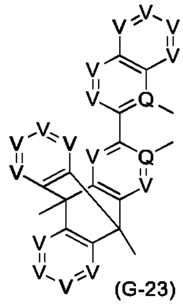
**(G-23)**
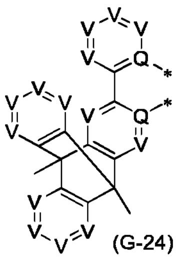
**(G-24)**
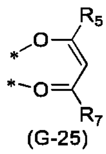
**(G-25)**
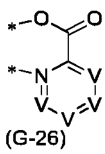
**(G-26)**
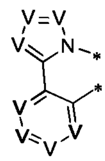
**(G-27)**
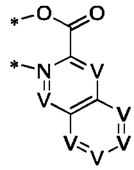
**(G-28)**

;

wherein one Q of the monovalent anionic organic ligand is C, and another one Q of the monovalent anionic organic ligand is N.

**9.** The metal complex of claim 8, wherein the metal complex is selected from any one of formulae (2-1) to (2-16):

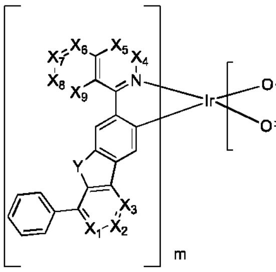
(2-1)

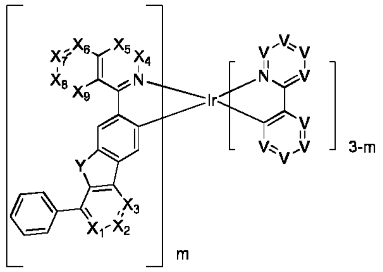
(2-2)

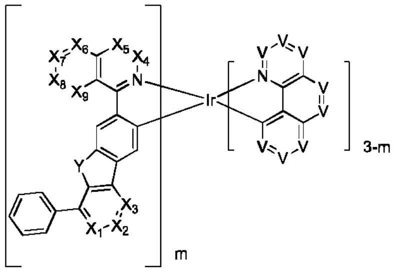
(2-3)

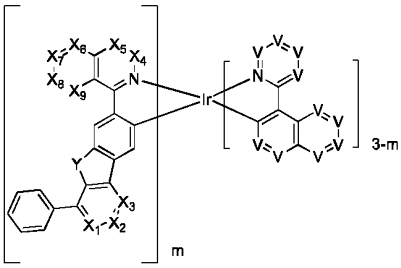
(2-4)

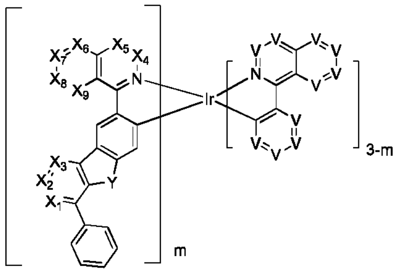
(2-5)

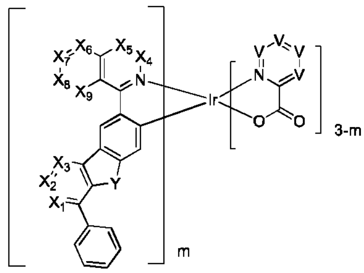
(2-6)

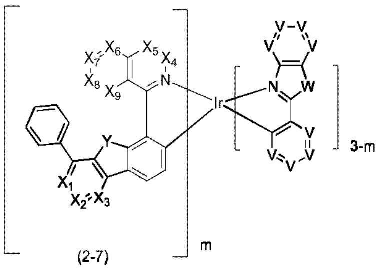
(2-7)

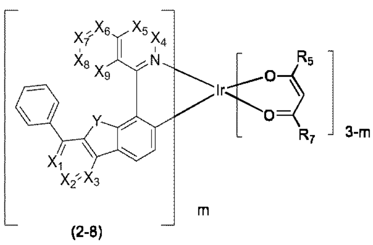
(2-8)

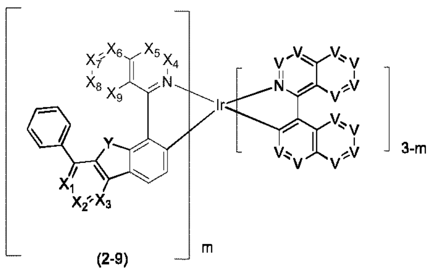
(2-9)

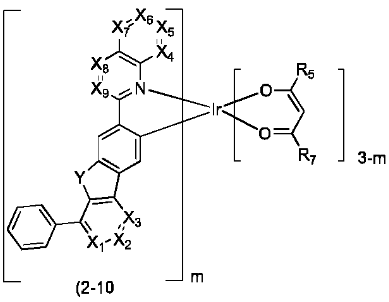
(2-10

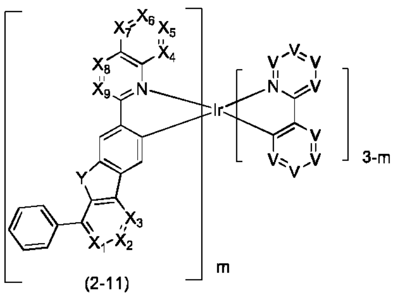
(2-11)

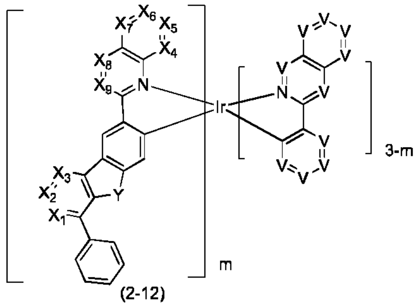
(2-12)

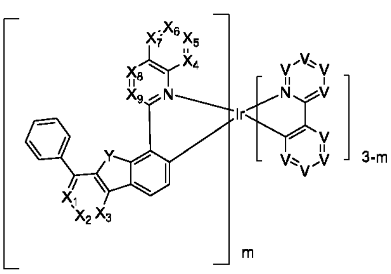
(2-13)

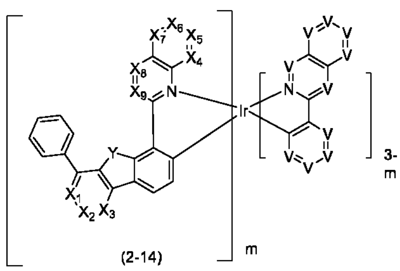
(2-14)

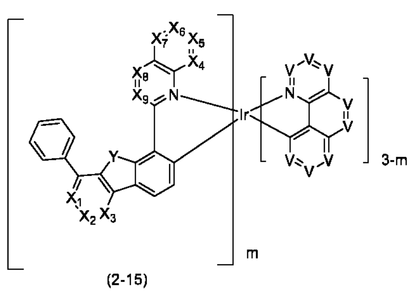
(2-15)

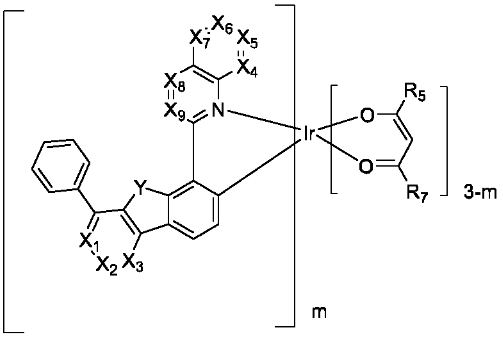

(2-16)

10. The metal complex of claim 1, wherein L is selected from any one of structures (H-1) to (H-42):

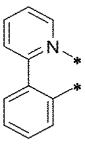
(H-1)
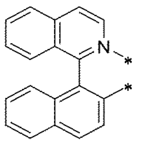
(H-2)
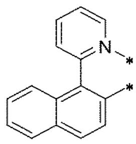
(H-3)
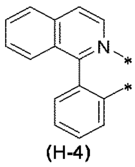
(H-4)
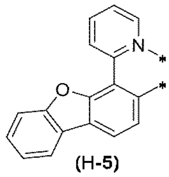
(H-5)
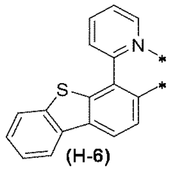
(H-6)
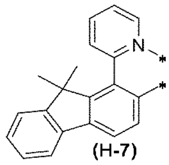
(H-7)
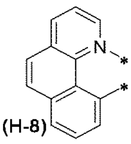
(H-8)

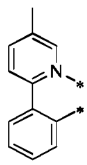
(H-9)
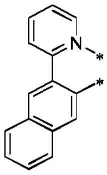
(H-10)
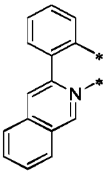
(H-11)
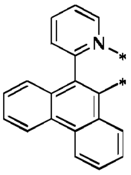
(H-12)
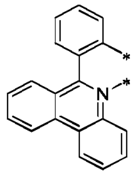
(H-13)
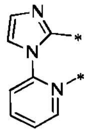
(H-14)
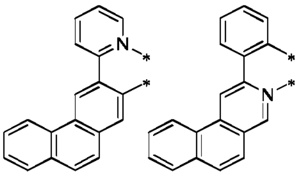
(H-15) (H-16)
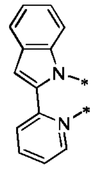
(H-17)

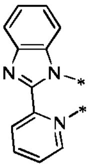
(H-18)
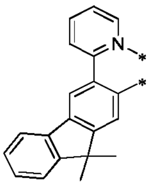
(H-19)
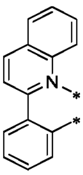
(H-20)
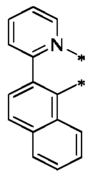
(H-21)
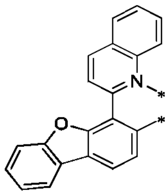
(H-22)
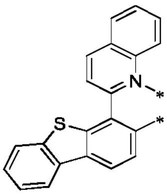
(H-23)
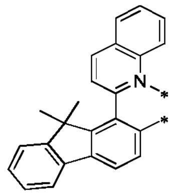
(H-24)
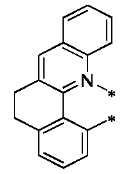
(H-25)

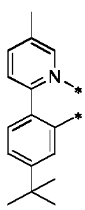
(H-26)
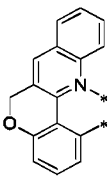
(H-27)
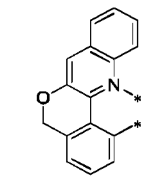
(H-28)
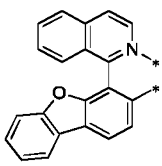
(H-29)
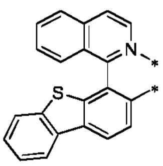
(H-30)
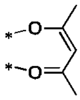
(H-31)
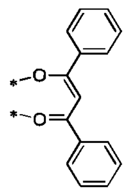
(H-32)
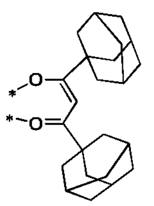
(H-33)

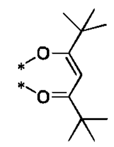
(H-34)
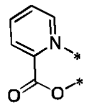
(H-35)
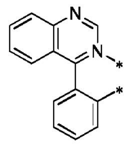
(H-36)
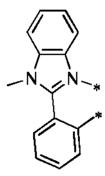
(H-37)
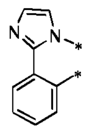
(H-38)
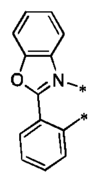
(H-39)
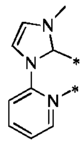
(H-40)
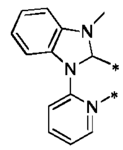
(H-41)
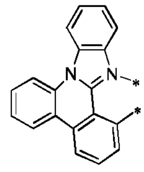
(H-42)

;

"*" represents a site connected to Ir.

**11.** A mixture, wherein the mixture comprises a metal complex and at least an organic functional material, and the organic functional material is selected from at least one of a hole injection material, a hole transport material, an electron transport material, an electron injection material, an electron blocking material, a hole blocking material, a luminescent material, a host material, and an organic dye;

the metal complex has a structure as represented by formula (I) or formula (II)

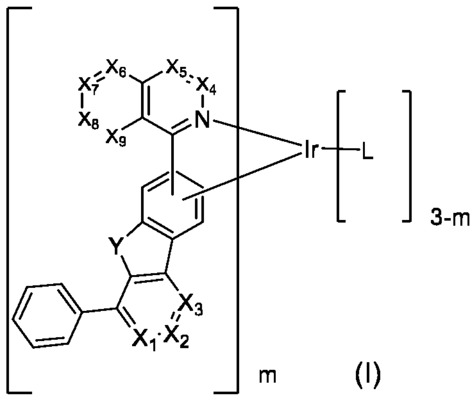
(I)
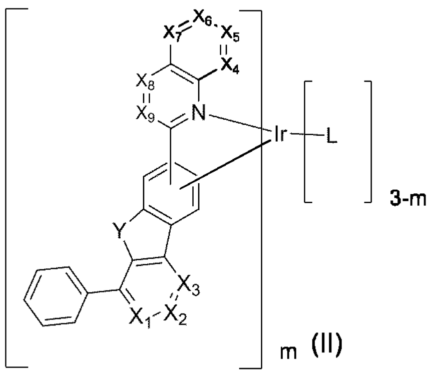
(II)
;

wherein,
L is a monovalent anionic organic ligand;
m is selected from 1 or 2 or 3;
$X_1$, $X_2$, and $X_3$ are selected independently at each occurrence from $CR_1$ or N;
$X_4$, $X_5$, $X_6$, $X_7$, $X_8$, and $X_9$ are selected independently at each occurrence from $CR_2$ or N;
Y is selected independently at each occurrence from $CR_3R_4$, $NR_3$, O, S or SOz;
$R_1$, $R_2$, $R_3$, and $R_4$ are selected independently at each occurrence from the group consisting of -H, -D, a linear alkyl group having 1 to 20 carbon atoms, a linear alkoxy group having 1 to 20 carbon atoms, a linear thioalkoxy group having 1 to 20 carbon atoms, a branched alkyl group having 3 to 20 carbon atoms, a cyclic alkyl group having 3 to 20 carbon atoms, a branched alkoxy group having 3 to 20 carbon atoms, a cyclic alkoxy group having 3 to 20 carbon atoms, a branched thioalkoxy group having 3 to 20 carbon atoms, a cyclic thioalkoxy group having 3 to 20 carbon atoms, silicyl, a ketone group having 1 to 20 carbon atoms, an alkoxycarbonyl group having 2 to 20 carbon atoms, an aryloxycarbonyl group having 7 to 20 carbon atoms, -CN, carbamoyl, haloformyl, formyl, an isocyano group, an isocyanate group, a thiocyanate group, an isothiocyanate group, hydroxyl, nitro, $-CF_3$, -Cl, -Br, -F, a substituted or unsubstituted aromatic group having 6 to 60 ring atoms, a substituted or unsubstituted heteroaromatic group having 5 to 60 ring atoms, a substituted or unsubstituted aryloxy group having 6 to 60 ring atoms, a substituted or unsubstituted heteroaryloxy group having 5 to 60 ring atoms, and any combination of the groups; and adjacent two $R_1$ form or do not form a ring, or adjacent two $R_2$ form or do not form a ring; and
at least a $R_2$ is selected from -CN, -F, or $-CF_3$.

**12.** The mixture of claim 11, wherein the metal complex is selected from any one of structures represented by formulae (1-1) to (1-6):

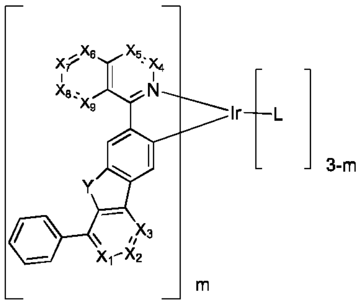

(1-1)

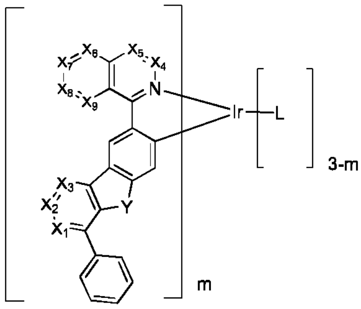

(1-2)

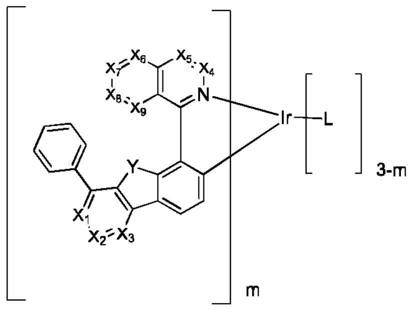

(1-3)

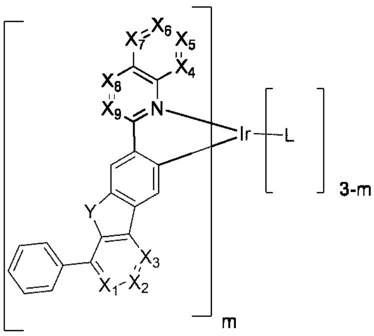

(1-4)

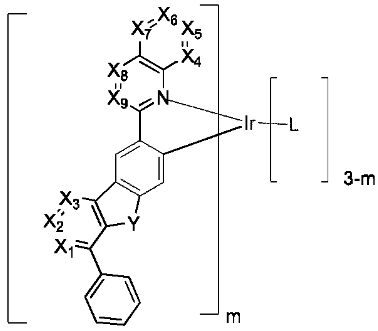

(1-5)

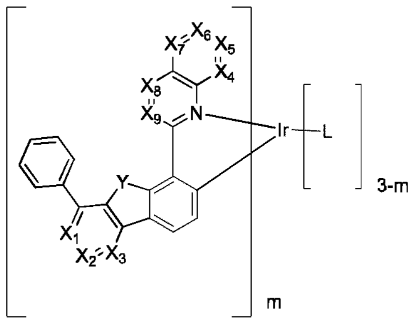

(1-6)

.

**13.** The mixture of claim 12, wherein $X_7$ is selected from $CR_2$, and $R_2$ is selected from -CN, -F, or $-CF_3$.

**14.** The mixture of claim 12, wherein

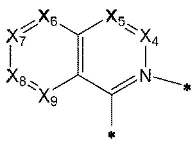

is selected from any one of following groups:

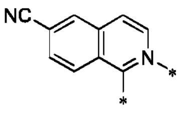 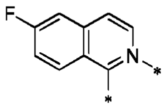 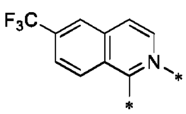 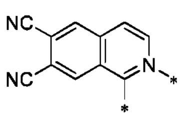 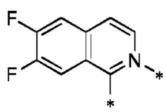 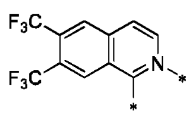

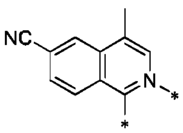 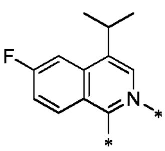 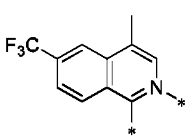 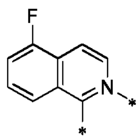 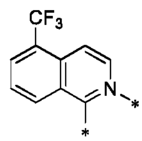 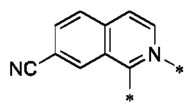 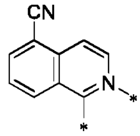

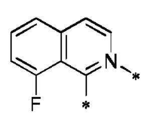 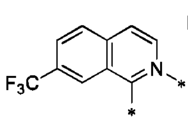 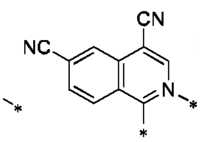 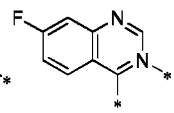 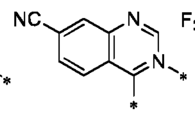 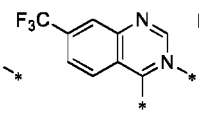 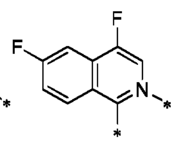

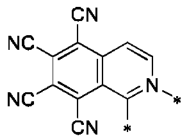 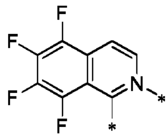 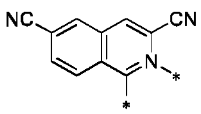 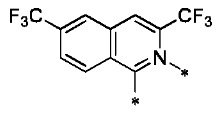 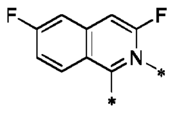 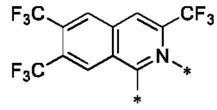

;

and/or,

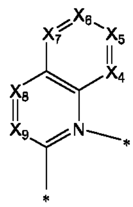

is selected from any one of following groups:

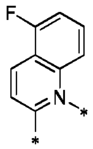 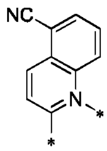 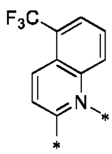 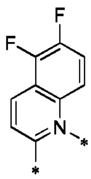 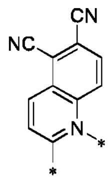 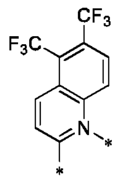 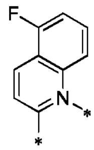 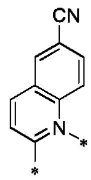 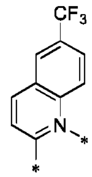 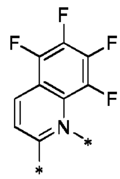

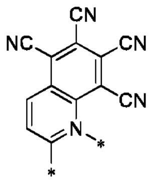 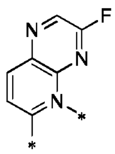 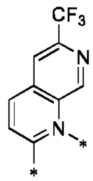 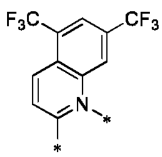 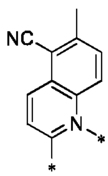 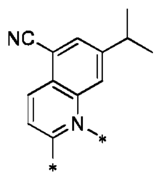 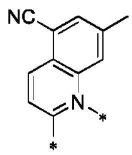 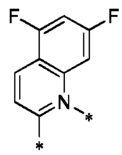 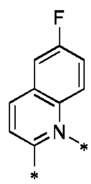

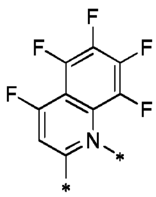 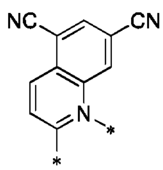 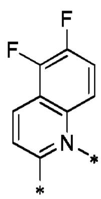 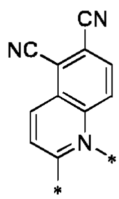 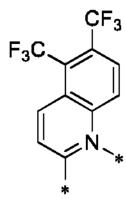 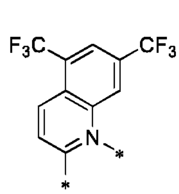

;

wherein: "*" represents a connecting site.

**15.** The mixture of claim 12, wherein

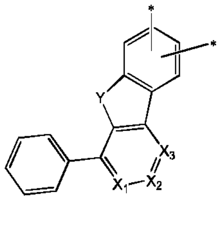

is selected independently of each other from any one of following groups:

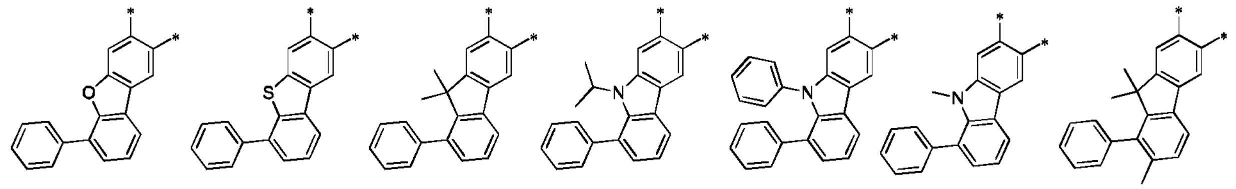

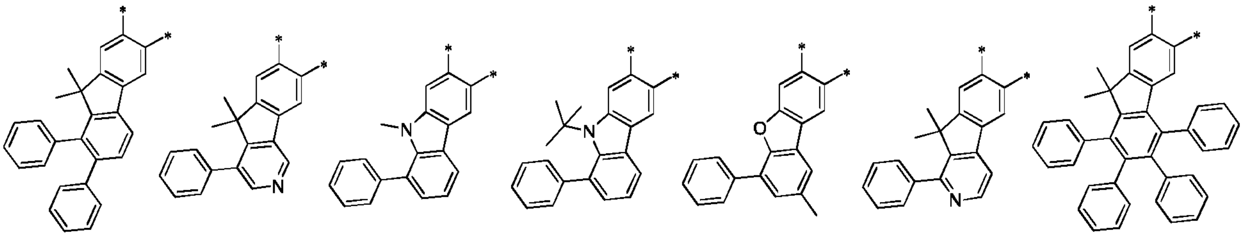

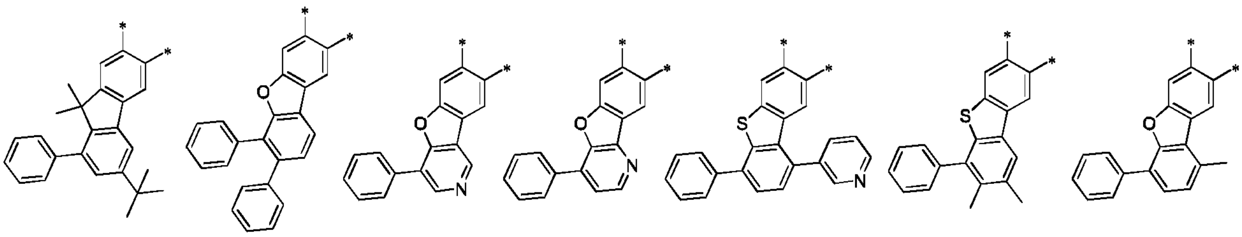

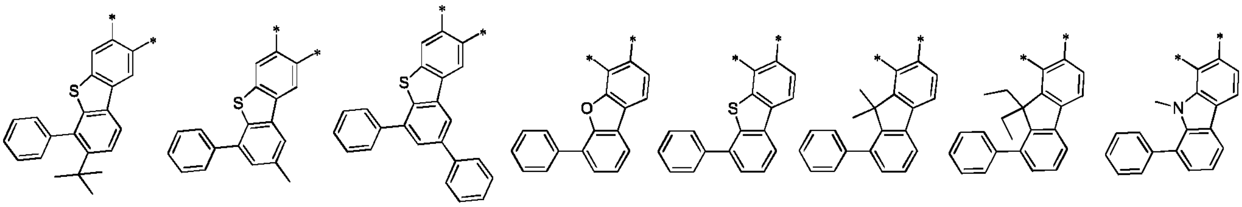

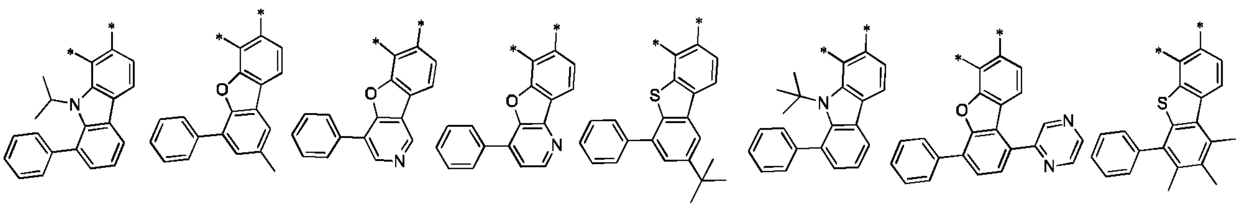

;

wherein: "*" represents a connecting site.

**16.** The mixture of claim 11, wherein L is selected from the group consisting of following structural formulae:

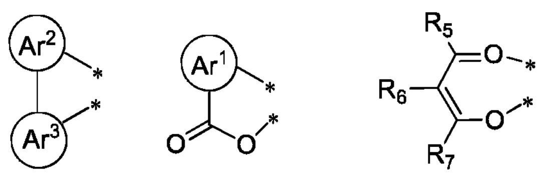

wherein,

$Ar^1$, $Ar^2$, and $Ar^3$ are selected independently of each other from the group consisting of a substituted or unsubstituted aromatic group having 5 to 30 ring atoms, a substituted or unsubstituted heteroaromatic group having 5 to 30 ring atoms, and a substituted or unsubstituted non-aromatic ring system having 5 to 30 ring atoms;

$R_5$, $R_6$, and $R_7$ are selected independently of each other at each occurrence from the group consisting of -H, -D, a linear alkyl group having 1 to 20 carbon atoms, a linear alkoxy group having 1 to 20 carbon atoms, a linear thioalkoxy group having 1 to 20 carbon atoms, a branched alkyl group having 3 to 20 carbon atoms, a cyclic alkyl group having 3 to 20 carbon atoms, a branched alkoxy group having 3 to 20 carbon atoms, a cyclic alkoxy group having 3 to 20 carbon atoms, a branched thioalkoxy group having 3 to 20 carbon atoms, a cyclic thioalkoxy group having 3 to 20 carbon atoms, silicyl, a ketone group having 1 to 20 carbon atoms, an alkoxycarbonyl group having 2 to 20 carbon atoms, an aryloxycarbonyl group having 7 to 20 carbon atoms, -CN, carbamoyl, haloformyl, formyl, an isocyano group, an isocyanate group, a thiocyanate group, an isothiocyanate group, hydroxyl, nitro, -CF3, -Cl, -Br, -F, a substituted or unsubstituted aromatic group having 6 to 60 ring atoms, a substituted or unsubstituted heteroaromatic group having 5 to 60 ring atoms, a substituted or unsubstituted aryloxy group having 6 to 60 ring atoms, a substituted or unsubstituted heteroaryloxy group having 5 to 60 ring atoms, and any suitable combination of the groups; and

"*" represents a site connected to Ir.

**17.** The mixture of claim 16, wherein the $Ar^1$, $Ar^2$, and $Ar^3$ are selected independently of each other from the group consisting of following groups:

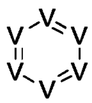
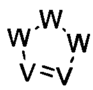
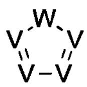
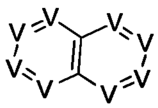
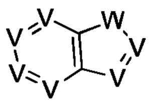
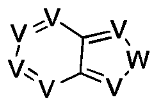
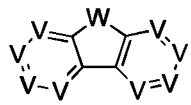
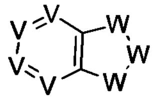

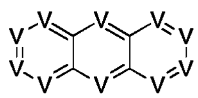
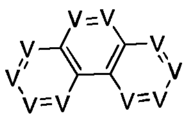
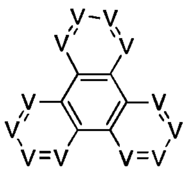
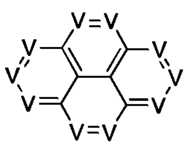
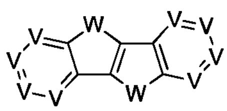
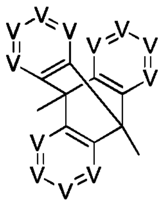

;

wherein,

V is selected independently at each occurrence from C, $CR_8$ or N;

W is selected independently at each occurrence from $CR_9R_{10}$, $NR_9$, O, S, N, $PR_9$, $BR_9$ or $SiR_9R_{10}$;

$R_8$, $R_9$, and $R_{10}$ are selected independently at each occurrence from the group consisting of -H, -D, a linear alkyl group having 1 to 20 carbon atoms, a linear alkoxy group having 1 to 20 carbon atoms, a linear thioalkoxy group having 1 to 20 carbon atoms, a branched alkyl group having 3 to 20 carbon atoms, a cyclic alkyl group having 3 to 20 carbon atoms, a branched alkoxy group having 3 to 20 carbon atoms, a cyclic alkoxy group having 3 to 20 carbon atoms, a branched thioalkoxy group having 3 to 20 carbon atoms, a cyclic thioalkoxy group having 3 to 20 carbon atoms, silicyl, a ketone group having 1 to 20 carbon atoms, an alkoxycarbonyl group having 2 to 20 carbon atoms, an aryloxycarbonyl group having 7 to 20 carbon atoms,-CN, carbamoyl, haloformyl, formyl, an isocyano group, an isocyanate group, a thiocyanate group, an isothiocyanate group, hydroxyl, nitro, $-CF_3$, -Cl, -Br, -F, a substituted or unsubstituted alkenyl group having 2 to 20 carbon atoms, a substituted or unsubstituted aromatic group having 6 to 60 ring atoms, a substituted or unsubstituted heteroaromatic group having 5 to 60 ring atoms, a substituted or unsubstituted aryloxy group having 6 to 60 ring atoms, a substituted or unsubstituted heteroaryloxy group having 5 to 60 ring atoms, and any combination of the groups; and adjacent two $R_8$ form or do not form a ring, and/or adjacent two $R_9$ form or do not form a ring.

**18.** The mixture of claim 17, wherein L is preferably selected from any one of structures (G-1) to (G-28):

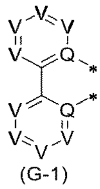
(G-1)
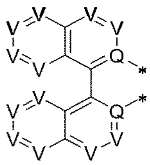
(G-2)
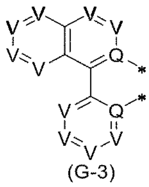
(G-3)
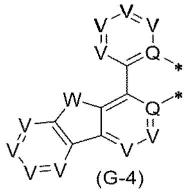
(G-4)
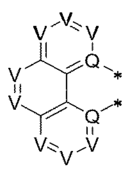
(G-5)
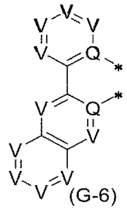
(G-6)
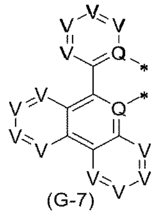
(G-7)

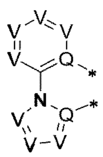
(G-8)
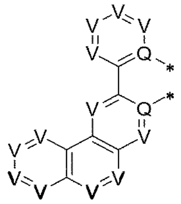
(G-9)
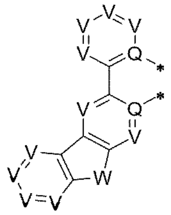
(G-10)
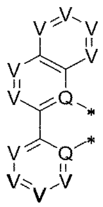
(G-11)
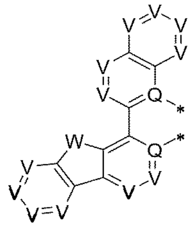
(G-12)
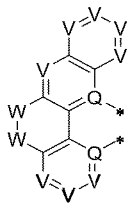
(G-13)
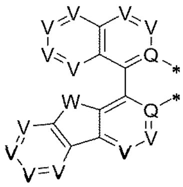
(G-14)

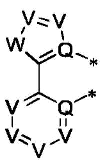
(G-15)
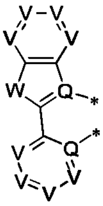
(G-16)
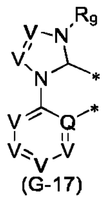
(G-17)
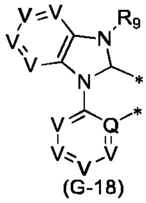
(G-18)
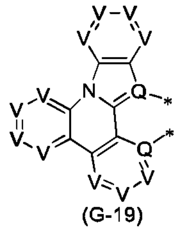
(G-19)
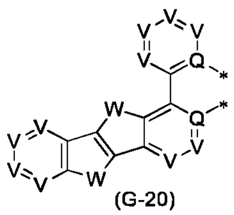
(G-20)
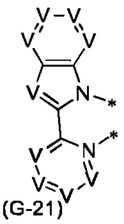
(G-21)

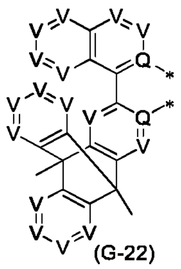
(G-22)
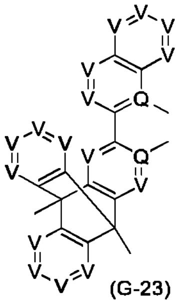
(G-23)
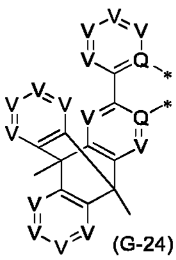
(G-24)
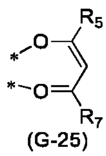
(G-25)
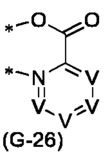
(G-26)
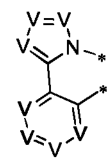
(G-27)
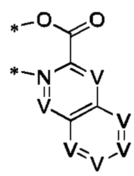
(G-28)

;

wherein one Q of the monovalent anionic organic ligand is selected from C, and another one Q of the monovalent anionic organic ligand is selected from N.

**19.** A composition, comprising a mixture and at least an organic solvent;

wherein the mixture comprises a metal complex and at least an organic functional material, and the organic functional material is selected from at least one of a hole injection material, a hole transport material, an electron transport material, an electron injection material, an electron blocking material, a hole blocking material, a luminescent material, a host material and an organic dye; and
the metal complex has a structure as represented by formula (I) or formula (II):

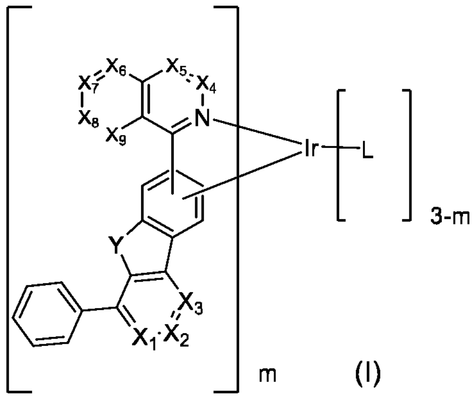
(I)
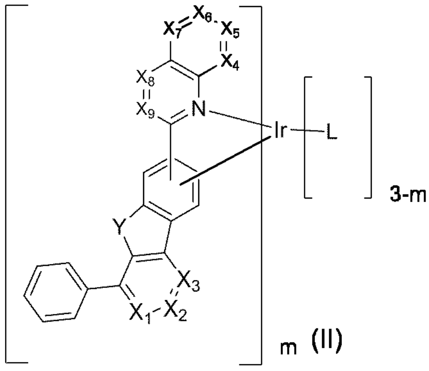
(II)
;

wherein,

L is a monovalent anionic organic ligand;

m is selected from 1 or 2 or 3;

$X_1$, $X_2$, and $X_3$ are selected independently at each occurrence from $CR_1$ or N;

$X_4$, $X_5$, $X_6$, $X_7$, $X_8$, and $X_9$ are selected independently at each occurrence from $CR_2$ or N;

Y is selected independently at each occurrence from $CR_3R_4$, $NR_3$, O, S or $SO_2$;

$R_1$, $R_2$, $R_3$, and $R_4$ are selected independently at each occurrence from the group consisting of -H, -D, a linear alkyl group having 1 to 20 carbon atoms, a linear alkoxy group having 1 to 20 carbon atoms, a linear thioalkoxy group having 1 to 20 carbon atoms, a branched alkyl group having 3 to 20 carbon atoms, a cyclic alkyl group having 3 to 20 carbon atoms, a branched alkoxy group having 3 to 20 carbon atoms, a cyclic alkoxy group having 3 to 20 carbon atoms, a branched thioalkoxy group having 3 to 20 carbon atoms, a cyclic thioalkoxy group having 3 to 20 carbon atoms, silicyl, a ketone group having 1 to 20 carbon atoms, an alkoxycarbonyl group having 2 to 20 carbon atoms, an aryloxycarbonyl group having 7 to 20 carbon atoms, -CN, carbamoyl, haloformyl, formyl, an isocyano group, an isocyanate group, a thiocyanate group, an isothiocyanate group, hydroxyl, nitro, $-CF_3$, -Cl, -Br, -F, a substituted or unsubstituted aromatic group having 6 to 60 ring atoms, a substituted or unsubstituted heteroaromatic group having 5 to 60 ring atoms, a substituted or unsubstituted aryloxy group having 6 to 60 ring atoms, a substituted or unsubstituted heteroaryloxy group having 5 to 60 ring atoms, and any combination of the groups; and adjacent two $R_1$ form or do not form a ring, or adjacent two $R_2$ form or do not forom a ring; and

at least a $R_2$ is selected from -CN, -F, or $-CF_3$.

**20.** An organic electronic device, manufactured by a composition;

wherein the composition comprises a mixture and at least an organic solvent;

the mixture comprises a metal complex and at least an organic functional material, and the organic functional material is selected from at least one of a hole injection material, a hole transport material, an electron transport material, an electron injection material, an electron blocking material, a hole blocking material, a luminescent material, a host material and an organic dye; and

the metal complex has a structure as represented by formula (I) or formula (II):

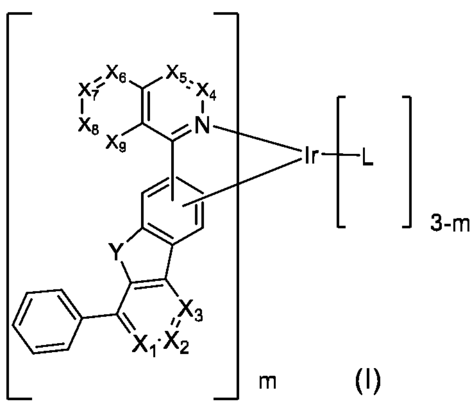
(I)
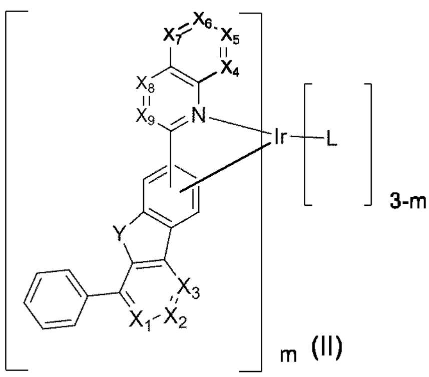
(II)
;

wherein,
L is a monovalent anionic organic ligand;
m is selected from 1 or 2 or 3;
$X_1$, $X_2$, and $X_3$ are selected independently at each occurrence from $CR_1$ or N;
$X_4$, $X_5$, $X_6$, $X_7$, $X_8$, and $X_9$ are selected independently at each occurrence from $CR_2$ or N;
Y is selected independently at each occurrence from $CR_3R_4$, $NR_3$, O, S or SOz;
$R_1$, $R_2$, $R_3$, and $R_4$ are selected independently at each occurrence from the group consisting of -H, -D, a linear alkyl group having 1 to 20 carbon atoms, a linear alkoxy group having 1 to 20 carbon atoms, a linear thioalkoxy group having 1 to 20 carbon atoms, a branched alkyl group having 3 to 20 carbon atoms, a cyclic alkyl group having 3 to 20 carbon atoms, a branched alkoxy group having 3 to 20 carbon atoms, a cyclic alkoxy group having 3 to 20 carbon atoms, a branched thioalkoxy group having 3 to 20 carbon atoms, a cyclic thioalkoxy group having 3 to 20 carbon atoms, silicyl, a ketone group having 1 to 20 carbon atoms, an alkoxycarbonyl group having 2 to 20 carbon atoms, an aryloxycarbonyl group having 7 to 20 carbon atoms, -CN, carbamoyl, haloformyl, formyl, an isocyano group, an isocyanate group, a thiocyanate group, an isothiocyanate group, hydroxyl, nitro, $-CF_3$, -Cl, -Br, -F, a substituted or unsubstituted aromatic group having 6 to 60 ring atoms, a substituted or unsubstituted heteroaromatic group having 5 to 60 ring atoms, a substituted or unsubstituted aryloxy group having 6 to 60 ring atoms, a substituted or unsubstituted heteroaryloxy group having 5 to 60 ring atoms, and any combination of the groups; and adjacent two $R_1$ form or do not form a ring, or adjacent two $R_2$ form or do not form a ring; and
at least one $R_2$ is selected from -CN, -F, or $-CF_3$.

## INTERNATIONAL SEARCH REPORT

International application No.
**PCT/CN2022/087005**

**A. CLASSIFICATION OF SUBJECT MATTER**

C07F 15/00(2006.01)i; C09K 11/06(2006.01)i; H01L 51/50(2006.01)i; H01L 51/54(2006.01)i

According to International Patent Classification (IPC) or to both national classification and IPC

**B. FIELDS SEARCHED**

Minimum documentation searched (classification system followed by classification symbols)

C07F15/-; C09K11/-; H01L51/-

Documentation searched other than minimum documentation to the extent that such documents are included in the fields searched

Electronic data base consulted during the international search (name of data base and, where practicable, search terms used)

CNKI, CNTXT, DWPI, ENTXT, STN(CAPLUS, REGISTRY); 铱, 配合物, 络合物, 配体, 喹啉, 苯基, 芴, 二苯并呋喃, 二苯并噻唑, 红移, 电致发光, 发光, 红, iridium, complex??, ligand?, Ir, light+, emit+, red, +quinolin+, +phenyl+, +dibenzofuran+, +dibenzothiazol+, +fluoren+, electroluminescen+, 根据权利要求1通式化合物的结构检索, structural search according to general compound of claim 1

**C. DOCUMENTS CONSIDERED TO BE RELEVANT**

| Category* | Citation of document, with indication, where appropriate, of the relevant passages | Relevant to claim No. |
|---|---|---|
| Y | CN 111377969 A (GUANGDONG AGLAIA OPTOELECTRONIC MATERIALS CO., LTD.) 07 July 2020 (2020-07-07)<br>entire document, in particular claims 1-20, and description, paragraphs 35 and 50 | 1-20 |
| Y | 丁勇 (DING, Yong). "新型红光铱配合物的合成及电致发光性质研究 (Synthesis and Electroluminescence Properties of Novel Red Iridium Complexes)" *中国优秀博硕士学位论文全文数据库(硕士)工程科技I辑 (Engineering Science and Technology I, China Doctoral Dissertations/Master's Theses full-text database (Master)),* No. 2, 15 February 2021 (2021-02-15),<br>B014-637, in particular text, page 54, section 3.4, and page 61, paragraph 2 | 1-20 |
| Y | CN 111620910 A (GUANGDONG AGLAIA OPTOELECTRONIC MATERIALS CO., LTD.) 04 September 2020 (2020-09-04)<br>entire document, in particular, claims 1-15 | 1-20 |
| Y | WO 2021103770 A1 (GUANGDONG AGLAIA OPTOELECTRONIC MATERIALS CO., LTD.) 03 June 2021 (2021-06-03)<br>entire document, in particular claims 1-20 | 1-20 |

☑ Further documents are listed in the continuation of Box C. ☑ See patent family annex.

* Special categories of cited documents:
- "A" document defining the general state of the art which is not considered to be of particular relevance
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| **12 July 2022** | **21 July 2022** |
| Name and mailing address of the ISA/CN<br>**China National Intellectual Property Administration (ISA/CN)**<br>**No. 6, Xitucheng Road, Jimenqiao, Haidian District, Beijing 100088, China**<br>Facsimile No. **(86-10)62019451** | Authorized officer<br><br>Telephone No. |

Form PCT/ISA/210 (second sheet) (January 2015)

**INTERNATIONAL SEARCH REPORT**

International application No.
**PCT/CN2022/087005**

**C. DOCUMENTS CONSIDERED TO BE RELEVANT**

| Category* | Citation of document, with indication, where appropriate, of the relevant passages | Relevant to claim No. |
|---|---|---|
| Y | CN 112830943 A (GUANGDONG AGLAIA OPTOELECTRONIC MATERIALS CO., LTD.) 25 May 2021 (2021-05-25)<br>entire document, in particular, claims 1-15 | 1-20 |
| Y | US 2015090981 A1 (UNIVERSAL DISPLAY CORP.) 02 April 2015 (2015-04-02)<br>entire document, in particular claims 1-20 | 1-20 |
| A | CN 107973823 A (EVERDISPLAY OPTRONICS (SHANGHAI) CO., LTD.) 01 May 2018 (2018-05-01)<br>entire document | 1-20 |

Form PCT/ISA/210 (second sheet) (January 2015)

**INTERNATIONAL SEARCH REPORT**
**Information on patent family members**

International application No.
**PCT/CN2022/087005**

| Patent document cited in search report | Publication date (day/month/year) | Patent family member(s) | Publication date (day/month/year) |
|---|---|---|---|
| CN 111377969 A | 07 July 2020 | JP 2022509647 A | 21 January 2022 |
| | | US 2022115603 A1 | 14 April 2022 |
| | | WO 2020134570 A1 | 02 July 2020 |
| | | KR 20210068531 A | 09 June 2021 |
| | | DE 112019005183 T5 | 01 July 2021 |
| CN 111620910 A | 04 September 2020 | None | |
| WO 2021103770 A1 | 03 June 2021 | DE 112020004791 T5 | 15 June 2022 |
| | | TW 202120520 A | 01 June 2021 |
| | | KR 20220065848 A | 20 May 2022 |
| CN 112830943 A | 25 May 2021 | None | |
| US 2015090981 A1 | 02 April 2015 | US 10003034 B2 | 19 June 2018 |
| CN 107973823 A | 01 May 2018 | None | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2010135519 A1
- US 20090134784 A1
- WO 2011110277 A1


### Non-patent literature cited in the description


- *Appl. Phys. Lett.,* 1999, vol. 75, 4
- *Appl. Phys. Lett.,* 2001, vol. 79, 2082
- **BULOVIC et al.** *Nature,* 1996, vol. 380, 29
- **GU et al.** *Appl. Phys. Lett.,* 1996, vol. 68, 2606